(19) Europäisches Patentamt
European Patent Office
Office européen des brevets

(11) EP 4 190 879 A1

(12) EUROPEAN PATENT APPLICATION
published in accordance with Art. 153(4) EPC

(43) Date of publication:
**07.06.2023 Bulletin 2023/23**

(21) Application number: **21851004.8**

(22) Date of filing: **02.07.2021**

(51) International Patent Classification (IPC):
***C09K 11/06*** *(2006.01)* ***H01L 51/50*** *(2006.01)*

(52) Cooperative Patent Classification (CPC):
**C09K 11/06; H10K 50/00**

(86) International application number:
**PCT/JP2021/025092**

(87) International publication number:
**WO 2022/024664 (03.02.2022 Gazette 2022/05)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **28.07.2020 JP 2020127510**

(71) Applicant: **SUMITOMO CHEMICAL COMPANY, LIMITED**
**Tokyo 103-6020 (JP)**

(72) Inventor: **MATSUMOTO, Ryuji**
**Ibaraki 300-3294 (JP)**

(74) Representative: **J A Kemp LLP**
**80 Turnmill Street**
**London EC1M 5QU (GB)**

# (54) COMPOSITION AND LIGHT-EMITTING ELEMENT

(57) To provide a composition which is useful for production of a light emitting device having high light emission efficiency, and a light emitting device containing the composition.

A composition containing
a polymer compound having a repeating unit represented by the formula (Y), and a constitutional unit (SM1) obtained by removing one or more hydrogen atoms from a low molecular compound (SM1) in which the absolute value of a difference between the energy level of the lowest triplet excited state and the energy level of the lowest singlet excited state is 0.50 eV or less, and
a low molecular compound (SM2) in which the absolute value of a difference between the energy level of the lowest triplet excited state and the energy level of the lowest singlet excited state is 0.50 eV or less, wherein
when the content number per unit mass of the constitutional unit (SM1) in the composition is represented as dSM1 and the content number per unit mass of the low molecular compound (SM2) in the composition is represented as dSM2, then, dSM1 + dSM2 is $2.0 \times 10^{19}$ (number/g) or more and dSM1/dSM2 is 0.020 or more and 50 or less.

EP 4 190 879 A1

## Description

Technical Field

The present invention relates to a composition and a light emitting device.

Background Art

Light emitting devices such as an organic electroluminescent device and the like can be suitably used, for example, for display and illumination. As a light emitting material used for a light emitting layer of a light emitting device, for example, compositions containing a low molecular compound such as a compound M101, a compound M103 or the like and a polymer compound, are disclosed in Patent Documents 1 and 2.

[Chemical Formula 1]

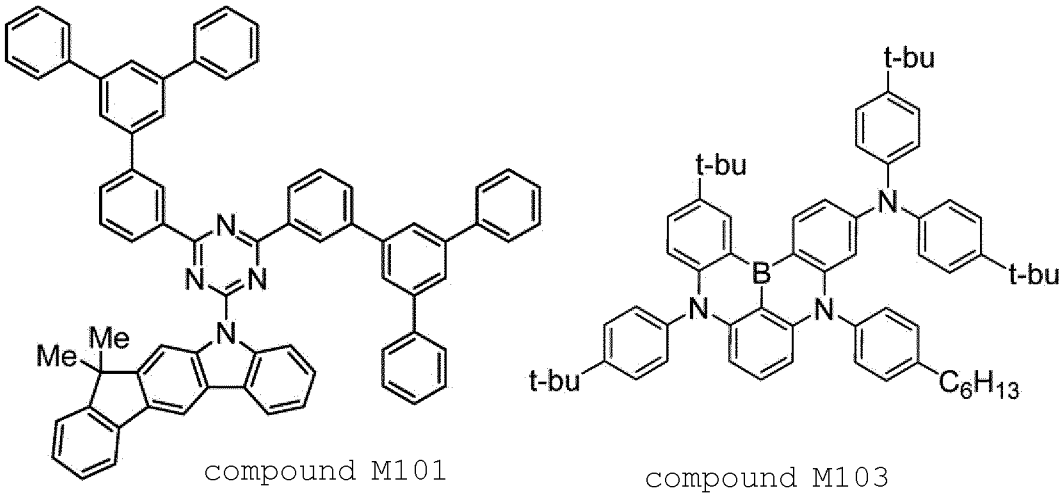

compound M101 compound M103

[Prior Art Document]

[Patent Document]

Patent Document 1: International Publication WO 2018/062276
Patent Document 2: International Publication WO 2018/062278

Summary of the Invention

Problem to be Solved by the Invention

In the compositions described in Patent Documents 1 and 2, the difference between the energy level of the lowest excited triplet state and the energy level of the lowest excited singlet state of in the low molecular compound is 0.50 eV or less and the difference between the energy level of the lowest excited triplet state and the energy level of the lowest excited singlet state in the polymer compound is over 0.50 eV. Light emitting devices using these compositions have room for further improvement in light emission efficiency.

Then, the present invention has an object of providing a composition which is useful for production of a light emitting device having high light emission efficiency, and a light emitting device containing the composition.

Means for Solving the Problem

The present invention provides the following [1] to [12] .

[1] A composition comprising

a polymer compound having a repeating unit represented by the formula (Y), and a constitutional unit (SM1) obtained by removing one or more hydrogen atoms from a low molecular compound (SM1) in which the absolute value of a difference between the energy level of the lowest triplet excited state and the energy level of the lowest singlet excited state is 0.50 eV or less, and
a low molecular compound (SM2) in which the absolute value of a difference between the energy level of the lowest triplet excited state and the energy level of the lowest singlet excited state is 0.50 eV or less, wherein
when the content number per unit mass of the above-described constitutional unit (SM1) in the above-described composition is represented as dSM1 and the content number per unit mass of the above-described low molecular compound (SM2) in the above-described composition is represented as dSM2, then, dSM1 + dSM2 is $2.0 \times 10^{19}$ (number/g) or more and dSM1/dSM2 is 0.020 or more and 50 or less:

[Chemical Formula 2]

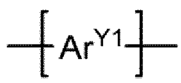

(Y)

[wherein, $Ar^{Y1}$ represents an arylene group optionally having a substituent.].

[2] The composition according to [1], wherein

the above-described low molecular compound (SM1) is a compound represented by the formula (T-1) or a compound having a group selected from Group D:

[Chemical Formula 3]

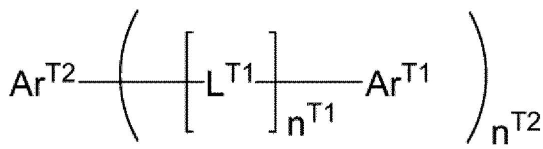

(T-1)

[wherein,
$n^{T1}$ represents an integer of 0 or more. When a plurality of $n^{T1}$ are present, they may be the same or different.
$n^{T2}$ represents an integer of 0 or more.
$Ar^{T1}$ represents a substituted amino group or a monovalent hetero ring group, and these groups optionally have a substituent. When a plurality of the substituents are present, they may be the same or different, and may be combined together to form a ring together with atoms to which they are attached. When a plurality of $Ar^{T1}$ are present, they may be the same or different. Note that the monovalent hetero ring group represented by $Ar^{T1}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$.
$L^{T1}$ represents an alkylene group, a cycloalkylene group, an arylene group, a divalent hetero ring group, an oxygen atom or a sulfur atom, and these groups optionally have a substituent. When a plurality of the substituents are present, they may be the same or different, and may be combined together to form a ring together with atoms to which they are attached. When a plurality of $L^{T1}$ are present, they may be the same or different.
$Ar^{T2}$ represents a group selected from Group A, Group B and Group C. Note that when $Ar^{T2}$ is selected from Group A, $n^{T2}$ is 2.]
Group A: -C(=O)-, -S(=O)- and $-S(=O)_2-$
Group B: groups obtained by removing $n^{T2}$ hydrogen atoms from an aromatic hydrocarbon having an electron-withdrawing group
Group C: groups obtained by removing $n^{T2}$ hydrogen atoms from a heterocyclic compound containing in the ring a group represented by =N-, groups obtained by removing $n^{T2}$ hydrogen atoms from a heterocyclic compound containing in the ring a group represented by -C(=O)-, groups obtained by removing $n^{T2}$ hydrogen atoms from

a heterocyclic compound containing in the ring a group represented by -S(=O)-, and groups obtained by removing $n^{T2}$ hydrogen atoms from a heterocyclic compound containing in the ring a group represented by - $S(=O)_2$-
Group D: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

[3] The composition according to [1] or [2], wherein dSM1/dSM2 is 0.077 to 0.77 or 1.3 to 13.

[4] The composition according to any one of [1] to [3], wherein the above-described low molecular compound (SM1) is a compound represented by the formula (D-1):

[Chemical Formula 4]

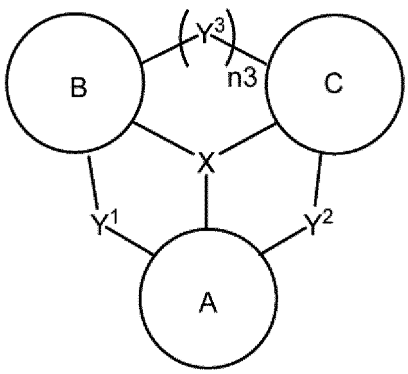

(D-1)

[wherein,

Ring A, Ring B and Ring C each independently represent an aromatic hydrocarbon ring or an aromatic hetero ring, and these rings optionally have a substituent.
X represents a boron atom, a phosphorus atom, P=O, P=S, an aluminum atom, a gallium atom, an arsenic atom, Si-Rx or Ge-Rx. Rx represents an aryl group or an alkyl group, and these groups optionally have a substituent.
$Y^1$ represents N-Ry, a sulfur atom or a selenium atom. $Y^2$ and $Y^3$ each independently represent an oxygen atom, N-Ry, a sulfur atom or a selenium atom. Ry represents a hydrogen atom, an aryl group, a monovalent hetero ring group, or an alkyl group, and these groups optionally have a substituent. When a plurality of Ry are present, these may be the same or different. Ry may be linked to the above-described Ring A, the above-described Ring B or the above-described Ring C directly or via linking group.
n3 is 0 or 1. When n3 is 0, -$Y^3$- is not present.].

[5] The composition according to any one of [1] to [4], wherein the above-described polymer compound further contains a constitutional unit represented by the formula (X) (note that, it differs from the above-described constitutional unit (SM1)):

[Chemical Formula 5]

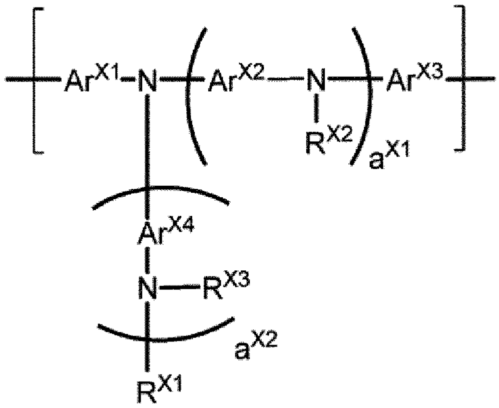

(X)

[wherein,

$a^{X1}$ and $a^{X2}$ each independently represent an integer of 0 or more.

$Ar^{X1}$ and $Ar^{X3}$ each independently represent an arylene group or a divalent hetero ring group, and these groups optionally have a substituent. When a plurality of the substituents are present, they may be the same or different, and may be combined together to form a ring together with atoms to which they are attached.

$Ar^{X2}$ and $Ar^{X4}$ each independently represent an arylene group, a divalent hetero ring group, or a divalent group in which at least one arylene group and at least one divalent hetero ring group are bonded directly, and these groups optionally have a substituent. When a plurality of the substituents are present, they may be the same or different, and may be combined together to form a ring together with atoms to which they are attached. When a plurality of $Ar^{X2}$ and $Ar^{X4}$ are present, they may be the same or different at each occurrence.

$R^{X1}$, $R^{X2}$ and $R^{X3}$ each independently represent a hydrogen atom, an alkyl group, a cycloalkyl group, an aryl group or a monovalent hetero ring group, and these groups optionally have a substituent. When a plurality of the substituents are present, they may be the same or different, and may be combined together to form a ring together with atoms to which they are attached. When a plurality of $R^{X2}$ and $R^{X3}$ are present, they may be the same or different at each occurrence.].

[6] The composition according to any one of [1] to [5], wherein the above-described low molecular compound (SM2) is a compound represented by the formula (T-11) or a compound having a group selected from Group G:

[Chemical Formula 6]

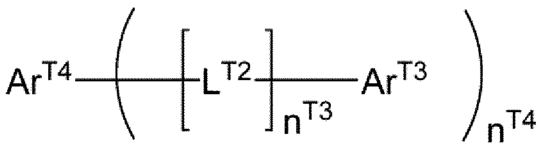

**(T-11)**

[wherein,

$n^{T3}$ represents an integer of 0 or more. When a plurality of $n^{T3}$ are present, they may be the same or different.

$n^{T4}$ represents an integer of 1 or more.

$Ar^{T3}$ represents a substituted amino group or a monovalent hetero ring group, and these groups optionally have a substituent. When a plurality of the substituents are present, they may be the same or different, and may be combined together to form a ring together with atoms to which they are attached. When a plurality of $Ar^{T3}$ are present, they may be the same or different. Note that the monovalent hetero ring group represented by $Ar^{T3}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$.

$L^{T2}$ represents an alkylene group, a cycloalkylene group, an arylene group, a divalent hetero ring group, an oxygen atom or a sulfur atom, and these groups optionally have a substituent. When a plurality of the substituents are present, they may be the same or different, and may be combined together to form a ring together with

atoms to which they are attached. When a plurality of $L^{T2}$ are present, they may be the same or different. $Ar^{T4}$ represents a group selected from Group A, Group E and Group F. Note that when $Ar^{T4}$ is a group selected from Group A, $n^{T4}$ is 2.]

Group A: -C(=O)-, -S(=O)- and $-S(=O)_2-$

Group E: groups obtained by removing $n^{T4}$ hydrogen atoms from an aromatic hydrocarbon having an electron-withdrawing group

Group F: groups obtained by removing $n^{T4}$ hydrogen atoms from a heterocyclic compound containing in the ring a group represented by =N-, groups obtained by removing $n^{T4}$ hydrogen atoms from a heterocyclic compound containing in the ring a group represented by -C(=O)-, groups obtained by removing $n^{T4}$ hydrogen atoms from a heterocyclic compound containing in the ring a group represented by -S(=O)-, and groups obtained by removing $n^{T4}$ hydrogen atoms from a heterocyclic compound containing in the ring a group represented by - $S(=O)_2-$

Group G: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

[7] The composition according to any one of [1] to [6], wherein the above-described low molecular compound (SM2) is a compound represented by the formula (D-11):

[Chemical Formula 7]

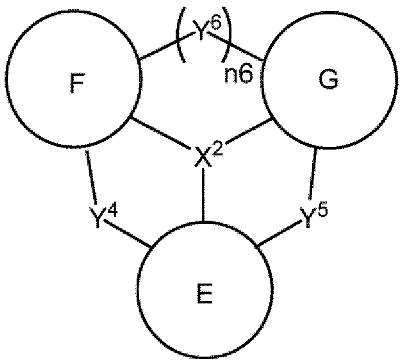

(D-11)

[wherein,

Ring E, Ring F and Ring G each independently represent an aromatic hydrocarbon ring or an aromatic hetero ring, and these rings optionally have a substituent.

$X^2$ represents a boron atom, a phosphorus atom, P=O, P=S, an aluminum atom, a gallium atom, an arsenic atom, Si-Rx or Ge-Rx. Rx represents an aryl group or an alkyl group, and these groups optionally have a substituent.

$Y^4$ represents N-Ry, a sulfur atom or a selenium atom. $Y^5$ and $Y^6$ each independently represent an oxygen atom, N-Ry, a sulfur atom or a selenium atom. Ry represents a hydrogen atom, an aryl group, a monovalent hetero ring group, or an alkyl group, and these groups optionally have a substituent. When a plurality of Ry are present, these may be the same or different. Ry may be linked to the above-described Ring E, the above-described Ring F or the above-described Ring G directly or via linking group.

n6 is 0 or 1. When n6 is 0, $-Y^6-$ is not present.].

[8] A composition comprising

a first polymer compound having a repeating unit represented by the formula (Y), and a constitutional unit (SM1-1) obtained by removing one or more hydrogen atoms from a low molecular compound (SM1-1) in which the absolute value of a difference between the energy level of the lowest triplet excited state and the energy level of the lowest singlet excited state is 0.50 eV or less, and

a second polymer compound having a repeating unit represented by the formula (Y), and a constitutional unit (SM1-2) obtained by removing one or more hydrogen atoms from a low molecular compound (SM1-2) in which the absolute value of a difference between the energy level of the lowest triplet excited state and the energy level of the lowest singlet excited state is 0.50 eV or less (note that, the above-described low molecular compound (SM1-1) and the above-described low molecular compound (SM1-2) are different),
wherein when the content number per unit mass of the above-described constitutional unit (SM1-1) in the above-described composition is represented as dSM1 and the content number per unit mass of the above-described constitutional unit (SM1-2) in the above-described composition is represented as dSM1b, then, dSM1a + dSM1b is $2.0 \times 10^{19}$ (number/g) or more and dSM1a/dSM1b is 0.020 or more and 50 or less:

[Chemical Formula 8]

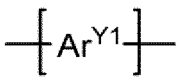
(Y)

[wherein, $Ar^{Y1}$ represents an arylene group optionally having a substituent.].

[9] The composition according to [8], wherein

the above-described low molecular compound (SM1-1) and the above-described low molecular compound (SM1-2) are each independently a compound represented by the formula (T-1) or a compound having a group selected from Group D:

[Chemical Formula 9]

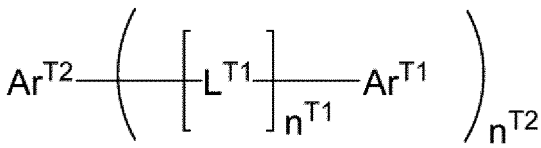
(T-1)

[wherein,
$n^{T1}$ represents an integer of 0 or more. When a plurality of $n^{T1}$ are present, they may be the same or different.
$n^{T2}$ represents an integer of 0 or more.
$Ar^{T1}$ represents a substituted amino group or a monovalent hetero ring group, and these groups optionally have a substituent. When a plurality of the substituents are present, they may be the same or different, and may be combined together to form a ring together with atoms to which they are attached. When a plurality of $Ar^{T1}$ are present, they may be the same or different. Note that the monovalent hetero ring group represented by $Ar^{T1}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$.
$L^{T1}$ represents an alkylene group, a cycloalkylene group, an arylene group, a divalent hetero ring group, an oxygen atom or a sulfur atom, and these groups optionally have a substituent. When a plurality of the substituents are present, they may be the same or different, and may be combined together to form a ring together with atoms to which they are attached. When a plurality of $L^{T1}$ are present, they may be the same or different.
$Ar^{T2}$ represents a group selected from Group A, Group B and Group C. Note that when $Ar^{T2}$ is selected from Group A, $n^{T2}$ is 2.]
Group A: -C(=O)-, -S(=O)- and $-S(=O)_2-$
Group B: groups obtained by removing $n^{T2}$ hydrogen atoms from an aromatic hydrocarbon having an electron-withdrawing group
Group C: groups obtained by removing $n^{T2}$ hydrogen atoms from a heterocyclic compound containing in the ring a group represented by =N-, groups obtained by removing $n^{T2}$ hydrogen atoms from a heterocyclic compound containing in the ring a group represented by -C(=O)-, groups obtained by removing $n^{T2}$ hydrogen atoms from a heterocyclic compound containing in the ring a group represented by -S(=O)-, and groups obtained by removing $n^{T2}$ hydrogen atoms from a heterocyclic compound containing in the ring a group represented by - $S(=O)_2-$

Group D: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

[10] The composition according to [8] or [9], wherein
the above-described low molecular compound (SM1-1) and the above-described low molecular compound (SM1-2) are each independently a compound represented by the formula (D-1):

[Chemical Formula 10]

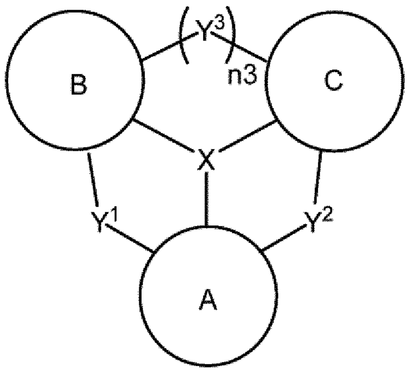

(D-1)

[wherein,

Ring A, Ring B and Ring C each independently represent an aromatic hydrocarbon ring or an aromatic hetero ring, and these rings optionally have a substituent.
X represents a boron atom, a phosphorus atom, P=O, P=S, an aluminum atom, a gallium atom, an arsenic atom, Si-Rx or Ge-Rx. Rx represents an aryl group or an alkyl group, and these groups optionally have a substituent.
$Y^1$ represents N-Ry, a sulfur atom or a selenium atom. $Y^2$ and $Y^3$ each independently represent an oxygen atom, N-Ry, a sulfur atom or a selenium atom. Ry represents a hydrogen atom, an aryl group, a monovalent hetero ring group, or an alkyl group, and these groups optionally have a substituent. When a plurality of Ry are present, these may be the same or different. Ry may be linked to the above-described Ring A, the above-described Ring B or the above-described Ring C directly or via linking group.
n3 is 0 or 1. When n3 is 0, $-Y^3-$ is not present.].

[11] An ink comprising the composition as described in any one of [1] to [10], and a solvent.

[12] A light emitting device comprising the composition as described in any one of [1] to [10].

Effect of the Invention

According to the present invention, a composition which is useful for production of a light emitting device having high light emission efficiency, and a light emitting device containing the composition, are provided.

Modes for Carrying Out the Invention

Suitable embodiments of the present invention will be illustrated in detail below.

[Explanation of common terms]

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

The hydrogen atom may be a heavy hydrogen atom or a light hydrogen atom.

In formulae representing a metal complex, the solid line representing a bond with a metal denotes an ion bond, a covalent bond or a coordination bond.

The "polymer compound" means a polymer having molecular weight distribution, and having a polystyrene-equivalent number-average molecular weight of $1 \times 10^3$ or more (for example, $1 \times 10^3$ to $1 \times 10^8$).

The polymer compound may be any of a block copolymer, a random copolymer, an alternative copolymer, or a graft copolymer, and may also be in another form.

The end group of the polymer compound is preferably a stable group since if a polymerization active group remains intact there, there is a possibility of a decrease in a light emitting property or luminance life when the polymer compound is used for fabrication of a light emitting device. The end group of the polymer compound is preferably a group conjugatively bonded to the main chain and includes, for example, an aryl group or a monovalent hetero ring group bonding to the main chain of the polymer compound via a carbon-carbon bond.

The "low molecular compound" means a compound having no molecular weight distribution, and having a molecular weight of $1 \times 10^4$ or less.

The "constitutional unit" means a unit occurring once or more times in a polymer compound. A constitutional unit occurring twice or more times in a polymer compound is in general referred to also as "repeating unit".

The "alkyl group" may be any of linear or branched. The number of carbon atoms of the linear alkyl group is, not including the number of carbon atoms of the substituent, usually 1 to 50, preferably 3 to 30, and more preferably 4 to 20. The number of carbon atoms of the branched alkyl group is, not including the number of carbon atoms of the substituent, usually 3 to 50, preferably 3 to 30, and more preferably 4 to 20.

The alkyl group optionally has a substituent. The alkyl group includes, for example, a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group. Further, the alkyl group may also be a group obtained by substituting a part or all of hydrogen atoms in these groups with a substituent (for example, a cycloalkyl group, an alkoxy group, a cycloalkoxy group, an aryl group, a fluorine atom, and the like) (for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group).

The number of carbon atoms of the "cycloalkyl group" is, not including the number of carbon atoms of the substituent, usually 3 to 50, preferably 3 to 30, and more preferably 4 to 20.

The cycloalkyl group optionally has a substituent. The cycloalkyl group includes, for example, a cyclohexyl group, a cyclohexylmethyl group, a cyclohexylethyl group, and these groups in which a part of all of hydrogen atoms are substituted with a substituent (for example, an alkyl group, a cycloalkyl group, an alkoxy group, a cycloalkoxy group, an aryl group, a fluorine atom and the like).

The "aromatic hydrocarbon group" means a group obtained by removing from an aromatic hydrocarbon one or more hydrogen atoms bonding directly to atoms constituting the ring. The group obtained by removing from an aromatic hydrocarbon one hydrogen atom bonding directly to an atom constituting the ring is referred to also as "aryl group". The group obtained by removing from an aromatic hydrocarbon two hydrogen atoms bonding directly to atoms constituting the ring is referred to also as "arylene group".

The number of carbon atoms of the aromatic hydrocarbon group is, not including the number of carbon atoms of the substituent, usually 6 to 60, preferably 6 to 40, and more preferably 6 to 20.

The "aromatic hydrocarbon group" includes, for example, groups obtained by removing from a mono-cyclic aromatic hydrocarbon (including, for example, benzene) or a poly-cyclic aromatic hydrocarbon (including, for example, 2-cyclic aromatic hydrocarbons such as naphthalene, indene and the like; 3-cyclic aromatic hydrocarbons such as anthracene, phenanthrene, dihydrophenanthrene, fluorene and the like; 4-cyclic aromatic hydrocarbons such as benzoanthracene, benzophenanthrene, benzofluorene, pyrene, fluoranthene and the like; 5-cyclic aromatic hydrocarbons such as dibenzoanthracene, dibenzophenanthrene, dibenzofluorene, perylene, benzofluoranthene and the like; 6-cyclic aromatic hydrocarbons such as spirobifluorene and the like; and 7-cyclic aromatic hydrocarbons such as benzospirobifluorene, acenaphthofluoranthene and the like) one or more hydrogen atoms bonding directly to atoms constituting the ring. The aromatic hydrocarbon group includes groups in which a plurality of these groups are bonded. The aromatic hydrocarbon group optionally has a substituent.

The number of carbon atoms of the aryl group is, not including the number of carbon atoms of the substituent, usually 6 to 60, preferably 6 to 20, and more preferably 6 to 10. The aryl group optionally has a substituent. The aryl group includes, for example, a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group,

a 3-fluorenyl group, a 4-fluorenyl group, a 2-phenylphenyl group, a 3-phenylphenyl group, a 4-phenylphenyl group, and these groups in which a part of all of hydrogen atoms are substituted with a substituent (for example, an alkyl group, a cycloalkyl group, an alkoxy group, a cycloalkoxy group, an aryl group, a fluorine atom and the like).

The number of carbon atoms of the arylene group is, not including the number of carbon atoms of the substituent, usually 6 to 60, preferably 6 to 30, and more preferably 6 to 18. The arylene group optionally has a substituent. The arylene group includes, for example, a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups in which a part of all of hydrogen atoms are substituted with a substituent. The arylene group is preferably a group represented by the formula (A-1) to the formula (A-20). The arylene group includes groups in which a plurality of these groups are bonded.

[Chemical Formula 11]

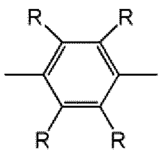
(A-1)

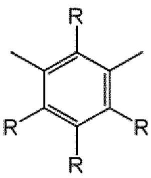
(A-2)

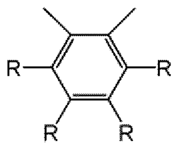
(A-3)

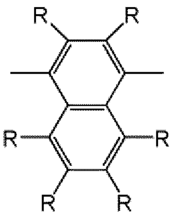
(A-4)

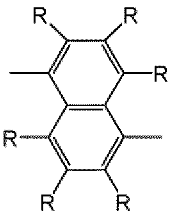
(A-5)

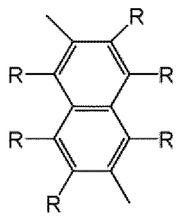
(A-6)

[Chemical Formula 12]

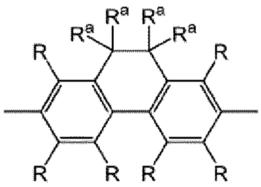
(A-7)

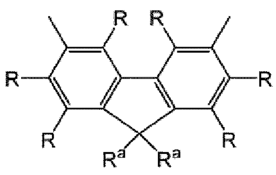
(A-8)

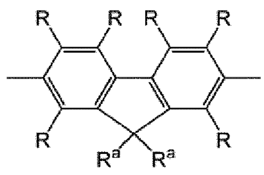
(A-9)

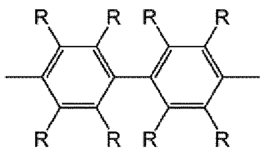
(A-10)

[Chemical Formula 13]

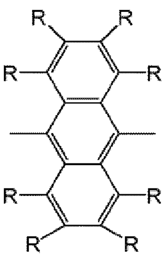
(A-11)

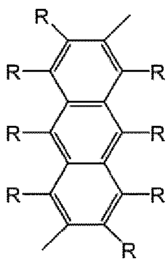
(A-12)

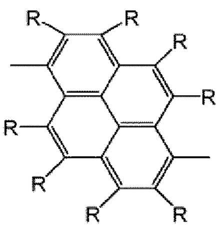
(A-13)

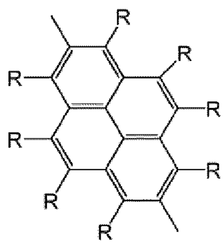
(A-14)

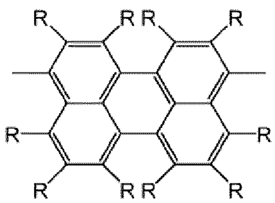
(A-15)

[Chemical Formula 14]

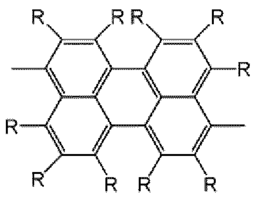

(A-16)

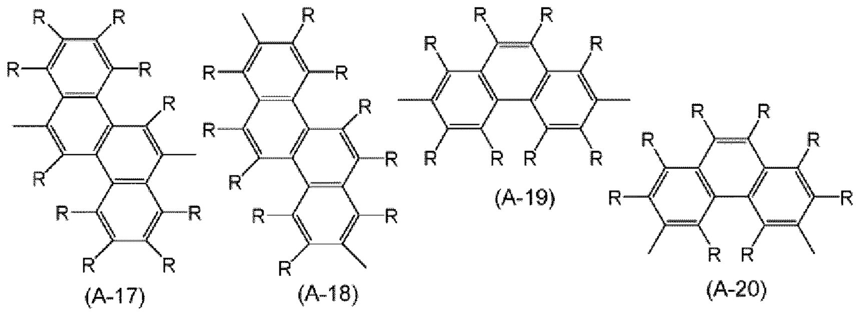

(A-17) (A-18) (A-19) (A-20)

In the formulae, R and $R^a$ each independently represent a hydrogen atom, an alkyl group, a cycloalkyl group, an aryl group or a monovalent hetero ring group. A plurality of R and $R^a$ each may be the same or different, and the plurality of $R^a$ may be combined together to form a ring together with atoms to which they are attached.

The "alkoxy group" may be any of linear or branched. The number of carbon atoms of the linear alkoxy group is, not including the number of carbon atoms of the substituent, usually 1 to 40, and preferably 4 to 10. The number of carbon atoms of the branched alkoxy group is, not including the number of carbon atoms of the substituent, usually 3 to 40, and preferably 4 to 10.

The alkoxy group optionally has a substituent. The alkoxy group includes, for example, a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group, a lauryloxy group, and these groups in which a part of all of hydrogen atoms are substituted with a substituent (for example, a cycloalkyl group, an alkoxy group, a cycloalkoxy group, an aryl group, a fluorine atom and the like).

The number of carbon atoms of the "cycloalkoxy group" is, not including the number of carbon atoms of the substituent, usually 3 to 40, and preferably 4 to 10.

The cycloalkoxy group optionally has a substituent, and includes, for example, a cyclohexyloxy group.

The number of carbon atoms of the "aryloxy group" is, not including the number of carbon atoms of the substituent, usually 6 to 60, and preferably 6 to 48.

The aryloxy group optionally has a substituent, and includes, for example, a phenoxy group, a 1-naphthyloxy group, a 2-naphthyloxy group, a 1-anthracenyloxy group, a 9-anthracenyloxy group, a 1-pyrenyloxy group, and these groups in which a part of all of hydrogen atoms are substituted with a substituent (for example, an alkyl group, a cycloalkyl group, an alkoxy group, a cycloalkoxy group, a fluorine atom and the like).

The "p-valent hetero ring group" (p represents an integer of 1 or more) means an atomic group remaining after removing from a heterocyclic compound p hydrogen atoms among hydrogen atoms bonding directly to carbon atoms or hetero atoms constituting the ring. Of p-valent hetero ring groups, a "p-valent aromatic hetero ring group" which is an atomic group remaining after removing from an aromatic heterocyclic compound p hydrogen atoms among hydrogen atoms bonding directly to carbon atoms or hetero atoms constituting the ring is preferred.

The "aromatic heterocyclic compound" means, for example, a compound in which the hetero ring itself shows aromaticity, such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole, and the like, and a compound in which an aromatic ring is condensed to the hetero ring even if the hetero ring itself shows no aromaticity, such as phenoxazine, phenothiazine, dibenzoborole, dibenzosilole, benzopyran, and the like.

It is preferable that the heterocyclic compound and the aromatic heterocyclic compound are compounds different from the low molecular compound (SM1), the low molecular compound (SM1-1), the low molecular compound (SM1-2) and the low molecular compound (SM2).

The number of carbon atoms of the monovalent hetero ring group is, not including the number of carbon atoms of the substituent, usually 2 to 60, and preferably 4 to 20.

The monovalent hetero ring group optionally has a substituent, and includes, for example, a thienyl group, a pyrrolyl group, a furyl group, a pyridyl group, a piperidinyl group, a quinolinyl group, an isoquinolinyl group, a pyrimidinyl group, a triazinyl group, and these groups in which a part of all of hydrogen atoms are substituted with a substituent (for example, an alkyl group, a cycloalkyl group, an alkoxy group, a cycloalkoxy group and the like).

The number of carbon atoms of the divalent hetero ring group is, not including the number of carbon atoms of the substituent, usually 2 to 60, preferably 3 to 20, and more preferably 4 to 15.

The divalent hetero ring group optionally has a substituent. The divalent hetero ring group includes, for example, divalent groups obtained by removing from pyridine, diazabenzene, triazine, azanaphthalene, diazanaphthalene, carbazole, dibenzofuran, dibenzothiophene, dibenzosilole, phenoxazine, phenothiazine acridine, dihydroacridine, furan, thiophene, azole, diazole or triazole two hydrogen atoms among hydrogen atoms bonding directly to carbon atoms or hetero atoms constituting the ring. The divalent hetero ring group is preferably a group represented by the formula (AA-1) to the formula (AA-15) and the formula (AA-18) to the formula (AA-34). The divalent hetero ring group includes groups in which a plurality of these groups are bonded.

[Chemical Formula 15]

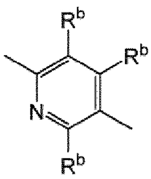
(AA-1)
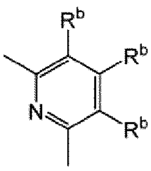
(AA-2)
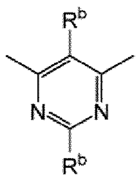
(AA-3)
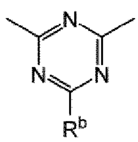
(AA-4)
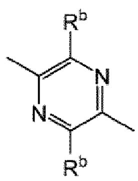
(AA-5)
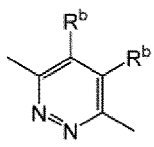
(AA-6)
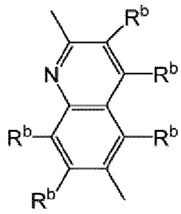
(AA-7)

[Chemical Formula 16]

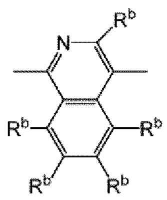
(AA-8)
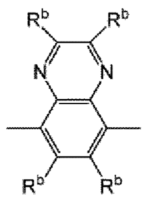
(AA-9)
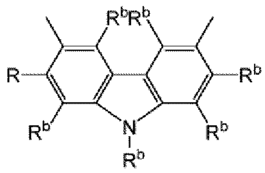
(AA-10)
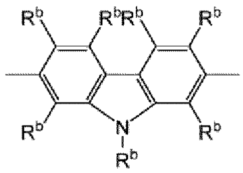
(AA-11)
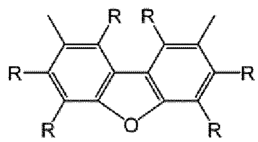
(AA-12)

[Chemical Formula 17]

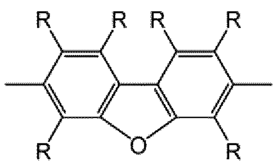
(AA-13)
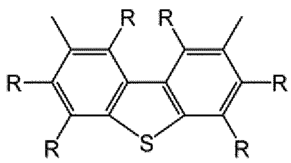
(AA-14)
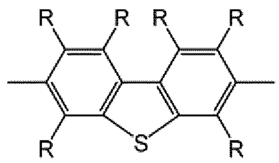
(AA-15)

[Chemical Formula 18]

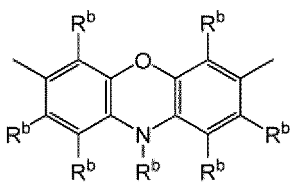
(AA-18)
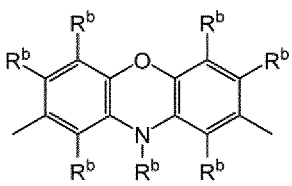
(AA-19)
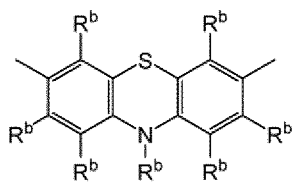
(AA-20)

[Chemical Formula 19]

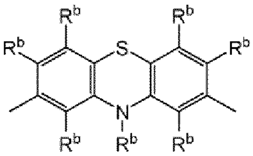

(AA-21)

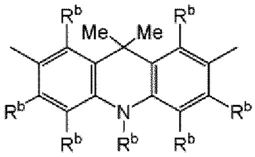

(AA-22)

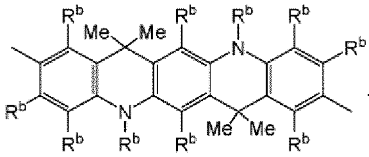

(AA-23)

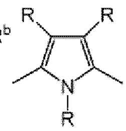

(AA-24)

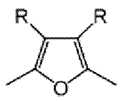

(AA-25)

[Chemical Formula 20]

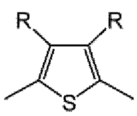

(AA-26)

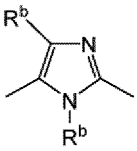

(AA-27)

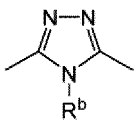

(AA-28)

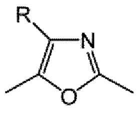

(AA-29)

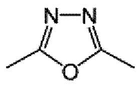

(AA-30)

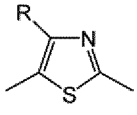

(AA-31)

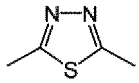

(AA-32)

[Chemical Formula 21]

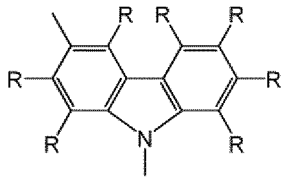

(AA-33)

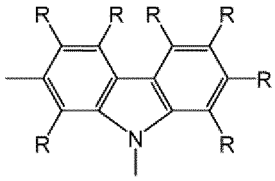

(AA-34)

In the formulae, R and $R^a$ represent the same meaning as described above. $R^b$ represents a hydrogen atom, an alkyl group, a cycloalkyl group, or an aryl group. A plurality of $R^b$ may be the same or different, and the plurality of $R^b$ may be combined together to form a ring together with atoms to which they are attached.

The "halogen atom" denotes a fluorine atom, a chlorine atom, a bromine atom or an iodine atom.

The "amino group" optionally has a substituent, and a substituted amino group (namely, a secondary amino group or a tertiary amino group, particularly a tertiary amino group) is preferred. The substituent which an amino group has is preferably an alkyl group, a cycloalkyl group, an aryl group or a monovalent hetero ring group. When a plurality of the substituents which an amino group has are present, they may be the same or different, and may be combined together to form a ring together with nitrogen atoms to which they are attached.

The substituted amino group includes, for example, a dialkylamino group, a dicycloalkylamino group and a diarylamino group.

The substituted amino group includes, for example, a dimethylamino group, a diethylamino group, a diphenylamino group, a bis(4-methylphenyl)amino group, a bis(4-tert-butylphenyl)amino group, and a bis(3,5-di-tert-butylphenyl)amino group.

The "alkenyl group" may be any of linear or branched. The number of carbon atoms of the linear alkenyl group is, not including the number of carbon atoms of the substituent, usually 2 to 30, and preferably 3 to 20. The number of carbon atoms of the branched alkenyl group is, not including the number of carbon atoms of the substituent, usually 3 to 30, and preferably 4 to 20.

The number of carbon atoms of the "cycloalkenyl group" is, not including the number of carbon atoms of the substituent, usually 3 to 30, and preferably 4 to 20.

The alkenyl group and the cycloalkenyl group optionally have a substituent. The alkenyl group includes, for example, a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups in which a part of all of hydrogen atoms are substituted with a substituent. The cycloalkenyl group includes, for example, a cyclohexenyl group, a cyclohexadienyl group, a cyclooctatrienyl group, a norbornylenyl group, and these groups in which a part of all of hydrogen atoms are substituted with a substituent.

The "alkynyl group" may be any of linear or branched. The number of carbon atoms of the alkynyl group is, not

including carbon atoms of the substituent, usually 2 to 20, and preferably 3 to 20. The number of carbon atoms of the branched alkynyl group is, not including carbon atoms of the substituent, usually 4 to 30, and preferably 4 to 20.

The number of carbon atoms of the "cycloalkynyl group" is, not including carbon atoms of the substituent, usually 4 to 30, and preferably 4 to 20.

The alkynyl group and the cycloalkynyl group optionally have a substituent. The alkynyl group includes, for example, an ethynyl group, a 1-propynyl group, a 2-propynyl group, a 2-butynyl group, a 3-butynyl group, a 3-pentynyl group, a 4-pentynyl group, a 1-hexynyl group, a 5-hexynyl group, and these groups in which a part of all of hydrogen atoms are substituted with a substituent. The cycloalkynyl group includes, for example, a cyclooctynyl group, and this group in which a part of all of hydrogen atoms are substituted with a substituent.

The "crosslinkable group" is a group capable of generating a new bond by being subjected to a heating treatment, an ultraviolet irradiation treatment, a near ultraviolet irradiation treatment, a visible light irradiation treatment, an infrared irradiation treatment, a radical reaction and the like, and preferably a cross-linkable group represented by the formula (XL-1) to the formula (XL-19) in Group A of crosslinkable group, more preferably a cross-linkable group represented by the formula (XL-1), the formula (XL-3), the formula (XL-9), the formula (XL-10), the formula (XL-16) or the formula (XL-17) to the formula (XL-19), further preferably a cross-linkable group represented by the formula (XL-1), the formula (XL-16) or the formula (XL-17) to the formula (XL-19), and particularly preferably a cross-linkable group represented by the formula (XL-1) or the formula (XL-17).

(Group A of crosslinkable group)

[Chemical Formula 22]

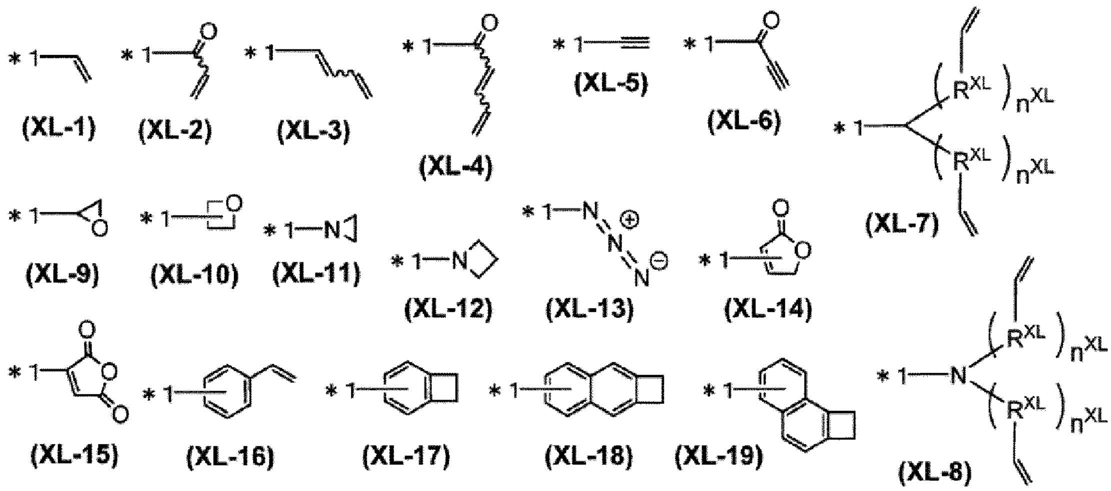

(XL-1) (XL-2) (XL-3) (XL-4) (XL-5) (XL-6) (XL-7)

(XL-9) (XL-10) (XL-11) (XL-12) (XL-13) (XL-14)

(XL-15) (XL-16) (XL-17) (XL-18) (XL-19) (XL-8)

[wherein, $R^{XL}$ represents a methylene group, an oxygen atom or a sulfur atom, and $n^{XL}$ represents an integer of 0 to 5. When a plurality of $R^{XL}$ are present, they may be the same or different. When a plurality of $n^{XL}$ are present, they may be the same or different. *1 represents a linkage position. These crosslinkable groups optionally have a substituent, and when a plurality of the substituents are present, they may be the same or different and may be combined together to form a ring together with carbon atoms to which they are attached.]

The "substituent" is preferably a halogen atom, a cyano group, an alkyl group, a cycloalkyl group, an aryl group, a monovalent hetero ring group, an alkoxy group, a cycloalkoxy group, an aryloxy group, amino group, a substituted amino group, an alkenyl group, a cycloalkenyl group, an alkynyl group or a cycloalkynyl group. The substituent may be a crosslinkable group.

[Constitutional unit represented by the formula (Y)]

The constitutional unit represented by the formula (Y) is preferably a constitutional unit represented by the formula (Y-1) or the formula (Y-2), and more preferably a constitutional unit represented by the formula (Y-1), since the light emitting device is more excellent in light emission efficiency.

[Chemical Formula 23]

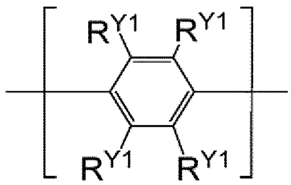

(Y-1)

[wherein,
$R^{Y1}$ represents a hydrogen atom, an alkyl group, a cycloalkyl group, an alkoxy group, a cycloalkoxy group or an aryl group, and these groups optionally have a substituent. A plurality of $R^{Y1}$ may be the same or different, and adjacent $R^{Y1}$ may be combined together to form a ring together with carbon atoms to which they are attached.]

[Chemical Formula 24]

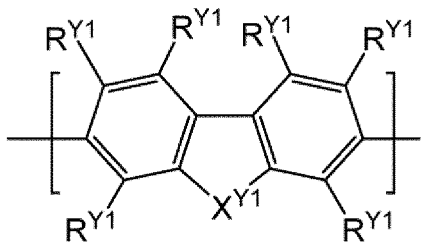

(Y-2)

[wherein,

$R^{Y1}$ represents the same meaning as described above.
$X^{Y1}$ represents a group represented by $-C(R^{Y2})_2-$, $-C(R^{Y2})=C(R^{Y2})-$ or $-C(R^{Y2})_2-C(R^{Y2})_2-$. $R^{Y2}$ represents a hydrogen atom, an alkyl group, a cycloalkyl group, an alkoxy group, a cycloalkoxy group or an aryl group, and these groups optionally have a substituent. A plurality of $R^{Y2}$ may be the same or different, and the plurality of $R^{Y2}$ may be combined together to form a ring together with carbon atoms to which they are attached.]

The combination of two groups $R^{Y2}$ in the group represented by $-C(R^{Y2})_2-$ for $X^{Y1}$ is preferably a combination in which both are alkyl groups or cycloalkyl groups, a combination in which both are aryl groups, or a combination in which one is an alkyl group or a cycloalkyl group and the other is an aryl group, and these groups optionally have a substituent. Two groups $R^{Y2}$ may be combined together to form a ring together with atoms to which they are attached, and when $R^{Y2}$ forms a ring, the group represented by $-C(R^{Y2})_2-$ is preferably a group represented by the formula (Y-A1) to the formula (Y-A5), and these groups optionally have a substituent.

[Chemical Formula 25]

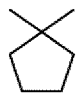

(Y-A1)

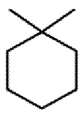

(Y-A2)

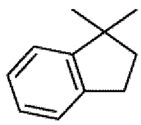

(Y-A3)

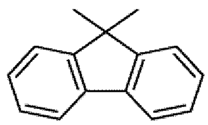

(Y-A4)

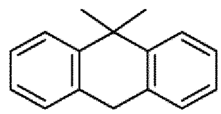

(Y-A5)

The combination of two groups $R^{Y2}$ in the group represented by $-C(R^{Y2})=C(R^{Y2})-$ for $X^{Y1}$ is preferably a combination in which both are alkyl groups or cycloalkyl groups, or a combination in which one is an alkyl group or a cycloalkyl group and the other is an aryl group, and these groups optionally have a substituent.

Four groups $R^{Y2}$ in the group represented by $-C(R^{Y2})_2-C(R^{Y2})_2-$ for $X^{Y1}$ are preferably alkyl groups or cycloalkyl groups optionally having a substituent. A plurality of $R^{Y2}$ may be combined together to form a ring together with atoms to which they are attached, and when $R^{Y2}$ forms a ring, the group represented by $-C(R^{Y2})_2-C(R^{Y2})_2-$ is preferably a group represented by the formula (Y-B1) to the formula (Y-B5), and these groups optionally have a substituent.

[Chemical Formula 26]

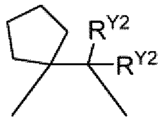
(Y-B1)

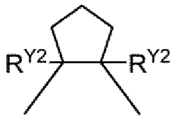
(Y-B2)

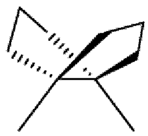
(Y-B3)

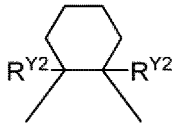
(Y-B4)

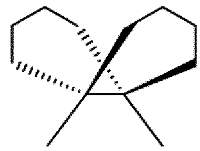
(Y-B5)

[wherein, $R^{Y2}$ represents the same meaning as described above.]

$Ar^{Y1}$ in the formula (Y) is preferably a group represented by the formula (A-1), the formula (A-2), the formula (A-6) to (A-10), the formula (A-19) or the formula (A-20), and these groups optionally have a substituent.

The group represented by $Ar^{Y1}$ preferably has a substituent, and the substituent which the group represented by $Ar^{Y1}$ optionally has is preferably an alkyl group, a cycloalkyl group or an aryl group, and more preferably an alkyl group or a cycloalkyl group, and these groups optionally further have a substituent.

The constitutional unit represented by the formula (Y) includes, for example, constitutional units represented by the formula (Y-101) to the formula (Y-108).

[Chemical Formula 27]

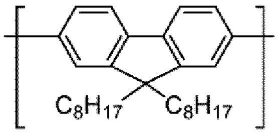
(Y-101)

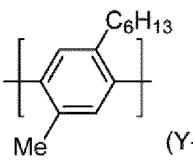
(Y-102)

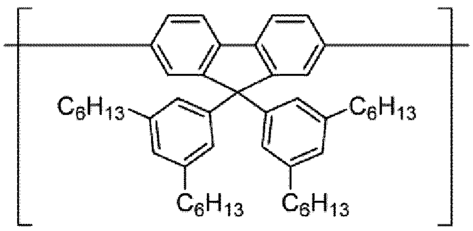
(Y-103)

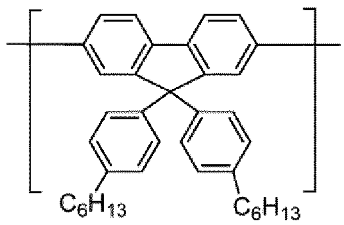
(Y-104)

[Chemical Formula 28]

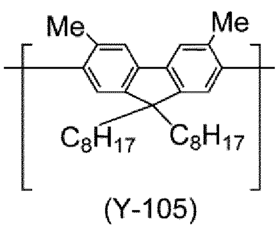
(Y-105)

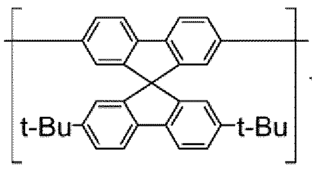
(Y-106)

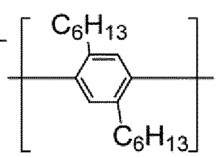
(Y-107)

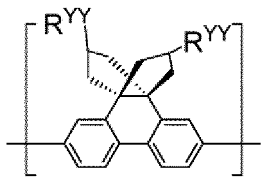
$R^{YY}$ = 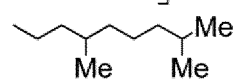
(Y-108)

[Low molecular compound (SM1)]

In the low molecular compound (SM1), the difference between the energy level of the lowest excited triplet state and the energy level of the lowest excited singlet state (also referred to as $\Delta E_{ST}$) is 0.50 eV or less. In the low molecular compound (SM1), the $\Delta E_{ST}$ is preferably 0.46 eV or less, more preferably 0.40 eV or less, further preferably 0.35 eV or less, particularly preferably 0.30 eV or less, especially preferably 0.25 eV or less, and especially more preferably 0.20 eV or less, since the light emitting device of the present embodiment is more excellent in light emission efficiency. Further, in the low molecular compound (SM1), the $\Delta E_{ST}$ may be 0.001 eV or more, may be 0.005 eV or more, may be 0.01 eV or more, and may be 0.05 eV or more.

The low molecular compound (SM1) is preferably a compound having a thermally activated delayed fluorescent

(TADF) property.

For $\Delta E_{ST}$ of SM1, Gaussian09 as a quantum chemical calculation program can be used. For example, $\Delta E_{ST}$ can be calculated by using a B3LYP-level time-dependent density functional method, after structural optimization of the ground state of the compound using a B3LYP-level density functional method. As the basis function, 6-31G* is usually used, however, when an atom for which 6-31G* cannot be applied is contained, LANL2DZ can be used for the atom.

The low molecular compound (SM1) is preferably a compound represented by the formula (T-1), or a compound having a group selected from Group D, since the light emitting device of the present embodiment is more excellent in light emission efficiency.

[Compound represented by the formula (T-1)]

$n^{T1}$ is usually an integer of 0 or more and 10 or less, and since the light emitting device of the present embodiment is more excellent in light emission efficiency, it is preferably an integer of 0 or more and 5 or less, more preferably an integer of 0 or more and 3 or less, further preferably an integer of 0 or more and 2 or less, and particularly preferably 0 or 1.

The monovalent hetero ring group represented by $Ar^{T1}$ is preferably a mono-valent donor type hetero ring group. The above-described mono-valent donor type hetero ring group is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$.

The number of nitrogen atoms of the mono-valent donor type hetero ring group is usually 1 to 10, preferably 1 to 5, more preferably 1 to 3, and further preferably 1 or 2.

In the mono-valent donor type hetero ring group, the number of carbon atoms constituting the ring is usually 1 to 60, preferably 3 to 50, more preferably 5 to 40, further preferably 7 to 30, and particularly preferably 10 to 25.

In the mono-valent donor type hetero ring group, the number of hetero atoms constituting the ring is usually 1 to 30, preferably 1 to 10, more preferably 1 to 5, and further preferably 1 to 3.

The mono-valent donor type hetero ring group is preferably a group obtained by removing from a poly-cyclic heterocyclic compound containing in the ring a nitrogen atom not forming a double bond and not containing in the ring a group represented by =N-, a group represented by -C(=O)-, a group represented by -S(=O)- and a group represented by $-S(=O)_2-$ one hydrogen atom bonding directly to an atom (preferably a carbon atom or a nitrogen atom, more preferably a nitrogen atom) constituting the ring, more preferably a group obtained by removing from a 3-cyclic to 5-cyclic heterocyclic compound containing in the ring a nitrogen atom not forming a double bond and not containing in the ring a group represented by =N-, a group represented by -C(=O)-, a group represented by -S(=O)- and a group represented by $-S(=O)_2-$ one hydrogen atom bonding directly to an atom (preferably a carbon atom or a nitrogen atom, more preferably a nitrogen atom) constituting the ring, further preferably a group obtained by removing from carbazole, phenoxazine, phenothiazine 9,10-dihydroacridine, 5,10-dihydrophenazine, benzocarbazole, dibenzocarbazole, indolocarbazole or indenocarbazole one hydrogen atom bonding directly to an atom (preferably a carbon atom or a nitrogen atom, more preferably a nitrogen atom) constituting the ring, and particularly preferably a group obtained by removing from carbazole, indolocarbazole or indenocarbazole one hydrogen atom bonding directly to an atom (preferably a carbon atom or a nitrogen atom, more preferably a nitrogen atom) constituting the ring, since the light emitting device of the present embodiment is more excellent in light emission efficiency, and these groups optionally have a substituent.

The examples and preferable range of the substituted amino group represented by $Ar^{T1}$ are the same as the examples and preferable range of the substituted amino group as the substituent which $Ar^{T1}$ optionally has described later.

The substituent which $Ar^{T1}$ optionally has is preferably an alkyl group, a cycloalkyl group, an alkoxy group, a cycloalkoxy group, an aryl group, an aryloxy group, a monovalent hetero ring group, a substituted amino group, a halogen atom or a cyano group, more preferably an alkyl group, a cycloalkyl group, an alkoxy group, a cycloalkoxy group, an aryl group, a monovalent hetero ring group or substituted amino group, and further preferably an alkyl group, a cycloalkyl group, an aryl group, a monovalent hetero ring group or substituted amino group, and these groups optionally further have a substituent.

The aryl group as the substituent which $Ar^{T1}$ optionally has is preferably a group obtained by removing from a mono-cyclic or 2-cyclic to 7-cyclic aromatic hydrocarbon one hydrogen atom bonding directly to an atom constituting the ring, more preferably a group obtained by removing from a mono-cyclic or 2-cyclic to 5-cyclic (preferably mono-cyclic, 2-cyclic or 3-cyclic) aromatic hydrocarbon one hydrogen atom bonding directly to an atom constituting the ring, further preferably a group obtained by removing from benzene, naphthalene, anthracene, phenanthrene or fluorene one hydrogen atom bonding directly to an atom constituting the ring, and particularly preferably a phenyl group, and these groups optionally have a substituent.

The monovalent hetero ring group as the substituent which $Ar^{T1}$ optionally has is preferably a group obtained by removing from a mono-cyclic or 2-cyclic to 7-cyclic heterocyclic compound one hydrogen atom bonding directly to an atom constituting the ring, more preferably a group obtained by removing from a mono-cyclic or 2-cyclic to 5-cyclic (preferably mono-cyclic, 2-cyclic or 3-cyclic) heterocyclic compound one or more hydrogen atoms bonding directly to

atoms constituting the ring, further preferably a group obtained by removing from pyridine, diazabenzene, triazine, azanaphthalene, diazanaphthalene, dibenzofuran, dibenzothiophene, carbazole, phenoxazine, phenothiazine 9,10-dihydroacridine, 5,10-dihydrophenazine, benzocarbazole, dibenzocarbazole, indolocarbazole or indenocarbazole one or more hydrogen atoms bonding directly to atoms constituting the ring, and particularly preferably a group obtained by removing from pyridine, diazabenzene, triazine, dibenzofuran, dibenzothiophene or carbazole one or more hydrogen atoms bonding directly to atoms constituting the ring, and these groups optionally further have a substituent.

In the substituted amino group as the substituent which $Ar^{T1}$ optionally has, the substituent which an amino group has is preferably an aryl group or a monovalent hetero ring group, and more preferably an aryl group, and these groups optionally further have a substituent. The examples and preferable range of the aryl group as the substituent which an amino group has are the same as the examples and preferable range of the aryl group as the substituent which $Ar^{T1}$ optionally has. The examples and preferable range of the monovalent hetero ring group as the substituent which an amino group has are the same as the examples and preferable range of the monovalent hetero ring group as the substituent which $Ar^{T1}$ optionally has.

The substituent which the substituent which $Ar^{T1}$ optionally has optionally further has is preferably an alkyl group, a cycloalkyl group, an alkoxy group, a cycloalkoxy group, an aryl group, an aryloxy group, a monovalent hetero ring group, a substituted amino group, a halogen atom or a cyano group, more preferably an alkyl group, a cycloalkyl group, an aryl group, a monovalent hetero ring group or substituted amino group, and further preferably an alkyl group or aryl group, and these groups optionally further have a substituent, but it is preferable that they do not further have a substituent.

The examples and preferable range of the aryl group, the monovalent hetero ring group and the substituted amino group as the substituent which the substituent which $Ar^{T1}$ optionally has optionally further has are the same as the examples and preferable range of the aryl group, the monovalent hetero ring group and the substituted amino group as the substituent which $Ar^{T1}$ optionally has, respectively.

When $n^{T2}$ is an integer of 1 or more, at least one of $n^{T2}$ $Ar^{T1}$ is preferably a substituted amino group, or a monovalent donor type hetero ring group optionally having a substituent, and further preferably a mono-valent donor type hetero ring group, since the light emitting device of the present embodiment is more excellent in light emission efficiency.

$L^{T1}$ represents preferably an alkylene group, a cycloalkylene group, an arylene group or a divalent hetero ring group, more preferably an arylene group or a divalent hetero ring group, and further preferably an arylene group, and these groups optionally have a substituent, since the light emitting device of the present embodiment is more excellent in light emission efficiency.

The arylene group represented by $L^{T1}$ is preferably a group obtained by removing from a mono-cyclic or 2-cyclic to 6-cyclic aromatic hydrocarbon two hydrogen atoms bonding directly to atoms constituting the ring, more preferably a group obtained by removing from a mono-cyclic, 2-cyclic or 3-cyclic aromatic hydrocarbon two hydrogen atoms bonding directly to atoms constituting the ring, further preferably a group obtained by removing from benzene, naphthalene, anthracene, phenanthrene or fluorene two hydrogen atoms bonding directly to atoms constituting the ring, and particularly preferably a phenylene group, and these groups optionally have a substituent.

The divalent hetero ring group represented by $L^{T1}$ is preferably a group obtained by removing from a mono-cyclic or 2-cyclic to 6-cyclic heterocyclic compound two hydrogen atoms bonding directly to atoms (preferably carbon atoms) constituting the ring, more preferably a group obtained by removing from a mono-cyclic, 2-cyclic or 3-cyclic heterocyclic compound two hydrogen atoms bonding directly to atoms (preferably carbon atoms) constituting the ring, further preferably a group obtained by removing from pyridine, diazabenzene, triazine, azanaphthalene, diazanaphthalene, carbazole, dibenzofuran, dibenzothiophene, phenoxazine or phenothiazine two hydrogen atoms bonding directly to atoms (preferably carbon atoms) constituting the ring, and particularly preferably a group obtained by removing from pyridine, diazabenzene or triazine two hydrogen atoms bonding directly to atoms (preferably carbon atoms) constituting the ring, and these groups optionally have a substituent.

The examples and preferable range of the substituent which $L^{T1}$ optionally has are the same as the examples and preferable range of the substituent which $Ar^{T1}$ optionally has.

<Group B>

The aromatic hydrocarbon having an electron-withdrawing group in Group B means an aromatic hydrocarbon having an electron-withdrawing group as a substituent, and the aromatic hydrocarbon optionally has a substituent other than an electron-withdrawing group.

In the aromatic hydrocarbon having an electron-withdrawing group, the number of electron-withdrawing groups which the aromatic hydrocarbon has is usually 1 to 20, preferably 1 to 10, more preferably 1 to 7, further preferably 1 to 5, and particularly preferably 1 to 3.

The electron-withdrawing group includes, for example, an alkyl group having a fluorine atom as a substituent, a fluorine atom, a cyano group, a nitro group, an acyl group and a carboxyl group, and is preferably a cyano group, an

alkyl group having a fluorine atom as a substituent, or a fluorine atom, and more preferably a cyano group.

The alkyl group having a fluorine atom as a substituent is preferably a trifluoromethyl group, a pentafluoroethyl group, a perfluorobutyl group, a perfluorohexyl group or a perfluorooctyl group.

The aromatic hydrocarbon group in the aromatic hydrocarbon group containing an electron-withdrawing group is preferably a group obtained by removing from a mono-cyclic or 2-cyclic to 6-cyclic aromatic hydrocarbon one or more hydrogen atoms bonding directly to atoms constituting the ring, more preferably a group obtained by removing from a mono-cyclic, 2-cyclic or 3-cyclic aromatic hydrocarbon one or more hydrogen atoms bonding directly to atoms constituting the ring, further preferably a group obtained by removing from benzene, naphthalene, anthracene, phenanthrene or fluorene one or more hydrogen atoms bonding directly to atoms constituting the ring, and particularly preferably a group obtained by removing from benzene one or more hydrogen atoms bonding directly to atoms constituting the ring, and these groups optionally have a substituent other than an electron-withdrawing group.

The aromatic hydrocarbon having an electron-withdrawing group includes, for example, the following compounds.

[Chemical Formula 29]

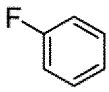
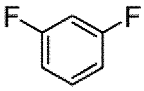
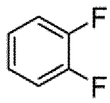
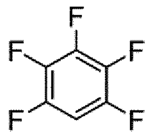
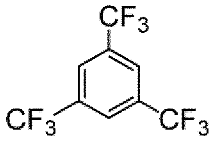
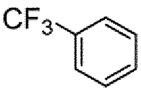
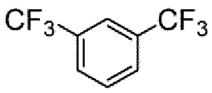
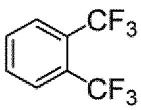
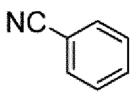
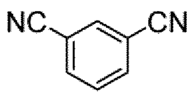
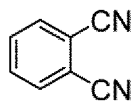

The group in Group B is not a group in Group C and a group in Group D described later.

<Group C>

In the heterocyclic compound containing in the ring a group represented by -C(=O)-, the number of the group represented by -C(=O)- constituting the ring is usually 1 to 10, preferably 1 to 7, more preferably 1 to 5, and further preferably 1 to 3.

The heterocyclic compound containing in the ring a group represented by -C(=O)- includes, for example, aromatic hydrocarbons containing in the ring a group represented by -C(=O)-, and is preferably a 2-cyclic or 3-cyclic aromatic hydrocarbon containing in the ring a group represented by - C(=O)-, more preferably naphthoquinone, anthraquinone, phenanthoquinone, indenone, fluorenone or tetralone, and further preferably anthraquinone, phenanthoquinone or fluorenone, and these aromatic hydrocarbons optionally have a substituent.

In a heterocyclic compound containing in the ring a group represented by =N-, a heterocyclic compound containing in the ring a group represented by -C(=O)-, a heterocyclic compound containing in the ring a group represented by - S(=O)- and a heterocyclic compound containing in the ring a group represented by $-S(=O)_2-$ (hereinafter, referred to as "acceptor type heterocyclic compound"), the total number of a group represented by =N-, a group represented by -C(=O)-, a group represented by -S(=O)- and a group represented by $- S(=O)_2-$ constituting the ring is usually 1 to 20, preferably 1 to 10, more preferably 1 to 5, and further preferably 1 to 3.

In the acceptor type heterocyclic compound, the number of carbon atoms constituting the ring is usually 1 to 60, preferably 2 to 40, and more preferably 3 to 20.

In the acceptor type heterocyclic compound, the number of hetero atoms constituting the ring is usually 1 to 30, preferably 1 to 10, more preferably 1 to 5, and further preferably 1 to 3.

The acceptor type heterocyclic compound is preferably at least one heterocyclic compound selected from the group consisting of a heterocyclic compound containing in the ring a group represented by -C(=O)-, a heterocyclic compound containing in the ring a group represented by $-S(=O)_2-$ and a heterocyclic compound containing in the ring a group represented by =N-, more preferably at least one heterocyclic compound selected from the group consisting of a heterocyclic compound containing in the ring a group represented by-C(=O)- and a heterocyclic compound containing in the ring a group represented by =N-, and further preferably a heterocyclic compound containing in the ring a group represented by =N-, since the light emitting device of the present embodiment is more excellent in light emission efficiency, and these heterocyclic compounds optionally have a substituent.

The acceptor type heterocyclic compound is preferably a mono-cyclic or 2 to 5-cyclic heterocyclic compound,

more preferably oxadiazole, thiadiazole, pyridine, diazabenzene, triazine, azanaphthalene, diazanaphthalene, dibenzothiophene dioxide, dibenzothiophene oxide, dibenzopyranone, azaanthracene, diazaanthracene, azaphenanthrene, diazaphenanthrene, azacarbazole, diazacarbazole, or acridone, and further preferably oxadiazole, thiadiazole, pyridine, diazabenzene, triazine, dibenzothiophene dioxide, dibenzothiophene oxide, or dibenzopyranone, and these heterocyclic compounds optionally have a substituent.

The group in Group C is not a group in Group D described later.

$Ar^{T2}$ is preferably a group selected from Group C.

$Ar^{T2}$ optionally has a substituent other than the group represented by the formula (T-1-1). The substituent is preferably an alkyl group, a cycloalkyl group, an alkoxy group, or a cycloalkoxy group, and more preferably an alkyl group, or a cycloalkyl group.

[Chemical Formula 30]

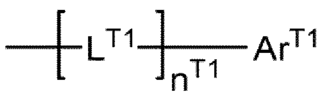
(T-1-1)

[wherein, the definition of $L^{T1}$, $n^{T1}$ and $Ar^{T1}$ is as defined above.]

$n^{T2}$ is usually an integer of 0 or more and 10 or less, and since the light emitting device of the present embodiment is excellent in light emission efficiency, it is preferably an integer of 0 or more and 7 or less, and more preferably an integer of 0 or more and 5 or less. Further preferably, it is an integer of 1 or more and 4 or less, and may be 2 or 3.

[Compound having a group selected from Group D]

The compound having a group selected from Group D may be a compound in which a group selected from Group D and a hydrogen atom are bonded (namely, a heterocyclic compound containing a boron atom, a phosphorus atom, an aluminum atom, a gallium atom, a silicon atom, an arsenic atom or a germanium atom), or may be a compound in which a group selected from Group D and one or more groups represented by the formula (T-1-1) are bonded, and these compounds optionally have a substituent.

In the compound having a group selected from Group D, the number of the group represented by the formula (T-1-1) boding to a group selected from Group D is usually an integer of 0 or more and 10 or less, and since the light emitting device of the present embodiment is excellent in light emission efficiency, it is preferably an integer of 0 or more and 7 or less, and more preferably an integer of 0 or more and 5 or less. Further preferably, it is an integer of 0 or more and 4 or less, and may be 0 or 1.

The total number of a boron atom, a phosphorus atom, an aluminum atom, a gallium atom, a silicon atom, an arsenic atom or a germanium atom in the heterocyclic compound containing a boron atom, a phosphorus atom, an aluminum atom, a gallium atom, a silicon atom, an arsenic atom or a germanium atom in Group D is usually 1 to 20, preferably 1 to 10, more preferably 1 to 5, and further preferably 1 to 3.

The number of carbon atoms in the heterocyclic compound containing a boron atom, a phosphorus atom, an aluminum atom, a gallium atom, a silicon atom, an arsenic atom or a germanium atom in Group D is, not including the number of carbon atoms of the substituent, usually 1 to 60, preferably 5 to 40, and more preferably 10 to 25. Further, the heterocyclic compound may contain an oxygen atom, a nitrogen atom, a sulfur atom, a selenium atom or the like.

The heterocyclic compound containing a boron atom, a phosphorus atom, an aluminum atom, a gallium atom, a silicon atom, an arsenic atom or a germanium atom in Group D is preferably a heterocyclic compound having a condensed hetero ring skeleton (b) containing in the ring a nitrogen atom and one or more selected from the group consisting of a boron atom, a phosphorus atom, an aluminum atom, a gallium atom, a silicon atom, an arsenic atom and a germanium atom. In the condensed hetero ring skeleton (b), it is preferable that at least one of nitrogen atoms contained in the condensed hetero ring skeleton (b) is a nitrogen atom not forming a double bond, and it is more preferable that all nitrogen atoms contained in the condensed hetero ring skeleton (b) are nitrogen atoms not forming a double bond.

The number of carbon atoms of the condensed hetero ring skeleton (b) is, not including the number of carbon atoms of the substituent, usually 1 to 60, preferably 5 to 40, and more preferably 10 to 25.

The number of hetero atoms of the condensed hetero ring skeleton (b) is, not including the number of hetero atoms of the substituent, usually 2 to 30, preferably 2 to 15, more preferably 2 to 10, further preferably 2 to 5, and particularly preferably 2 or 3.

The total number of a boron atom, a phosphorus atom, an aluminum atom, a gallium atom, a silicon atom, an arsenic atom, and a germanium atom in the condensed hetero ring skeleton (b) is, not including those contained in the substituent, usually 1 to 10, preferably 1 to 5, more preferably 1 to 3, and further preferably 1.

The number of nitrogen atoms of the condensed hetero ring skeleton (b) is, not including the number of nitrogen atoms of the substituent, usually 1 to 20, preferably 1 to 10, more preferably 1 to 5, further preferably 1 to 3, and particularly preferably 2.

The condensed hetero ring skeleton (b) is preferably a 3 to 12-cyclic condensed hetero ring skeleton, more preferably a 3 to 6-cyclic condensed hetero ring skeleton, and further preferably a 5-cyclic condensed hetero ring skeleton, since the light emitting device of the present embodiment is more excellent in light emission efficiency.

The "nitrogen atom not forming a double bond" means a nitrogen atom bonding to other three atoms each via a single bond. The expression "containing in the ring a nitrogen atom not forming a double bond" means that -N(-$R^N$)- (wherein, $R^N$ represents a hydrogen atom or a substituent) or a group represented by the formula:

[Chemical Formula 31]

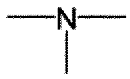

is contained in the ring.

The heterocyclic compound containing a boron atom, a phosphorus atom, an aluminum atom, a gallium atom, a silicon atom, an arsenic atom or a germanium atom in Group D is preferably a compound represented by the formula (D-1).

The heterocyclic compound containing a boron atom, a phosphorus atom, an aluminum atom, a gallium atom, a silicon atom, an arsenic atom or a germanium atom in Group D is preferably a heterocyclic compound containing a boron atom and a heterocyclic compound containing a phosphorus atom, and more preferably a heterocyclic compound containing a boron atom.

The substituent which Ring A, Ring B and Ring C optionally have in the formula (D-1) is preferably an alkyl group, an aryl group, a monovalent hetero ring group, or a substituted amino group, and more preferably an alkyl group, an aryl group, or a substituted amino group, since the light emitting device of the present embodiment is more excellent in light emission efficiency, and these groups optionally have a substituent.

More detailed structures (CA, CB and CC) of Ring A, Ring B and Ring C in the formula (D-1) are described below.

[Chemical Formula 32]

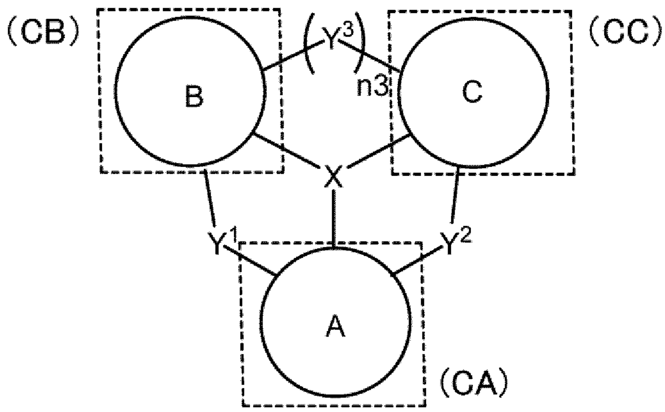

The detailed structure (CA) of Ring A includes, for example, structures represented by the formula (CA01) to the formula (CA38), and since the light emitting device of the present embodiment is more excellent in light emission efficiency, it is preferably a structure represented by the formula (CA01) to the formula (CA19), more preferably a structure represented by the formula (CA01) to the formula (CA05), and further preferably a structure represented by the formula (CA01).

[Chemical Formula 33]

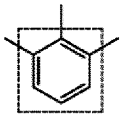
(CA01)

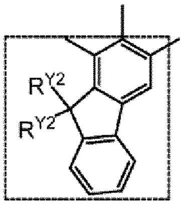
(CA02)

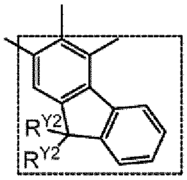
(CA03)

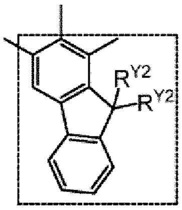
(CA04)

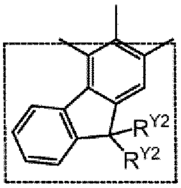
(CA05)

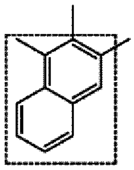
(CA06)

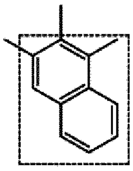
(CA07)

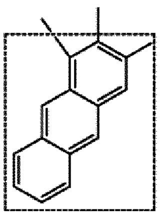
(CA08)

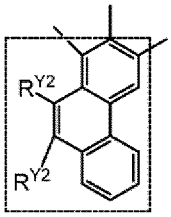
(CA09)

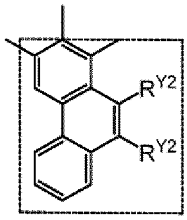
(CA10)

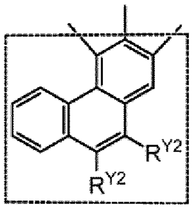
(CA11)

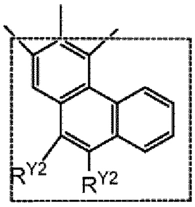
(CA12)

[Chemical Formula 34]

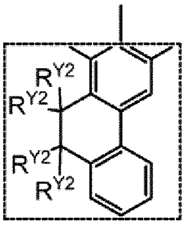
(CA13)

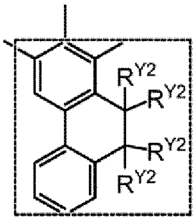
(CA14)

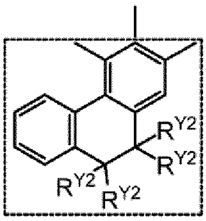
(CA15)

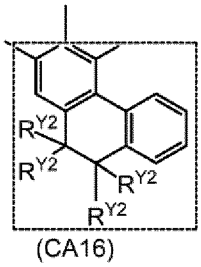
(CA16)

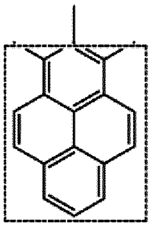
(CA17)

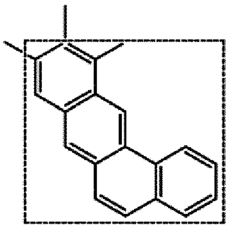
(CA18)

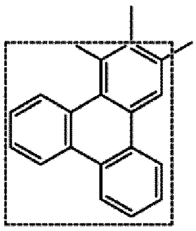
(CA19)

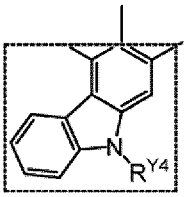
(CA20)

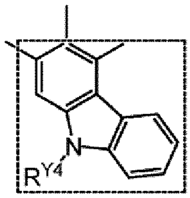
(CA21)

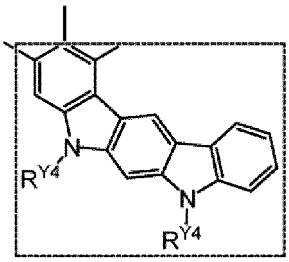
(CA22)

[Chemical Formula 35]

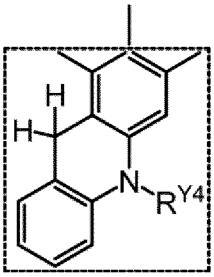
(CA23)

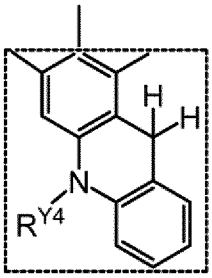
(CA24)

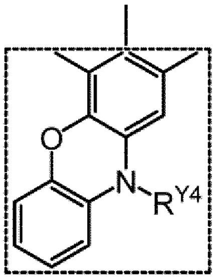
(CA25)

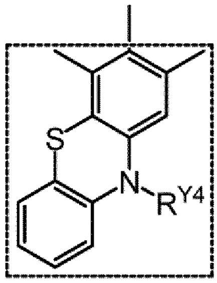
(CA26)

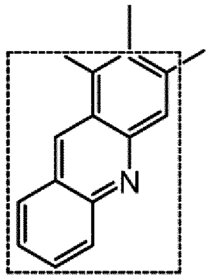
(CA27)

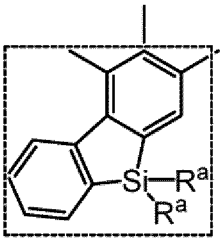
(CA28)

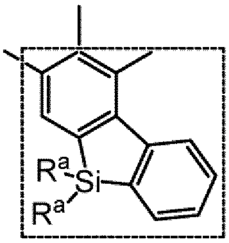
(CA29)

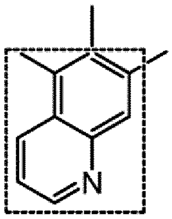
(CA30)

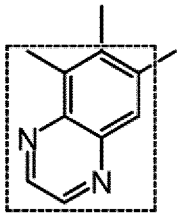
(CA31)

[Chemical Formula 36]

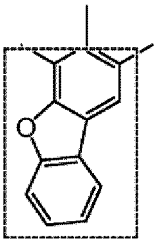
(CA32)

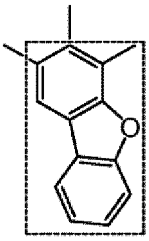
(CA33)

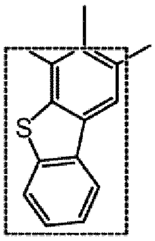
(CA34)

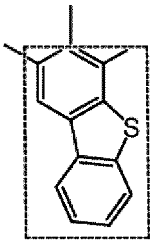
(CA35)

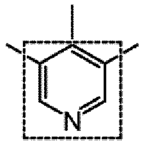
(CA36)

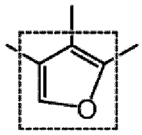
(CA37)

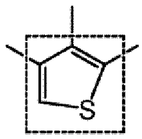
(CA38)

[wherein, $R^{Y2}$ and $R^a$ represent the same meaning as described above.

$R^{Y4}$ represents a hydrogen atom, an alkyl group, a cycloalkyl group or an aryl group, and these groups optionally have a substituent. When a plurality of $R^{Y4}$ are present, they may be the same or different.

A hydrogen atom in the formula may be substituted with a substituent which Ring A optionally has.]

The detailed structure (CB) of Ring B includes, for example, structures represented by the formula (CB01) to the formula (CB24), and since the light emitting device of the present embodiment is excellent in light emission efficiency, it is preferably a structure represented by the formula (CB01) to the formula (CB13), more preferably a structure represented by the formula (CB01) to the formula (CB05), and particularly preferably a structure represented by the formula (CB01).

[Chemical Formula 37]

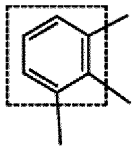
(CB01)

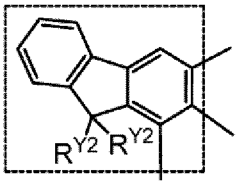
(CB02)

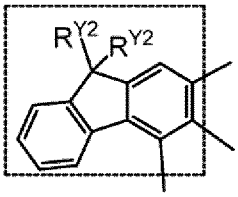
(CB03)

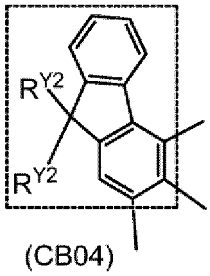
(CB04)

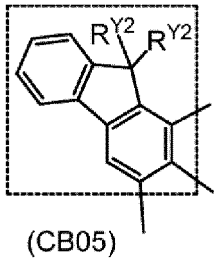
(CB05)

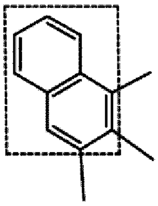
(CB06)

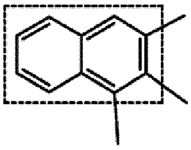
(CB07)

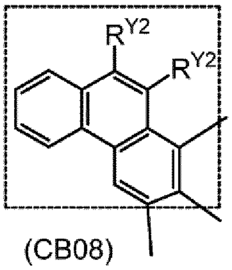
(CB08)

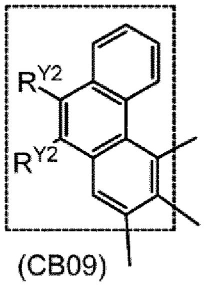
(CB09)

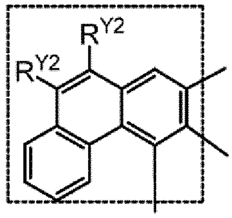
(CB10)

[Chemical Formula 38]

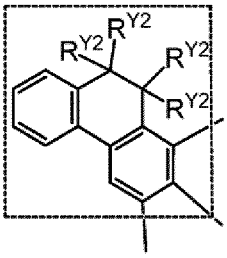
(CB11)

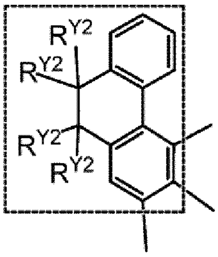
(CB12)

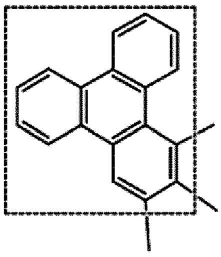
(CB13)

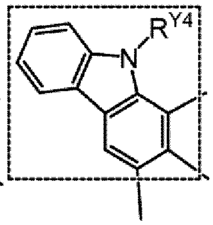
(CB14)

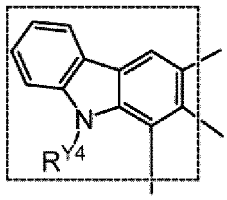
(CB15)

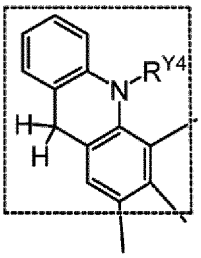
(CB16)

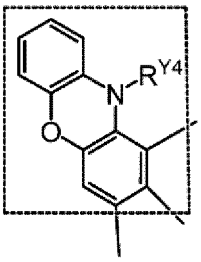
(CB17)

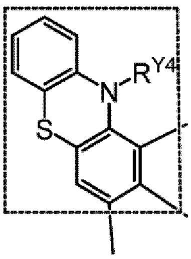
(CB18)

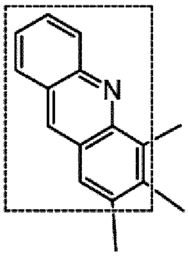
(CB19)

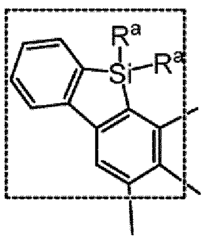
(CB20)

[Chemical Formula 39]

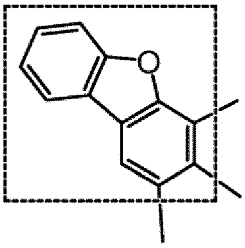
(CB21)

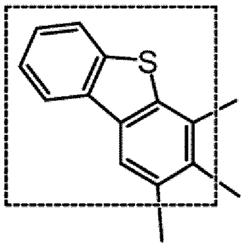
(CB22)

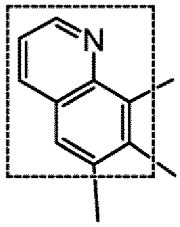
(CB23)

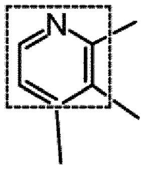
(CB24)

[wherein, $R^{Y2}$, $R^{Y4}$ and $R^a$ represent the same meaning as described above. A hydrogen atom may be substituted with a substituent which Ring B optionally has.]

The detailed structure (CC) of Ring C includes, for example, structures represented by the formula (CC01) to the formula (CC24), and is preferably a structure represented by the formula (CC01) to the formula (CC13), more preferably a structure represented by the formula (CC01) to the formula (CC05), and further preferably a structure represented by the formula (CC01).

[Chemical Formula 40]

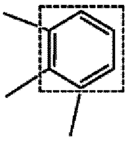
(CC01)

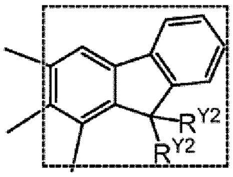
(CC02)

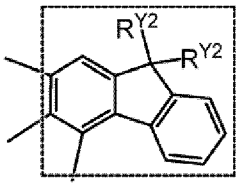
(CC03)

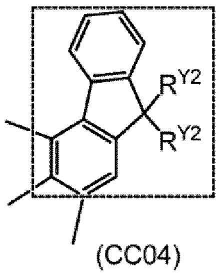
(CC04)

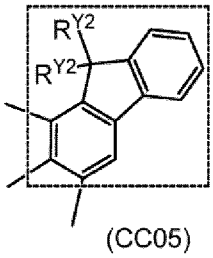
(CC05)

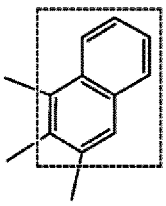
(CC06)

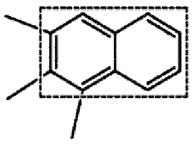
(CC07)

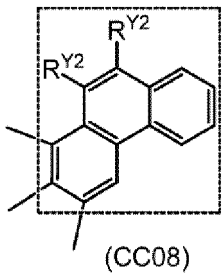
(CC08)

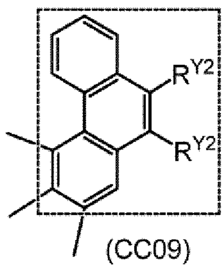
(CC09)

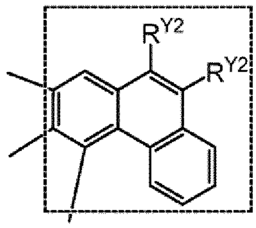
(CC10)

[Chemical Formula 41]

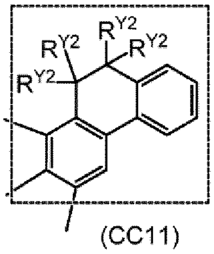
(CC11)
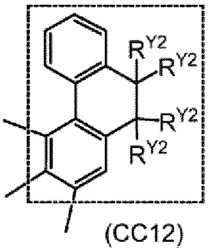
(CC12)
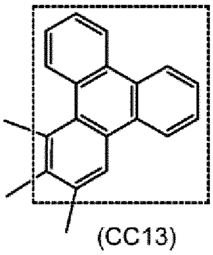
(CC13)
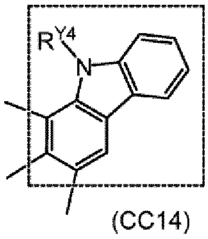
(CC14)
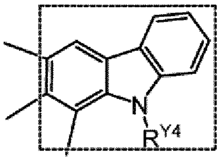
(CC15)

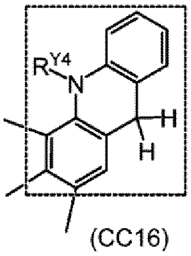
(CC16)
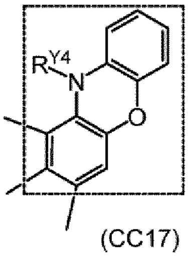
(CC17)
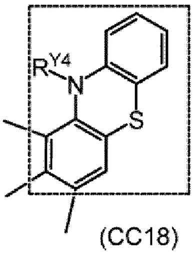
(CC18)
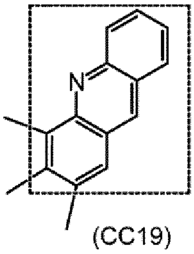
(CC19)
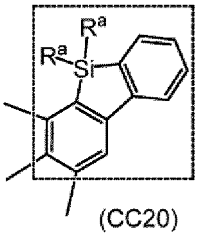
(CC20)

[Chemical Formula 42]

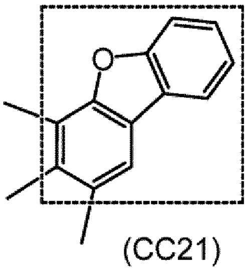
(CC21)
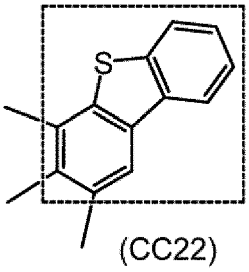
(CC22)
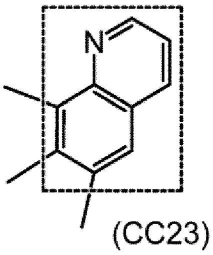
(CC23)
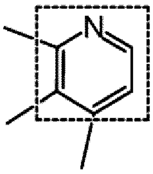
(CC24)

[wherein, $R^{Y2}$, $R^{Y4}$ and $R^a$ represent the same meaning as described above. A hydrogen atom may be substituted with a substituent which Ring C optionally has.]

In the formula (CA02) to the formula (CA05), the formula (CB02) to the formula (CB05), and the formula (CC02) to the formula (CC05), the combination of two groups $R^{Y2}$ in the group represented by $-C(R^{Y2})_2-$ is preferably a combination in which both are alkyl groups or cycloalkyl groups, both are aryl groups, both are monovalent hetero ring groups, or one is an alkyl group or cycloalkyl group and the other is an aryl group or monovalent hetero ring group, and more preferably a combination in which one is an alkyl group or cycloalkyl group and the other is an aryl group, and these groups optionally have a substituent. When two groups $R^{Y2}$ in the group represented by $-C(R^{Y2})_2-$ are combined together to form a ring together with the carbon atoms, the group represented by $-C(R^{Y2})_2-$ is preferably a group represented by the formula (Y-A1) to the formula (Y-A5), and more preferably a group represented by the formula (Y-A4), and these groups optionally have a substituent.

[Chemical Formula 43]

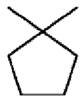
(Y-A1)
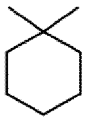
(Y-A2)
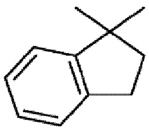
(Y-A3)
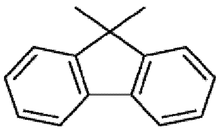
(Y-A4)
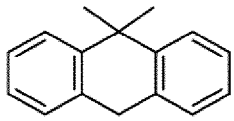
(Y-A5)

In the formula (CA09) to the formula (CA12), the formula (CB08) to the formula (CB10) and the formula (CC08) to the formula (CC10), the combination of two groups $R^{Y2}$ in the group represented by $-C(R^{Y2}) = C(R^{Y2})-$ is preferably a combination in which both are alkyl groups or cycloalkyl groups, or one is an alkyl group or cycloalkyl group and the other is an aryl group, and these groups optionally have a substituent.

In the formula (CA13) to the formula (CA16), the formula (CB11), the formula (CB12), the formula (CC11) and the formula (CC12), four groups $R^{Y2}$ in the group represented by $-C(R^{Y2})_2-C(R^{Y2})_2-$ are preferably alkyl groups optionally having a substituent or cycloalkyl groups optionally having a substituent. A plurality of $R^{Y2}$ may be combined together to form a ring together with carbon atoms to which they are attached, and when $R^{Y2}$ forms a ring, the group represented by $-C(R^{Y2})_2-C(R^{Y2})_2-$ is preferably a group represented by the formula (Y-B1) to the formula (Y-B5), and more preferably a group represented by the formula (Y-B3), and these groups optionally have a substituent.

[Chemical Formula 44]

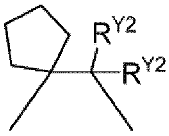
(Y-B1)

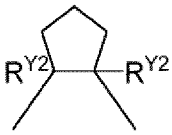
(Y-B2)

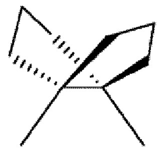
(Y-B3)

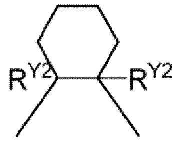
(Y-B4)

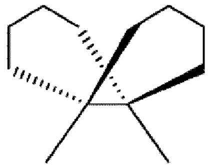
(Y-B5)

[wherein, $R^{Y2}$ represents the same meaning as described above.]

In the formula (CA20) to the formula (CA26), the formula (CB14) to the formula (CB18) and the formula (CC14) to the formula (CC18), $R^{Y4}$ is preferably an alkyl group, a cycloalkyl group, an alkoxy group, a cycloalkoxy group, an aryl group or a monovalent hetero ring group, and more preferably an aryl group, and these groups optionally have a substituent.

In the compound (B), the combination of Ring A, Ring B and Ring C is preferably a combination in which Ring A is a structure represented by the formula (CA01) to the formula (CA05), Ring B is a structure represented by the formula (CB01) to the formula (CB05), and, and Ring C is a structure represented by the formula (CC01) to the formula (CC05), more preferably a combination in which Ring A is a structure represented by the formula (CA01), Ring B is a structure represented by the formula (CB01) to the formula (CB05), and Ring C is a structure represented by the formula (CC01) to the formula (CC05), and further preferably a combination in which Ring A is a structure represented by the formula (CA01), Ring B is a structure represented by the formula (CB01), and Ring C is a structure represented by the formula (CC01), since the light emitting device of the present embodiment is more excellent in light emission efficiency.

n3 is preferably 0, since the light emitting device of the present embodiment is more excellent in external quantum efficiency.

$Y^2$ and $Y^3$ represent preferably -N(-Ry)- or a sulfur atom, more preferably -N(-Ry)-.

It is preferable that at least one of $Y^2$ and $Y^3$ is -N(-Ry)-, and it is more preferable that both $Y^2$ and $Y^3$ represent -N(-Ry)-, since the present embodiment is more excellent in light emission efficiency. Note that when n3 is 0, $Y^2$ is preferably -N(-Ry)-.

Ry is preferably a hydrogen atom, an aryl group optionally having a substituent, or a monovalent hetero ring group optionally having a substituent, more preferably a hydrogen atom or an aryl group optionally having a substituent, further preferably an aryl group optionally having a substituent, since the light emitting device of the present embodiment is more excellent in light emission efficiency.

When Ry is bonded to Ring A, Ring B or Ring C via a linking group, the linking group includes, for example, divalent groups such as -O-, -S-, $-CH_2$ - and the like, and trivalent groups such as a boron atom and the like.

When Ry is bonded to Ring A, Ring B or Ring C via a trivalent group, it is usually linked to Ring A at a substituent on Ring A, linked to Ring B at a substituent on Ring B, or linked to Ring C at a substituent on Ring C.

The molecular weight of the low molecular compound (SM1) is preferably $1 \times 10^2$ to $5 \times 10^3$, more preferably $2 \times 10^2$ to $3 \times 10^3$, further preferably $3 \times 10^2$ to $1.5 \times 10^3$, and particularly preferably $4 \times 10^2$ to $1 \times 10^3$.

The low molecular compound (SM1) includes, for example, compounds represented by the following formulae.

[Chemical Formula 45]

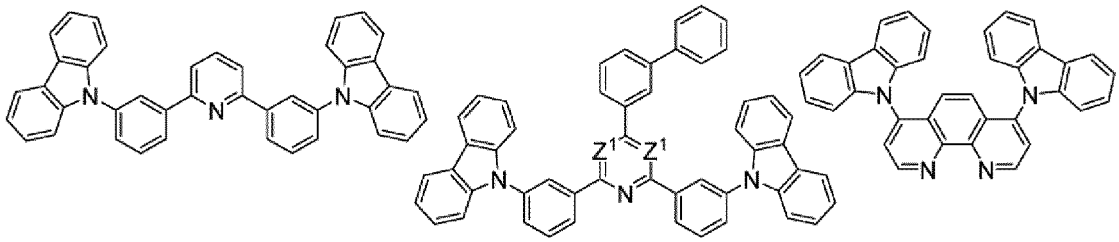

[Chemical Formula 46]

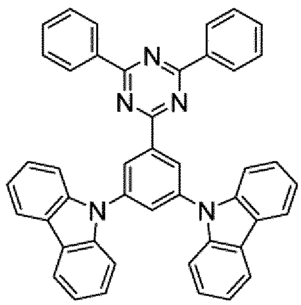

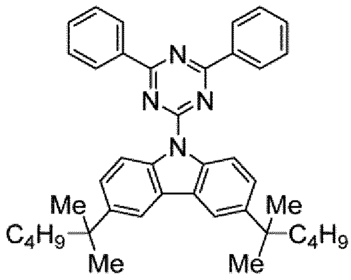

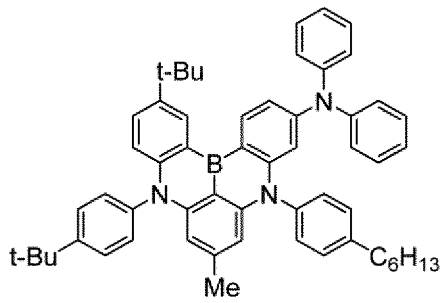

[Chemical Formula 47]

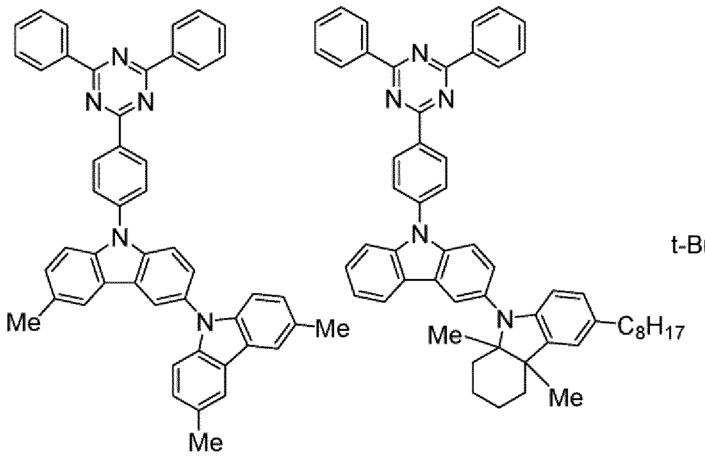

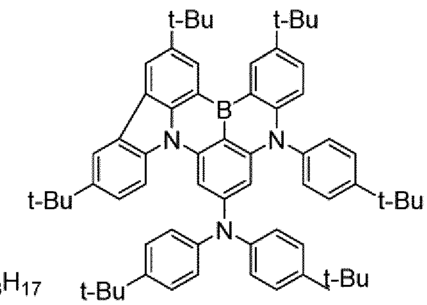

[Chemical Formula 48]

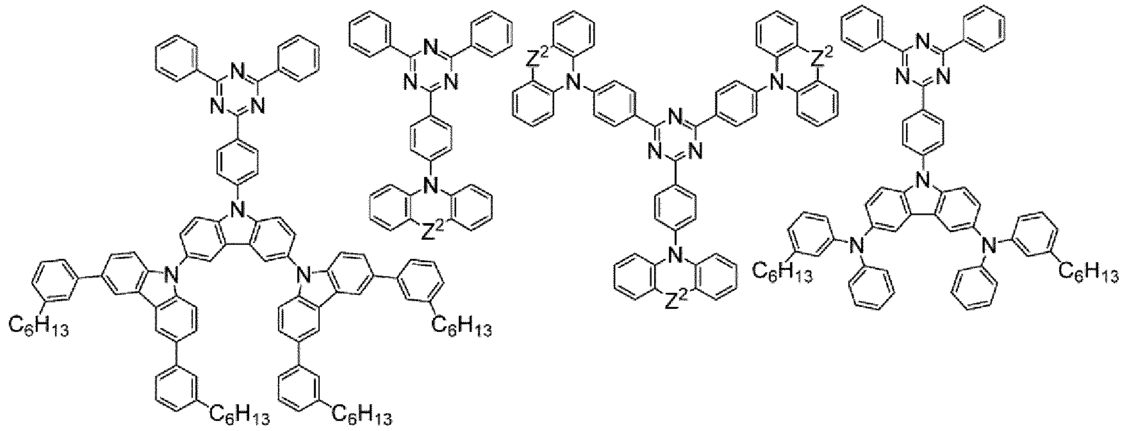

[Chemical Formula 49]

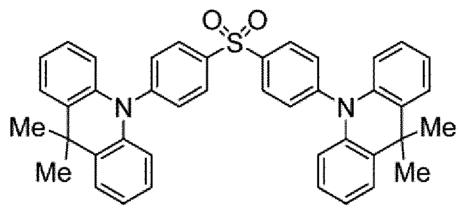
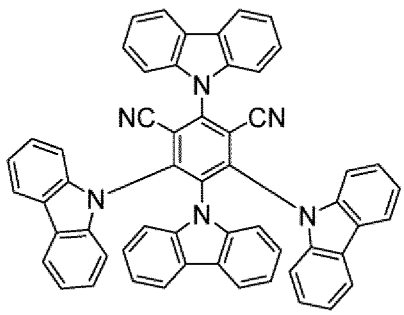

[Chemical Formula 50]

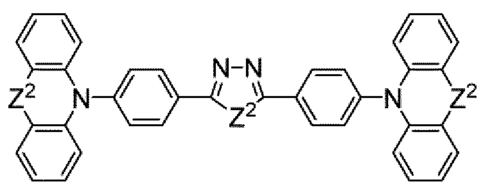
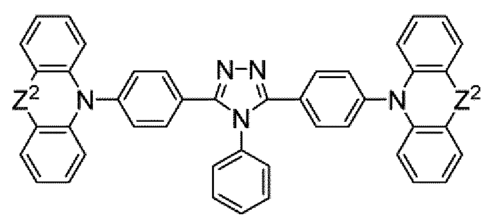
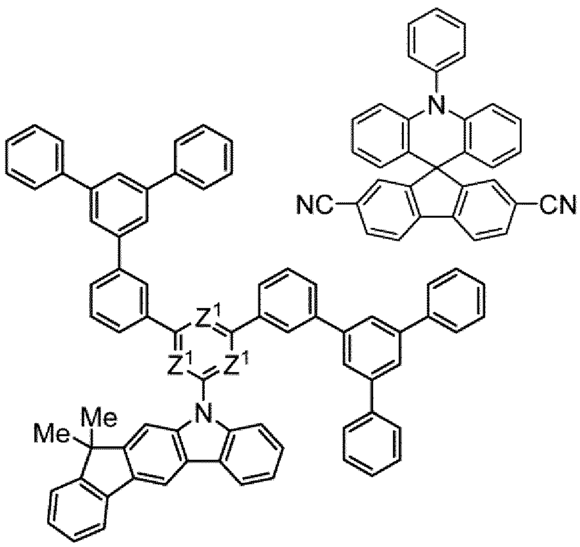

[wherein,

$Z^1$ represents a group represented by -N=, or a group represented by -CH=.
$Z^2$ represents an oxygen atom or a sulfur atom.
A plurality of $Z^1$ and $Z^2$ each may be the same or different.]
$Z^1$ is preferably a group represented by -N=. $Z^2$ is preferably an oxygen atom.

The low molecular compound (SM1) is available from Aldrich, Luminescence Technology Corp., and the like. In addition, it can be synthesized according to methods described in, for example, International Publication WO

2007/063754, International Publication WO 2008/056746, International Publication WO 2011/032686, International Publication WO 2012/096263, Japanese Unexamined Patent Application Publication (JP-A) No. 2009-227663, JP-A No. 2010-275255, and Advanced Materials, vol. 26, pp. 7931-7958, 2014.

The constitutional unit composed of a group obtained by removing a hydrogen atom from the low molecular compound (SM1) includes, for example, constitutional units represented by the formula (MC1-1) to the formula (MC1-3), the formula (MC2-1) to the formula (MC2-8), and the formula (MC3-1) to the formula (MC3-5).

[Chemical Formula 51]

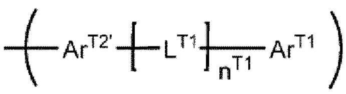

(MC1-1)

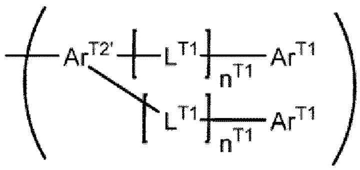

(MC1-2)

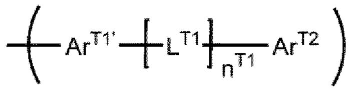

(MC1-3)

[Chemical Formula 52]

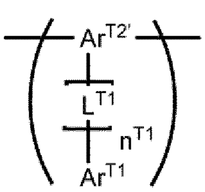

(MC2-1)

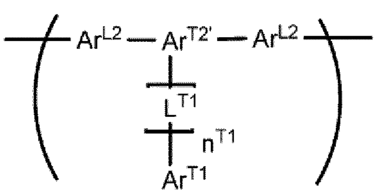

(MC2-2)

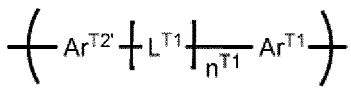

(MC2-3)

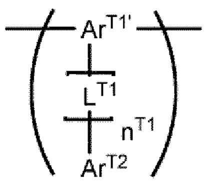

(MC2-4)

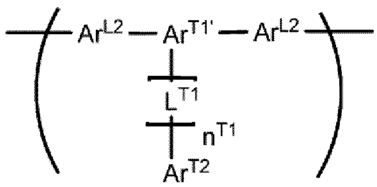

(MC2-5)

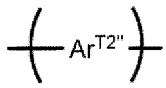

(MC2-8)

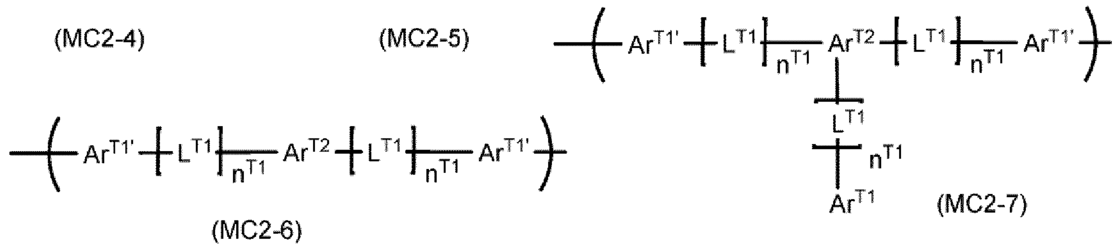

(MC2-6)

(MC2-7)

[Chemical Formula 53]

[wherein,

$n^{T1}$, $L^{T1}$, $Ar^{T1}$ and $Ar^{T2}$ have the same meaning as described above.

$Ar^{L2}$ represents an arylene group or a divalent hetero ring group, and these groups optionally have a substituent.

$Ar^{L3}$ is a group obtained by removing from an aromatic hydrocarbon ring or aromatic hetero ring three hydrogen atoms.

$Ar^{T1'}$ is a group obtained by removing from $Ar^{T1}$ one hydrogen atom.

$Ar^{T2'}$ is a group obtained by removing from $Ar^{T2}$ one hydrogen atom or two hydrogen atoms, or a group selected from Group D.

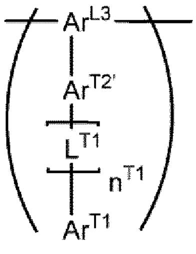

(MC3-1)

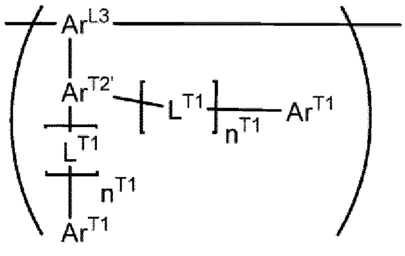

(MC3-2)

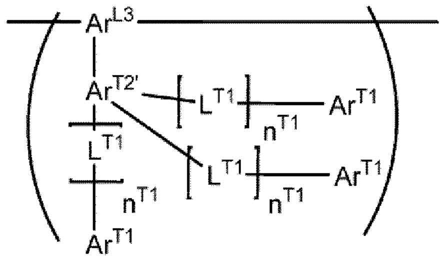

(MC3-3)

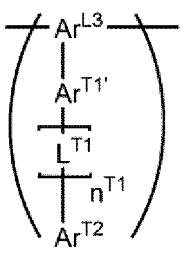

(MC3-4)

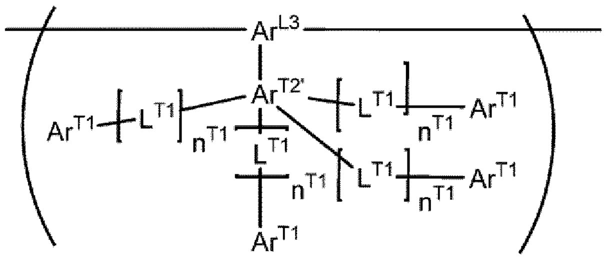

(MC3-5)

$Ar^{T2''}$ is a group selected from Group D]

As a preferable structure in the formula (MC1-1) to the formula (MC1-3), the formula (MC2-1) to the formula (MC2-7), and the formula (MC3-1) to the formula (MC3-5), the following structures are exemplified.

[Chemical Formula 54]

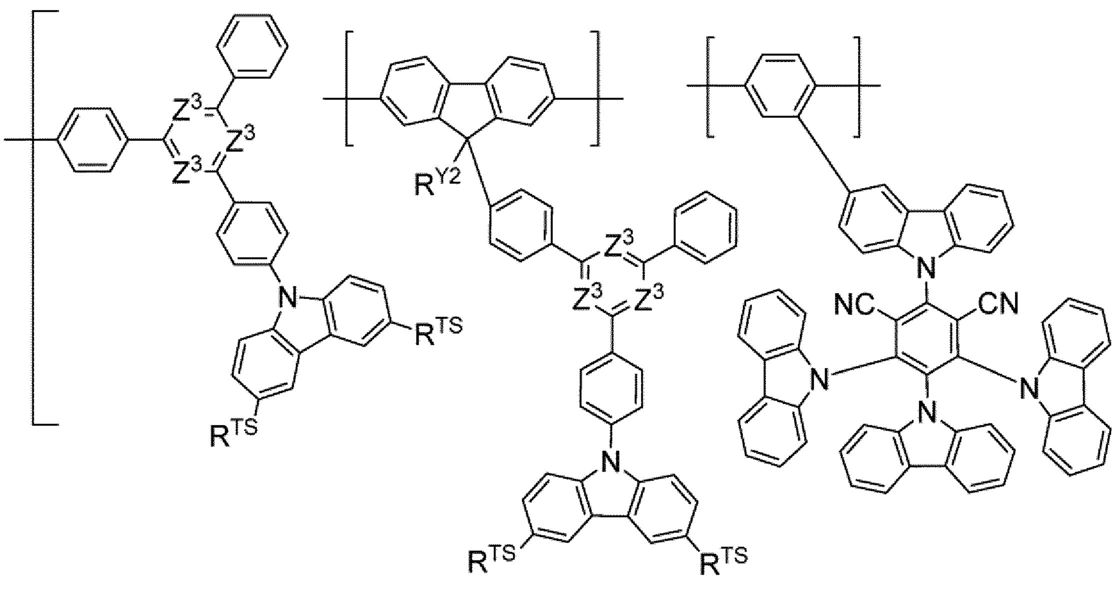

[Chemical Formula 55]

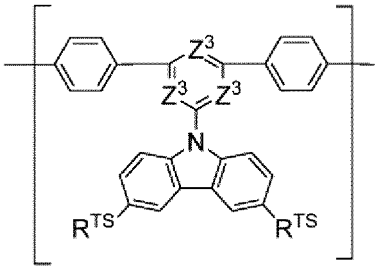
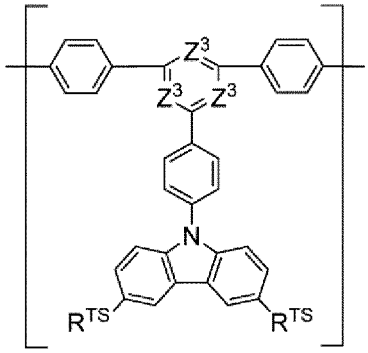
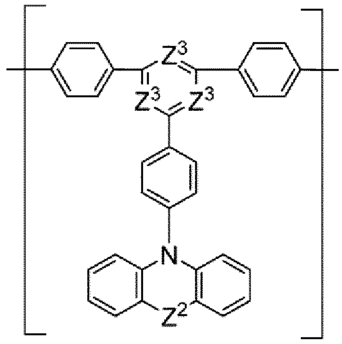

[Chemical Formula 56]

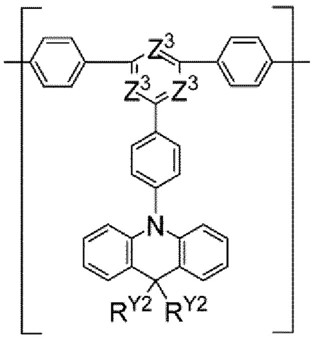
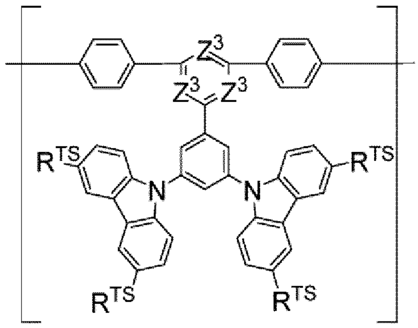
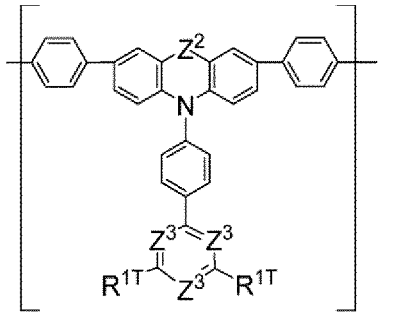

[Chemical Formula 57]

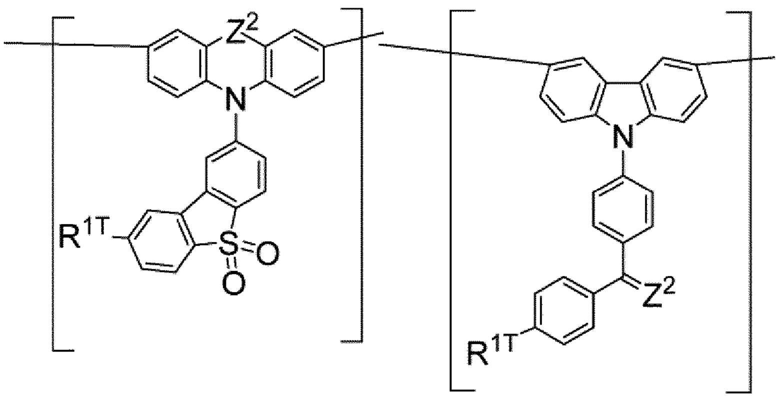
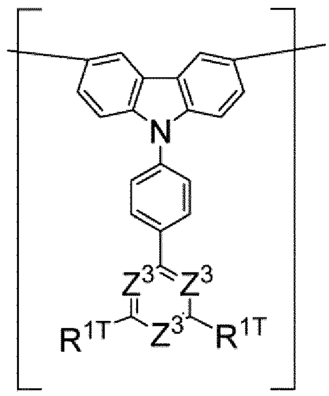

[Chemical Formula 58]

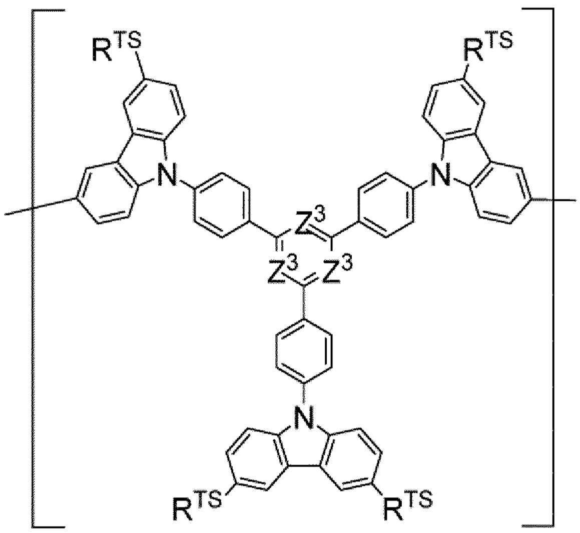

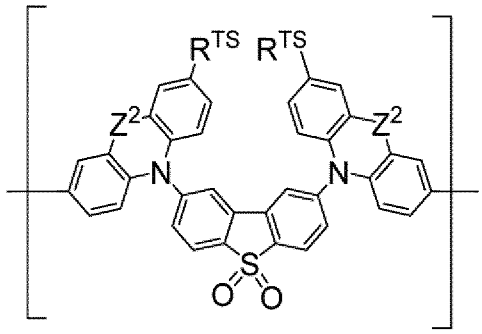

[Chemical Formula 59]

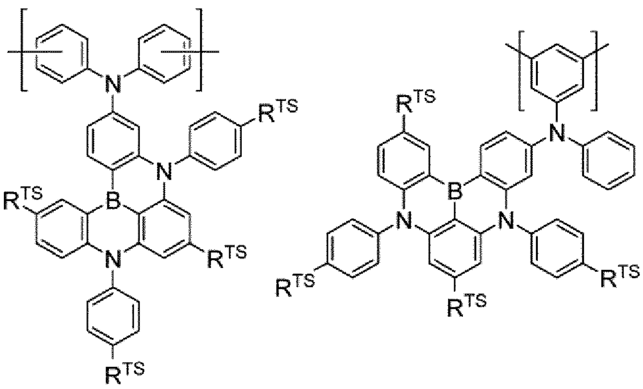

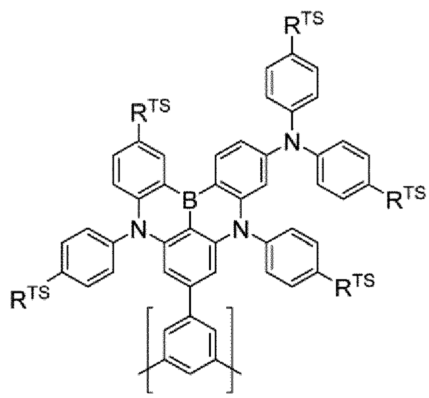

As a preferable structure in the formula (MC2-8), the following structures are exemplified.

[Chemical Formula 60]

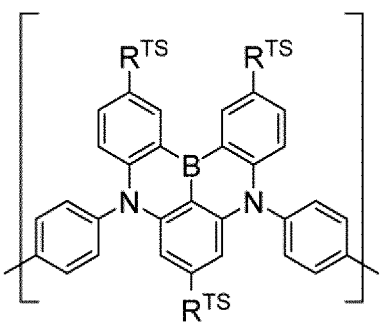

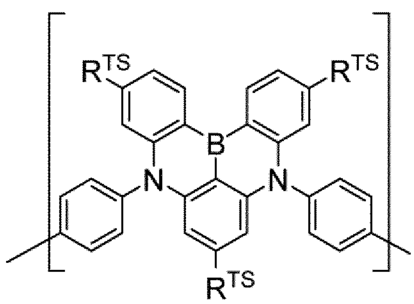

[wherein,

$R^{Y2}$ and $Z^2$ represent the same meaning as described above.

$Z^3$ represents -CH- or =N-.

$R^{1T}$ represents a hydrogen atom, an alkyl group, a cycloalkyl group, an alkoxy group, a cycloalkoxy group, a halogen atom, a cyano group, or a group represented by the formula (T1-1-1), and these groups optionally have a substituent.

$R^{TS}$ represents a hydrogen atom, an alkyl group, a cycloalkyl group, an alkoxy group, a cycloalkoxy group, an aryl group, an aryloxy group, a monovalent hetero ring group, a substituted amino group, a halogen atom or a cyano group, and these groups optionally further have a substituent. A plurality of $R^{TS}$ may be the same or different.]

$R^{TS}$ is preferably a hydrogen atom, an alkyl group, a cycloalkyl group, an alkoxy group, a cycloalkoxy group, an aryl group, a monovalent hetero ring group, a substituted amino group or a cyano group, and more preferably a hydrogen atom, an alkyl group or a monovalent hetero ring group.

The examples and preferable range of the aryl group, the monovalent hetero ring group and the substituted amino group represented by $R^{TS}$ are the same as the examples and preferable range of the aryl group, the monovalent hetero ring group and the substituted amino group as the substituent which $Ar^{T1}$ optionally has, respectively.

The examples and preferable range of the substituent which $R^{TS}$ optionally has are the same as the examples and preferable range of the substituent which the substituent which $Ar^{T1}$ optionally has optionally further has, respectively.

[Constitutional unit represented by the formula (X)]

$a^{X1}$ is preferably 2 or less, more preferably 0 or 1, and further preferably 0, since the light emitting device of the present embodiment is more excellent in light emission efficiency.

$a^{X2}$ is preferably 2 or less, and more preferably 0, since the light emitting device of the present embodiment is more excellent in light emission efficiency.

$R^{X1}$, $R^{X2}$ and $R^{X3}$ represent preferably an alkyl group, a cycloalkyl group, an aryl group or a monovalent hetero ring group, and more preferably an aryl group, and these groups optionally have a substituent.

The examples and preferable range of the arylene group and the divalent hetero ring group represented by $Ar^{X1}$ , $Ar^{X2}$ , $Ar^{X3}$ and $Ar^{X4}$ are the preferable range of the arylene group represented by $Ar^{Y1}$ and the preferable range of the divalent hetero ring group described in [Explanation of common terms], respectively.

The examples and preferable range of the arylene group and the divalent hetero ring group as the divalent group in which at least one arylene group and at least one divalent hetero ring group are bonded directly represented by $Ar^{X2}$ and $Ar^{X4}$ are the preferable range of the arylene group represented by $Ar^{Y1}$ and the preferable range of the divalent hetero ring group described in [Explanation of common terms], respectively.

The divalent group in which at least one arylene group and at least one divalent hetero ring group are bonded directly represented by $Ar^{X2}$ and $Ar^{X4}$ includes groups in which at least one selected from the formula (A-1) to the formula (A-20) and at least one selected from the formula (AA-1) to the formula (AA-15) and the formula (AA-18) to the formula (AA-34) are bonded.

$Ar^{X1}$ , $Ar^{X2}$ , $Ar^{X3}$ and $Ar^{X4}$ represent preferably an arylene group optionally having a substituent.

The examples and preferable range of the substituent which a group represented by $Ar^{X1}$ to $Ar^{X4}$ and $R^{X1}$ to $R^{X3}$ optionally has are the same as the examples and preferable range of the substituent which a group represented by $Ar^{Y1}$ optionally has.

The constitutional unit represented by the formula (X) is preferably a constitutional unit represented by the formula (X-1) to the formula (X-7).

[Chemical Formula 61]

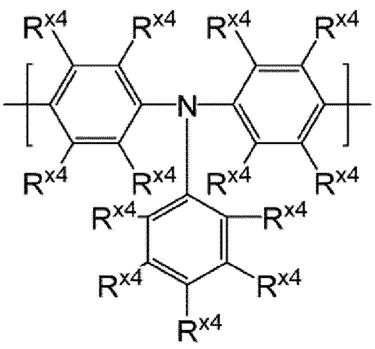

(X-1)

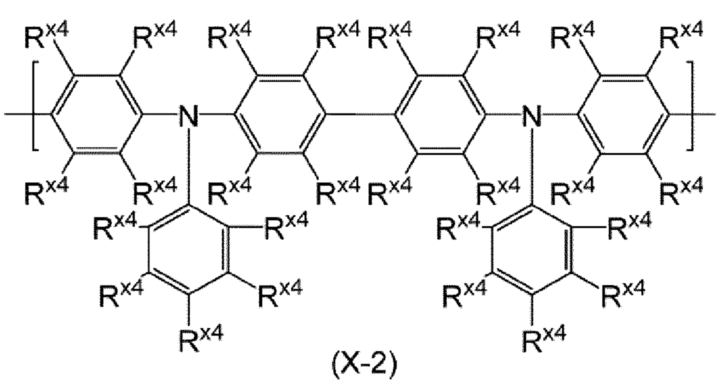

(X-2)

[Chemical Formula 62]

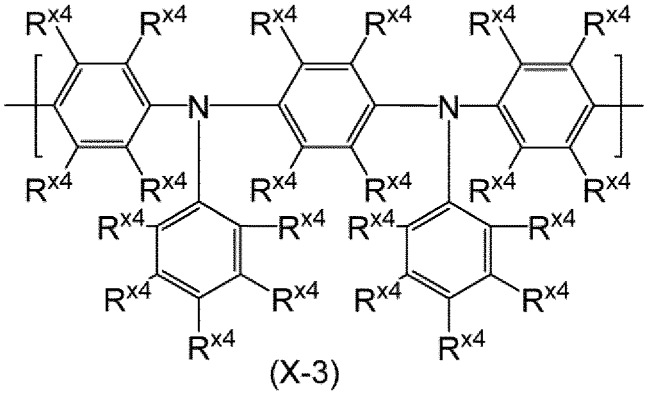

(X-3)

[Chemical Formula 63]

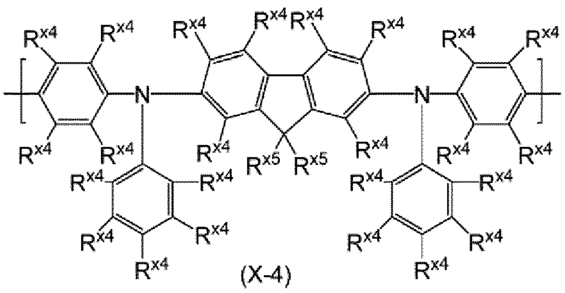

(X-4)

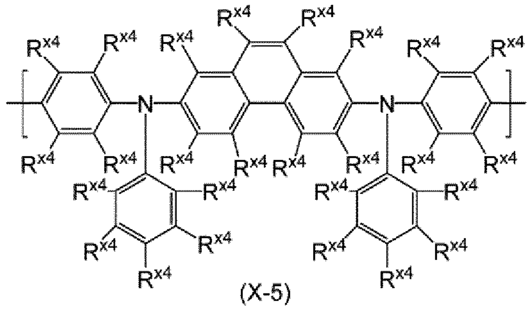

(X-5)

[Chemical Formula 64]

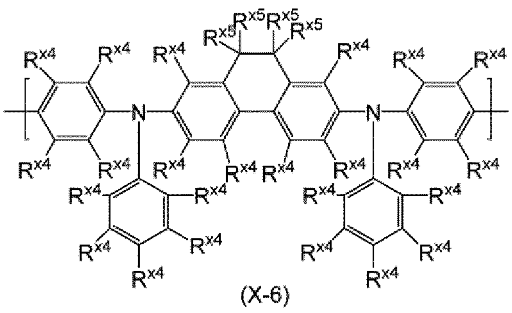

(X-6)

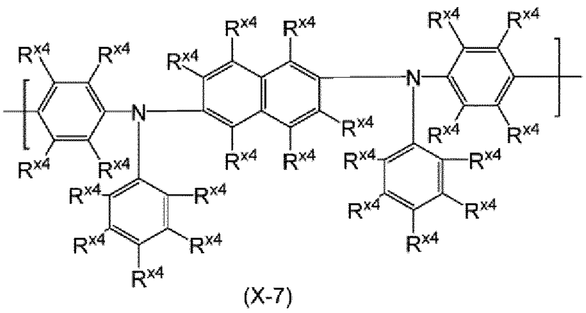

(X-7)

[wherein, $R^{X4}$ and $R^{X5}$ each independently represent a hydrogen atom, an alkyl group, a cycloalkyl group, an alkoxy group, a cycloalkoxy group, an aryl group, an aryloxy group, a halogen atom, a monovalent hetero ring group or a cyano group, and these groups optionally have a substituent. A plurality of $R^{X4}$ may be the same or different, and may be combined together to form a ring together with carbon atoms to which they are attached. A plurality of $R^{X3}$ may be the same or different, and may be combined together to form a ring together with carbon atoms to which they are attached.]

The constitutional unit represented by the formula (X) includes, for example, constitutionals unit represented by the formula (X1-1) to the formula (X1-15).

[Chemical Formula 65]

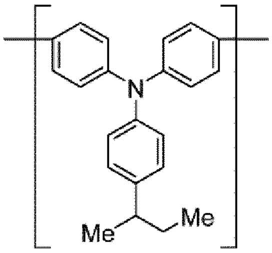

(X1-1)

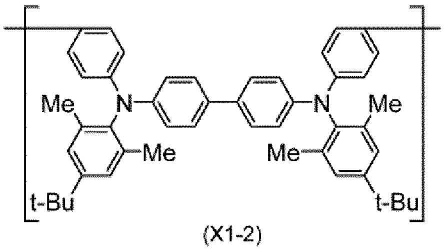

(X1-2)

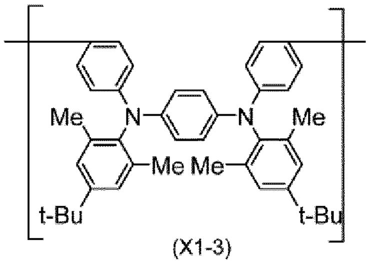

(X1-3)

[Chemical Formula 66]

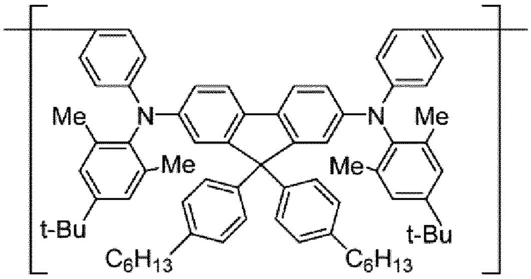

(X1-4)

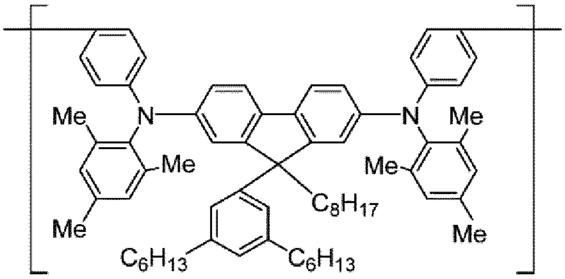

(X1-5)

[Chemical Formula 67]

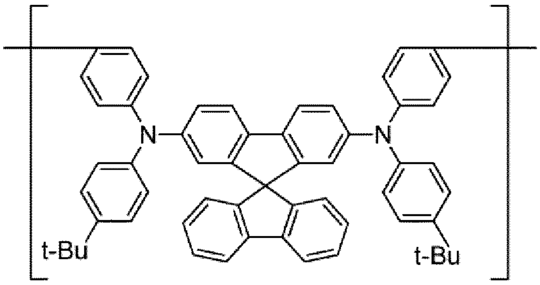

(X1-6)

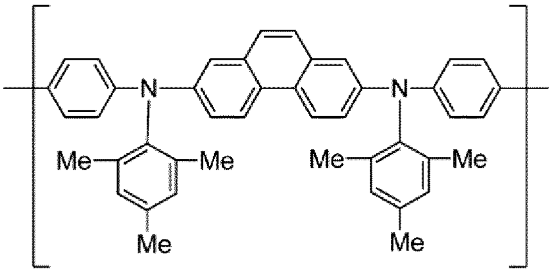

(X1-7)

[Chemical Formula 68]

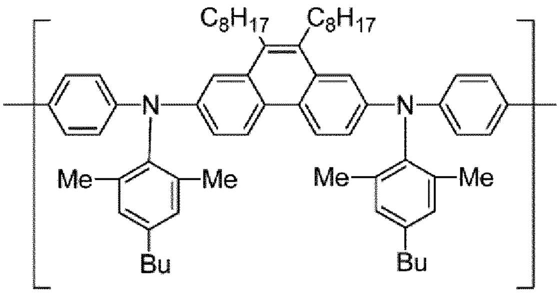

(X1-8)

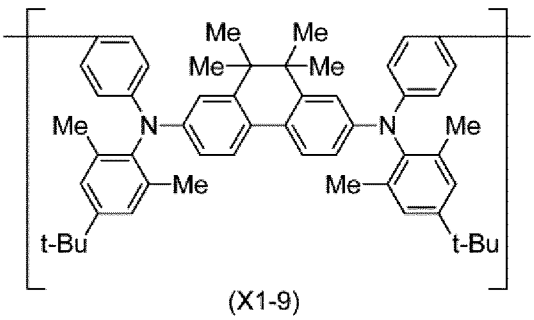

(X1-9)

[Chemical Formula 69]

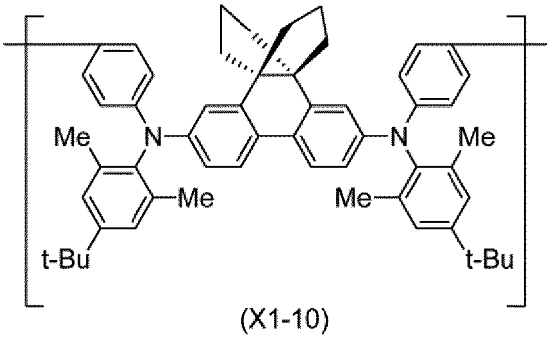

(X1-10)

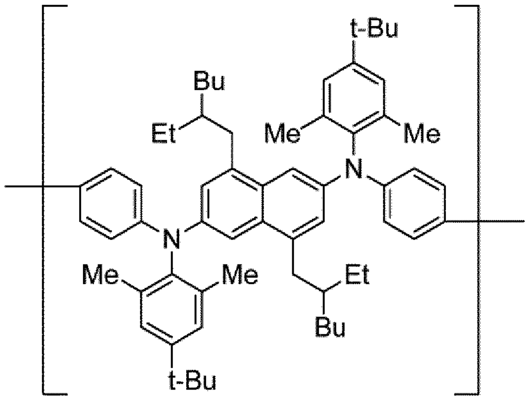

(X1-11)

[Chemical Formula 70]

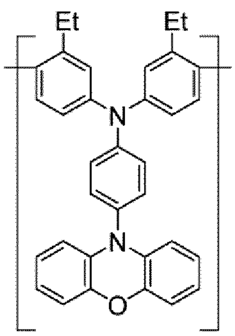

(X1-12)

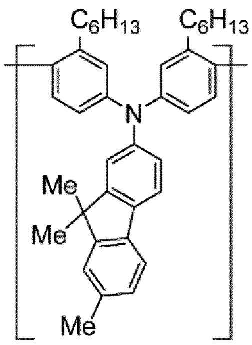

(X1-13)

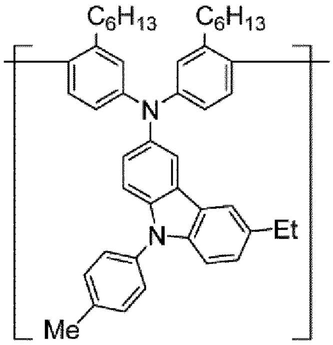

(X1-14)

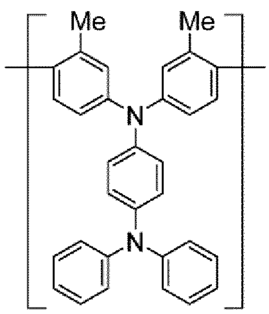

(X1-15)

In the polymer compound having a repeating unit represented by the formula (Y), and a constitutional unit (SM1) composed of a group obtained by removing from a low molecular compound (SM1) one or more hydrogen atoms, the total amount of the constitutional unit (SM1) is preferably 0.01 to 50% by mol, more preferably 0.1 to 30% by mol, further preferably 0.5 to 15% by mol, and particularly preferably 1 to 15% by mol, with respect to the total amount of constitutional units contained in the polymer compound, since the light emitting device of the present embodiment is excellent in light emission efficiency.

The polymer compound may further have a repeating unit represented by the formula (Y-2).

[Chemical Formula 71]

$$-\left[ Ar^{Y2} \right]- \quad \textbf{(Y-2)}$$

[wherein, $Ar^{Y2}$ is a divalent hetero ring group optionally having a substituent.]

The divalent hetero ring group in the formula (Y-2) is preferably a group represented by the formula (AA-1) to the formula (AA-15) and the formula (AA-18) to the formula (AA-34) . The divalent hetero ring group includes groups in which a plurality of these groups are bonded.

The polymer compound includes the following polymer compounds P-1 to P-4. In the description, the "other" constitutional unit means a constitutional unit other than the constitutional unit (SM1), the constitutional unit represented by the formula (X), the constitutional unit represented by the formula (Y) and the constitutional unit represented by the formula (Y-2).

[Table 1]

| Polymer compound | Constitutional unit and molar ratio thereof | | | | |
|---|---|---|---|---|---|
| | Formula (X) | Formula (Y) | Formula (Y-2) | Formula (C) | other |
| | r' | s' | t' | u' | v' |
| P-1 | 0 | 0.1~99.9 | 0 | 0.1~99.9 | 0~30 |
| P-2 | 0.1~99.8 | 0.1~99.8 | 0 | 0.1~99.8 | 0~30 |
| P-3 | 0 | 0.1~99.8 | 0.1~99.8 | 0.1~99.8 | 0~30 |
| P-4 | 0.1~99.7 | 0.1~99.7 | 0.1~99.7 | 0.1~99.7 | 0~30 |

[In Table 1, r', s', t', u' and v' represent the molar ratio (% by mol) of each constitutional unit. r' + s' + t' + u' + v' = 100, and, $70 \leq$ r' + u' + s' $\leq 100$.]

The polymer compound may be any of a block copolymer, a random copolymer, an alternative copolymer or a graft copolymer, and may also be in another form, and is preferably a copolymer obtained by copolymerizing a plurality of raw material monomers.

The polystyrene-equivalent weight-average molecular weight of the polymer compound is preferably $5 \times 10^3$ to $1 \times 10^6$, and more preferably $1.5 \times 10^4$ to $1 \times 10^5$.

[Production method of polymer compound]

Next, the method for producing the polymer compound will be explained.

The polymer compound can be produced, for example, by condensation-polymerizing a compound represented by the formula (M-1), a compound represented by the formula (M-2), and at least one of compounds represented by the formula (MT-1) to the formula (MT-4).

[Chemical Formula 72]

$$Z^{C1}—Ar^{Y1}—Z^{C2} \quad \textbf{(M-1)} \qquad Z^{C3}—Ar^{Y1}—Z^{C4} \quad \textbf{(M-2)}$$

[Chemical Formula 73]

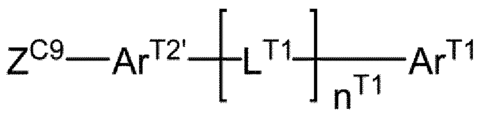

**(MT-1)**

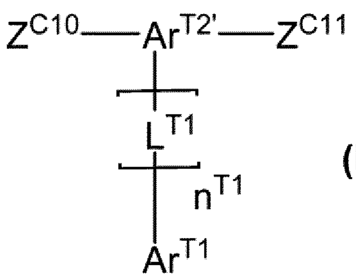

**(MT-2)**

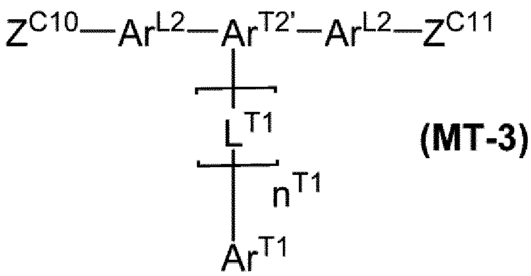

**(MT-3)**

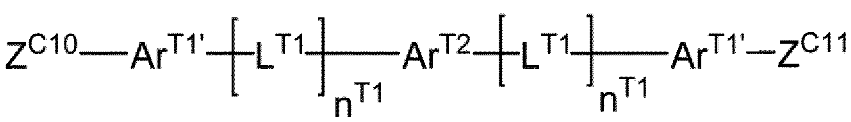

**(MT-4)**

[wherein,

$Ar^Y$, $Ar^{T1}$, $Ar^{T2}$, $Ar^{T1'}$, $Ar^{T2'}$, $Ar^{L2}$, $L^{T1}$ and $n^{T1}$ represent the same meaning as described above.
$Z^{C1}$ to $Z^{C4}$ and $Z^{C9}$ to $Z^{C11}$ each independently represent a group selected from the group consisting of Group A of substituent and Group B of substituent.]

For example, when $Z^{C1}$ and $Z^{C2}$ are groups selected from Group A of substituent, $Z^{C3}$, $Z^{C4}$ and $Z^{C9}$ to $Z^{C11}$ are selected from groups selected from Group B of substituent, respectively.

For example, when $Z^{C1}$ and $Z^{C2}$ are groups selected from Group B of substituent, $Z^{C3}$, $Z^{C4}$ and $Z^{C9}$ to $Z^{C11}$ are selected from groups selected from Group A of substituent, respectively.

<Group A of substituent>

A chlorine atom, a bromine atom, an iodine atom, and groups represented by $-O-S(=O)_2R^{C1}$ (wherein, $R^{C1}$ represents an alkyl group, a cycloalkyl group or an aryl group, and these groups optionally have a substituent.).

<Group B of substituent>

Groups represented by $-B(OR^{C2})_2$ (wherein, $R^{C2}$ represents a hydrogen atom, an alkyl group, a cycloalkyl group or an aryl group, and these groups optionally have a substituent. A plurality of $R^{C2}$ may be the same or different, and may be combined together to form a ring structure together with oxygen atoms to which they are attached.);
Groups represented by $-BF_3Q'$ (wherein, Q' represents Li, Na, K, Rb or Cs);
Groups represented by -MgY' (wherein, Y' represents a chlorine atom, a bromine atom or an iodine atom);
Groups represented by -ZnY" (wherein, Y" represents a chlorine atom, a bromine atom or an iodine atom); and
Groups represented by $-Sn(R^{C3})_3$ (wherein, $R^{C3}$ represents a hydrogen atom, an alkyl group, a cycloalkyl group or an aryl group, and these groups optionally have a substituent. A plurality of $R^{C3}$ may be the same or different, and may be combined together to form a ring structure together with tin atoms to which they are attached.).

As the group represented by $-B(OR^{C2})_2$, groups represented by the following formulae are exemplified.

[Chemical Formula 74]

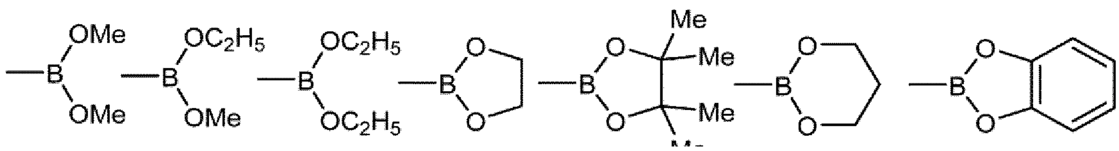

A compound having a group selected from Group A of substituent and a compound having a group selected from Group B of substituent are condensation-polymerized according to a known coupling reaction, and a carbon atom bonding to a group selected from Group A of substituent and a carbon atom bonding to a group selected from Group B of substituent are bonded mutually. Therefore, if a compound having two groups selected from Group A of substituent and a compound having two groups selected from Group B of substituent are subjected to a known coupling reaction, a condensed polymer of these compounds can be obtained by condensation polymerization.

The condensation polymerization is usually conducted in the presence of a catalyst, a base and a solvent, and if necessary, a phase transfer catalyst may be allowed to coexist.

The catalyst includes, for example, transition metal complexes such as palladium complexes such as bis(triphenylphosphine)palladium (II) dichloride, bis(tris-o-methoxyphenylphosphine)palladium (II) dichloride, tetrakis (triphenylphosphine)palladium (0), tris(dibenzylideneacetone)dipalladium (0), palladium acetate, and the like, nickel complexes such as tetrakis (triphenylphosphine)nickel (0), [1,3-bis(diphenylphosphino)propane]nickel (II) dichloride, bis(1,4-cyclooctadiene)nickel (0), and the like; and, these transition metal complexes further having a ligand such as triphenylphosphine, tri(o-tolyl)phosphine, tri(tert-butyl)phosphine, tricyclohexylphosphine, 1,3-bis(diphenylphosphino)propane, bipyridyl, and the like. The catalyst may be used singly or in combination of two or more.

The use amount of the catalyst is usually 0.00001 to 3 mol equivalent in terms of the amount of a transition metal with respect to the sum of the molar numbers of raw material monomers.

The base and the phase transfer catalyst include, for example, inorganic bases such as sodium carbonate, potassium carbonate, cesium carbonate, potassium fluoride, cesium fluoride, tripotassium phosphate, and the like; organic bases such as tetrabutylammonium fluoride, tetraethylammonium hydroxide, tetrabutylammonium hydroxide,

and the like; and phase transfer catalysts such as tetrabutylammonium chloride, tetrabutylammonium bromide, and the like. The base and the phase transfer catalyst may each be used singly or in combination of two or more.

The use amounts of the base and the phase transfer catalyst are each usually 0.001 to 100 mol equivalent with respect to the total molar number of raw material monomers.

The solvent includes, for example, organic solvents such as toluene, xylene, mesitylene, tetrahydrofuran, 1,4-dioxane, dimethoxyethane, N,N-dimethylacetamide, N,N-dimethylformamide and the like; and water. The solvent may be used singly or in combination of two or more.

The use amount of the solvent is usually 10 to 100000 parts by mass with respect to 100 parts by mass of the sum of the raw material monomers.

The reaction temperature of the condensation polymerization is usually -100 to 200°C. The reaction time of the condensation polymerization is usually 1 hour or more.

For the post treatment of the polymerization reaction, known methods, for example, a method in which water-soluble impurities are removed by liquid separation, a method in which a reaction solution after the polymerization reaction is added to a lower alcohol such as methanol and the like, the deposited precipitate is filtrated, then, dried, and other methods, are used each singly or used in combination. When the purity of the polymer compound is low, it can be purified by usual methods such as, for example, crystallization, reprecipitation, continuous extraction with a Soxhlet extractor, column chromatography and the like.

[Low molecular compound (SM2)]

In the low molecular compound (SM2), the difference between the energy level of the lowest excited triplet state and the energy level of the lowest excited singlet state (referred to also as $\Delta E_{ST}$) is 0.50 eV or less. $\Delta E_{ST}$ of the low molecular compound (SM2) is preferably 0.46 eV or less, more preferably 0.40 eV or less, further preferably 0.35 eV or less, particularly preferably 0.30 eV or less, especially preferably 0.25 eV or less, and especially more preferably 0.20 eV or less, since the light emitting device of the present embodiment is more excellent in light emission efficiency. Further, $\Delta E_{ST}$ of SM2 may be 0.001 eV or more, may be 0.005 eV or more, may be 0.01 eV or more, may be 0.05 eV or more.

The low molecular compound (SM2) is preferably a compound having a thermally activated delayed fluorescent (TADF) property.

For $\Delta E_{ST}$ of the low molecular compound (SM2), Gaussian09 as a quantum chemical calculation program can be used. For example, $\Delta E_{ST}$ can be calculated by using a B3LYP-level time-dependent density functional method, after structural optimization of the ground state of the compound using a B3LYP-level density functional method. As the basis function, 6-31G* is usually used, however, when an atom for which 6-31G* cannot be applied is contained in the compound, LANL2DZ can be used for the atom.

The low molecular compound (SM2) is preferably a compound represented by the formula (T-11), or a compound having a group selected from Group G, since the light emitting device of the present embodiment is more excellent in light emission efficiency.

The preferable range and examples of $Ar^{T3}$ in the formula (T-11) are the same as the preferable range and examples of $Ar^{T1}$ in the formula (T-1).

The preferable range and examples of $Ar^{T4}$ in the formula (T-11) are the same as the preferable range and examples of $Ar^{T2}$ in the formula (T-1). Further, Group E is not Group F and Group G, and Group F is not Group G.

The preferable range and examples of $L^{T2}$ in the formula (T-11) are the same as the preferable range and examples of $L^{T1}$ in the formula (T-1).

The preferable range of $n^{T3}$ in the formula (T-11) is the same as the preferable range of $n^{T1}$ in the formula (T-1).

The preferable range of $n^{T4}$ in the formula (T-11) is the same as the preferable range of $n^{T2}$ in the formula (T-1).

The preferable range and examples of the compound represented by the formula (T-11) are the same as the preferable range and examples of the compound represented by the formula (T-1).

The preferable range and examples of the group selected from Group G are the same as the preferable range and examples of the group selected from Group D.

The preferable range and examples of the compound having a group selected from Group G are the same as the preferable range and examples of the compound having a group selected from Group D.

The low molecular compound (SM2) is preferably a compound represented by the formula (D-11), since the light emitting device of the present embodiment is more excellent in light emission efficiency.

The preferable range and examples of Ring E in the formula (D-11) are the same as the preferable range and examples of Ring A in the formula (D-1).

The preferable range and examples of Ring F in the formula (D-11) are the same as the preferable range and examples of Ring B in the formula (D-1).

The preferable range and examples of Ring G in the formula (D-11) are the same as the preferable range and examples of Ring C in the formula (D-1).

The preferable range of $X^2$ in the formula (D-11) is the same as the preferable range of X in the formula (D-1).
The preferable range of $Y^4$ in the formula (D-11) is the same as the preferable range of $Y^1$ in the formula (D-1). The preferable range of $Y^3$ in the formula (D-11) is the same as the preferable range of $Y^2$ in the formula (D-1).
The preferable range of $Y^6$ in the formula (D-11) is the same as the preferable range of $Y^3$ in the formula (D-1).
In the formula (D-11), n6 is preferably 0.
The preferable range and examples of the compound represented by the formula (D-11) are the same as the preferable range and examples of the compound represented by the formula (D-1).

[Composition]

The composition of the present embodiment contains a polymer compound, and in the composition, two or more structures (SM0) obtained by removing one or more hydrogen atoms from a low molecular compound in which the absolute value of a difference between the energy level of the lowest triplet excited state and the energy level of the lowest singlet excited state is 0.50 eV or less are present. That is, in the composition of the present embodiment, structures (SM0) may be present as the constitutional unit (SM1) in the polymer compound and as the low molecular compound (SM2) (hereinafter, such a composition is referred to as first embodiment of composition). Further, in the composition of the present embodiment, structures (SM0) may be present as the constitutional unit (SM1-1) in the first polymer compound and as the constitutional unit (SM1-2) in the second polymer compound (hereinafter, such a composition is referred to as second embodiment of composition).
According to the composition of the present embodiment, excellent light emission efficiency of the light emitting device is realized by physical, chemical or electrical interaction of two structures (SM0). The present inventors have investigated a design so that two structures (SM0) are physically, chemically or electrically interacted efficiently (particularly, design to electrically interact efficiently). It is considered that for obtaining electrical interaction more efficiently, the intermolecular distance between one of two structures (SM0) and the other is important, hence, it is focused on the content numbers per unit mass of two structures (SM0), and the ratio thereof. More specifically, it is estimated that if the content numbers per unit mass and the ratio thereof are designed so as to give a correlation shown later, electrical energy moves quickly to either one of two structures (SM0), as a result, the light emitting device is more excellent in light emitting properties (particularly, light emission efficiency).
The constitutional unit (SM1-1) is a constitutional unit obtained by removing from a low molecular compound (SM1-1) one or more hydrogen atoms, and the preferable range and examples of the low molecular compound (SM1-1) are the same as the preferable range and examples of the low molecular compound (SM1). Further, constitutional unit (SM1-2) is a constitutional unit obtained by removing from a low molecular compound (SM1-2) one or more hydrogen atoms, and the preferable range and examples of the low molecular compound (SM1-2) are the same as the preferable range and examples of the low molecular compound (SM1). Note that the low molecular compound (SM1-1) and the low molecular compound (SM1-2) are different.
In the first embodiment of composition, when the content number per unit mass of the constitutional unit (SM1) in the composition is expressed as dSM1 (number/g) and the content number per unit mass of the low molecular compound (SM2) in the composition is expressed as dSM2 (number/g), then, the total value (dSM1 + dSM2) of dSM1 and dSM2 is $2.0 \times 10^{19}$ (number/g) or more, and may be $3.0 \times 10^{19}$ (number/g) or more, may be $5.0 \times 10^{19}$ (number/g) or more, and may be $7.0 \times 10^{19}$ (number/g) or more. Further, dSM1 + dSM2 is usually $4.0 \times 10^{20}$ (number/g) or less, and may be $3.0 \times 10^{20}$ (number/g) or less, and may be $2.5 \times 10^{20}$ (number/g) or less.
Further, it is preferable that the ratio of dSM1 (number/g) and dSM2 (number/g) is in a specific range. By this, the constitutional unit (SM1) and the low molecular compound (SM2) more easily physically, chemically or electrically interact more efficiently, and the light emission efficiency of the light emitting device using the composition of the present embodiment is more excellent. From the above-described standpoint, dSM1/dSM2 is 0.020 or more, and may be 0.033 or more may be, may be 0.050 or more, may be 0.077 or more, and may be 0.083 or more. Further, from the above-described standpoint, dSM1/dSM2 is 50 or less, and may be 30 or less, may be 20 or less, may be 13 or less, and may be 12 or less.
Further, it is preferable that the ratio of the constitutional unit (SM1) and the low molecular compound (SM2) is such that at least one is higher than the other. When the constitutional unit (SM1) is more present in the composition than the low molecular compound (SM2), dSM1/dSM2 is, for example, 1.1 to 50, and may be preferably 1.2 to 20, more preferably 1.3 to 13, and further preferably 1.7 to 12.7. Further, when the low molecular compound (SM2) is more present in the composition than the constitutional unit (SM1), dSM1/dSM2 is, for example, 0.020 to 0.91, and may be preferably 0.050 to 0.83, more preferably 0.077 to 0.77, and further preferably 0.079 to 0.59. By attaining such a correlation, the constitutional unit (SM1) and the low molecular compound (SM2) easily interact physically, chemically or electrically more efficiently, and the light emission efficiency of the light emitting device using the composition of the present embodiment is more excellent.
In the second embodiment of composition, when the content number per unit mass of the constitutional unit

(SM1-1) in the composition is expressed as dSM1a (number/g) and the content number per unit mass of the constitutional unit (SM1-2) in the composition is expressed as dSM1b (number/g), then, the total number (dSM1a + dSM1b) of dSM1 and dSM1b is $2.0 \times 10^{19}$ (number/g) or more, and may be $3.0 \times 10^{19}$ (number/g) or more, may be $5.0 \times 10^{19}$ (number/g) or more, and may be $7.0 \times 10^{19}$ (number/g) or more. Further, dSM1a + dSM1b is usually $4.0 \times 10^{20}$ (number/g) or less, and may be $3.0 \times 10^{20}$ (number/g) or less, and may be $2.5 \times 10^{20}$ (number/g) or less.

Further, it is preferable that the ratio of dSM1a (number/g) and dSM1b (number/g) is in a specific range. By this, the constitutional unit (SM1-1) and the constitutional unit (SM1-2) more easily physically, chemically or electrically interact more efficiently, and the light emission efficiency of the light emitting device using the composition of the present embodiment is more excellent. From the above-described standpoint, dSM1a/dSM1b is 0.020 or more, and may be 0.033 or more, may be 0.050 or more, may be 0.077 or more, and may be 0.083 or more. Further, from the above-described standpoint, dSM1a/dSM1b is 50 or less, and may be 30 or less, may be 20 or less, may be 13 or less, and may be 12 or less.

Further, it is preferable that the ratio of the constitutional unit (SM1-1) and the constitutional unit (SM1-2) is such that at least one is higher than the other. When the constitutional unit (SM1-1) is more present in the composition than the constitutional unit (SM1-2), dSM1a/dSM1b is, for example, 1.1 to 50, and may be preferably 1.2 to 20, more preferably 1.3 to 13, and further preferably 1.7 to 12.7. Further, when the constitutional unit (SM1-2) is more present in the composition than the constitutional unit (SM1-1), dSM1/dSM1 is, for example, 0.020 to 0.91, and may be preferably 0.050 to 0.83, more preferably 0.077 to 0.77, and further preferably 0.079 to 0.59. By attaining such a correlation, the constitutional unit (SM1-1) and the constitutional unit (SM1-2) easily interact physically, chemically or electrically more efficiently, and the light emission efficiency of the light emitting device using the composition of the present embodiment is more excellent.

The composition of the present embodiment may further contain other materials than the above-described materials. For example, the composition of the present embodiment may further contain at least one material selected from the group consisting of a hole transporting material, a hole injection material, an electron transporting material, an electron injection material, a light emitting material and an antioxidant.

[Hole transporting material]

The hole transporting material is classified into a low molecular compound and a polymer compound.

The polymer compound includes, for example, polyvinylcarbazole and derivatives thereof; and polyarylenes having an aromatic amine structure in the side chain or main chain and derivatives thereof, and polymer compounds containing a constitutional unit represented by the formula (X). The polymer compound may also be a compound to which an electron accepting site is bonded. The electron accepting site includes, for example, fullerene, tetrafluorotetracyanoquinodimethane, tetracyanoethylene, trinitrofluorenone, and the like, and fullerene being preferred.

In the first embodiment of composition, the blending amount of the hole transporting material is usually 1 to 400 parts by mass, and preferably 5 to 150 parts by mass, when the amount of the polymer compound in the present embodiment is taken as 100 parts by mass.

Further, in the second embodiment of the composition, the blending amount of the hole transporting material is usually 1 to 400 parts by mass, and preferably 5 to 150 parts by mass, when the total amount of the polymer compound in the present embodiment is taken as 100 parts by mass.

The hole transporting material may be used singly or in combination of two or more.

[Electron transporting material]

The electron transporting material is classified into low molecular compounds and polymer compounds.

The low molecular compound includes, for example, a metal complex having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polymer compounds containing at least one polymer compound selected from the group consisting of a constitutional unit represented by the formula (Y) and a constitutional unit represented by the formula (Y-2), and examples thereof include polyphenylene, polyfluorene, and derivatives thereof. The polymer compound may be doped with a metal.

The blending amount of the electron transporting material is usually 1 to 400 parts by mass, preferably 5 to 150 parts by mass, when the amount of the polymer compound (TP) is taken as 100 parts by mass.

The electron transporting material may be used singly or in combination of two or more.

[Hole injection material and electron injection material]

The hole injection material and the electron injection material are each classified into low molecular compounds and polymer compounds.

The low molecular compound includes, for example, metal phthalocyanines such as copper phthalocyanine and the like; carbon; oxides of metals such as molybdenum, tungsten and the like; metal fluorides such as lithium fluoride, sodium fluoride, cesium fluoride, potassium fluoride and the like.

The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer containing an aromatic amine structure in the main chain or side chain, and the like.

The blending amounts of the hole injection material and the electron injection material are each usually 1 to 400 parts by mass, preferably 5 to 150 parts by mass, when the amount of the polymer compound is taken as 100 parts by mass.

The electron injection material and the hole injection material may each be used singly or in combination of two or more.

When the hole injection material or the electron injection material contains an electrically conductive polymer, the electric conductivity of the electrically conductive polymer is preferably $1\times10^{-5}$ S/cm to $1\times10^{3}$ S/cm. For adjusting the electric conductivity of the electrically conductive polymer within such a range, the electrically conductive polymer can be doped with an appropriate amount of ions.

The kind of the ion to be doped is an anion for the hole injection material and a cation for the electron injection material. The anion includes, for example, a polystyrenesulfonic ion, an alkylbenzenesulfonic ion and a camphor sulfonic ion. The cation includes, for example, a lithium ion, a sodium ion, a potassium ion and a tetrabutylammonium ion.

The ion to be doped may be used singly or in combination of two or more kinds thereof.

[Light emitting material]

The light emitting material is classified into a low molecular compound and a polymer compound, and the light emitting material is preferably a low molecular compound, since the light emitting device of the present embodiment is more excellent in light emission efficiency.

The low molecular compound includes, for example, fluorescent compounds typified by as naphthalene and derivatives thereof, anthracene and derivatives thereof, and perylene and derivatives thereof, and phosphorescent compounds containing iridium, platinum or europium as the central metal.

The polymer compound includes, for example, polymer compounds containing a phenylene group, a naphthalenediyl group, a fluorenediyl group, a phenanthrenediyl group, a dihydrophenanthrenediyl group, a carbazolediyl group, a phenoxazinediyl group, a phenothiazinediyl group, an anthracenediyl group, a pyrenediyl group, and the like.

[Antioxidant]

The antioxidant may advantageously be a compound that is soluble in the same solvent as that for the polymer compound and does not inhibit light emission and charge transportation, and includes, for example, phenol type antioxidants and phosphorus-based antioxidants.

In the first embodiment of the composition, the blending amount of the antioxidant is usually 0.001 to 10 parts by mass, when the amount of the polymer compound is taken as 100 parts by mass.

The antioxidant may be used singly or in combination of two or more.

[Composition containing solvent]

The composition of the present embodiment can be mixed with a solvent to produce a composition containing the solvent (hereinafter, referred to also as "first ink"), and the composition can be suitably used in wet film formation methods such as a spin coat method, an inkjet method, and the like.

The viscosity of the first ink may advantageously be adjusted depending on the type of the wet method, and is preferably 1 to 20 mPa●s at 25°C, when applied to printing methods in which a solution passes through a discharge device such as an inkjet printing method, and the like, since clogging and flight curving in discharging less likely to occur.

The solvent contained in the first ink is a solvent capable of dissolving or uniformly dispersing solid components in the ink. The solvent includes, for example, chlorine-based solvents such as 1,2-dichloroethane, 1,1,2-trichloroethane, chlorobenzene, o-dichlorobenzene, and the like; ether type solvents such as tetrahydrofuran, dioxane, anisole, 4-methylanisole, and the like; aromatic hydrocarbon type solvents such as toluene, xylene, mesitylene, ethylbenzene, n-hexylbenzene, cyclohexylbenzene, and the like; aliphatic hydrocarbon type solvents such as cyclohexane, methylcyclohexane, n-pentane, n-hexane, n-heptane, n-octane, n-nonane, n-decane, n-dodecane, bicyclohexyl, and the like; ketone type solvents such as acetone, methyl ethyl ketone, cyclohexanone, acetophenone, and the like; ester type solvents such as ethyl acetate, butyl acetate, ethyl cellosolve acetate, methyl benzoate, phenyl acetate, and the like; polyhydric alcohol type solvents such as ethylene glycol, glycerin, 1,2-hexanediol, and the like; alcohol type solvents such as isopropyl alcohol, cyclohexanol, and the like; sulfoxide type solvents such as dimethyl sulfoxide, and the like; and amide type solvents such as N-methyl-2-pyrrolidone, N,N-dimethylformamide, and the like. The solvent may be used singly or in combination of two or more.

In the first ink, the blending amount of the solvent is usually 1000 to 100000 parts by mass, when the amount of the composition of the present embodiment is taken as 100 parts by mass.

<Light emitting device >

The composition of the present embodiment can be utilized, for example, for a light emitting device having an anode, a cathode, and an organic layer disposed between the anode and the cathode.

[Layer constitution]

The layer containing the composition of the present embodiment is usually at least one layer such as a light emitting layer, a hole transporting layer, a hole injection layer, an electron transporting layer, or an electron injection layer, with the light emitting layer being preferred. These layers contain a light emitting material, a hole transporting material, a hole injection material, an electron transporting material, or an electron injection material, respectively. Each of the layers can be formed, for example, by dissolving a light emitting material, a hole transporting material, a hole injection material, an electron transporting material, or an electron injection material in the solvent described above to prepare an ink, then, by applying, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, a inkjet printing method, a capillary coat method, or a nozzle coat method, using the ink.

(D1) anode/hole injection layer/hole transporting layer/light emitting layer/cathode
(D2) anode/hole injection layer/hole transporting layer/light emitting layer/electron injection layer/cathode
(D3) anode/hole injection layer/hole transporting layer/light emitting layer/electron transporting layer/electron injection layer/cathode

In the above-described (D1) to (D3), "/" means that layers before and after it are adjacently laminated. (D1) to (D2) are preferable, since the light emitting device of the present embodiment is more excellent in light emission efficiency.

The method for forming each layer such as a light emitting layer, a hole transporting layer, an electron transporting layer, a hole injection layer, an electron injection layer and the like in the light emitting device includes, for example, a method of vacuum vapor deposition from power, and a method by film formation from solution or melted state when a low molecular compound is used, and for example, a method by film formation from solution or melted state when a polymer compound is used.

The order, number and thickness of layers to be laminated may be adjusted in consideration of light emission efficiency and device life.

[Substrate/electrode]

The substrate in the light emitting device may advantageously be a substrate on which an electrode can be formed and which does not change chemically in forming an organic layer, and for example, is a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, and includes preferably indium oxide, zinc oxide, tin oxide; electrically conductive compounds such as indium●tin●oxide (ITO), indium●zinc●oxide, and the like; argentine-palladium-copper (APC) composite; NESA, gold, platinum, silver, and copper.

The material of the cathode includes, for example, metals such as lithium, sodium, potassium, rubidium, cesium, beryllium, magnesium, calcium, strontium, barium, aluminum, zinc, indium, and the like; alloys composed of two or more of them; alloys composed of one or more of them and one or more of silver, copper, manganese, titanium, cobalt, nickel, tungsten, and tin; and, graphite and graphite intercalation compounds. The alloy includes, for example, a magnesium-silver alloy, a magnesium-indium alloy, a magnesium-aluminum alloy, an indium-silver alloy, a lithium-aluminum alloy,

a lithium-magnesium alloy, a lithium-indium alloy, a calcium-aluminum alloy, and the like.

The anode and the cathode each may take a laminated structure composed of two or more layers.

[Application]

The light emitting device of the present embodiment is useful, for example, for display and illumination.

[EXAMPLES]

The present invention will be explained further in detail by examples below, but the present invention is not limited to these examples.

In examples, the polystyrene-equivalent number-average molecular weight (Mn) and polystyrene-equivalent weight-average molecular weight (Mw) of polymer compounds were determined by size exclusion chromatography (SEC) described below, using tetrahydrofuran as the mobile phase.

A polymer compound to be measured was dissolved in tetrahydrofuran at a concentration of about 0.05% by mass, and 10 μL of the solution was injected into SEC. The mobile phase was flowed at a flow rate of 1.0 mL/min. As the column, PLgel MIXED-B (manufactured by Polymer Laboratories Inc.) was used. As the detector, UV-VIS detector (trade name: UV-8320GPC, manufactured by Tosoh Corporation) was used.

<Synthesis Examples> Acquisition method of compounds M1 to M17, and compounds M101 to M104

A compound M1 was synthesized according to a method described in International Publication WO 2002/045184.

A compound M2 was synthesized according to a method described in Japanese Translation of PCT International Application Publication (JP-T) No. 2002-539292.

A compound M3 was synthesized according to a method described in International Publication WO 2011/049241.

A compound M4 was synthesized according to a method described in International Publication WO 2015/014871.

A compound M5 was synthesized according to a method described in International Publication WO 2013/146806.

A compound M6 was synthesized according to a method described in JP-T No. 2007-512249.

As compounds M7 and M11, commercially available products were used.

A compound M8 was synthesized according to a method described in International Publication WO 2019/004247. As the compound M8, a mixture of compounds M8a, M8b, M8c, and M8d was used.

A compound M9 was synthesized according to a method described in International Publication WO 2012/086671.

A compound M10 and M14 were synthesized according to a method described in JP-A No. 2010-189630.

A compound M12 was synthesized according to a method described in International Publication WO 2013/191086.

Compounds M13 and M16 were synthesized according to a method described in International Publication WO 2013/191088.

A compound M15 was synthesized according to a method described in International Publication WO 2019/004247.

A compound M17 was synthesized according to a method described in JP-A No. 2010-196040.

A compound M101 was synthesized according to a method described in International Publication WO 2010/136109.

As a compound M102, one manufactured by Amadis Chemical was used.

Compounds M103 and M104 were synthesized according to a method described in International Publication WO 2015/102118.

[Chemical Formula 75]

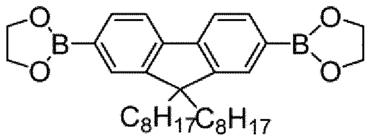

compound M1

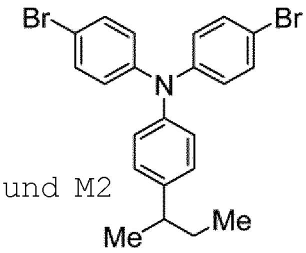

compound M2

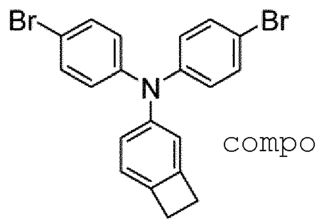

compound M3

[Chemical Formula 76]

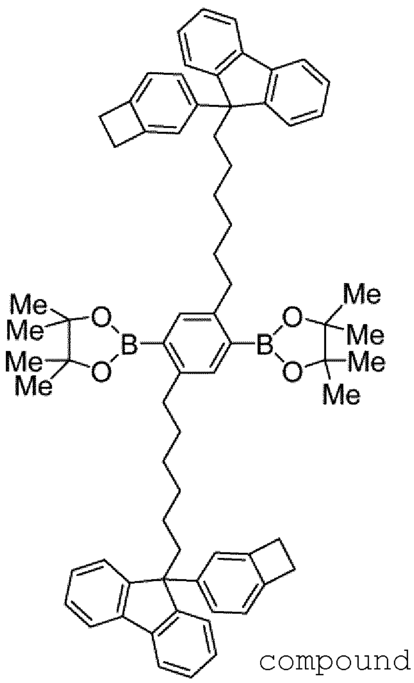

compound M4

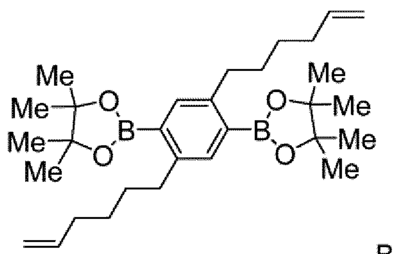

compound M5

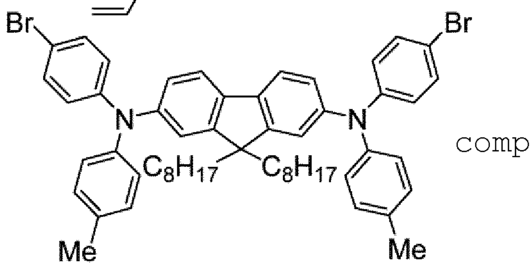

compound M6

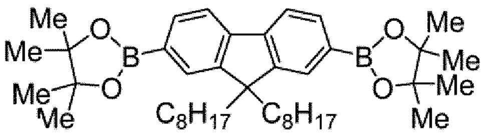

compound M7

[Chemical Formula 77]

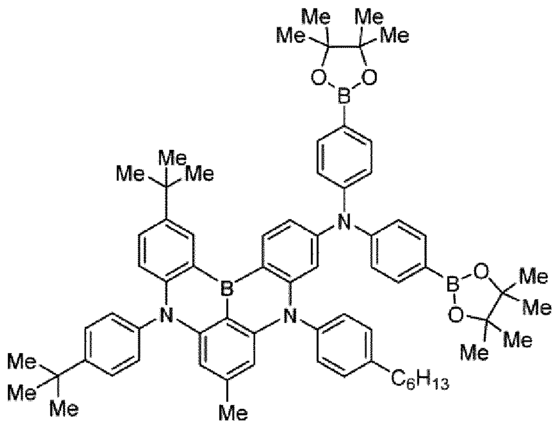

compound M8a

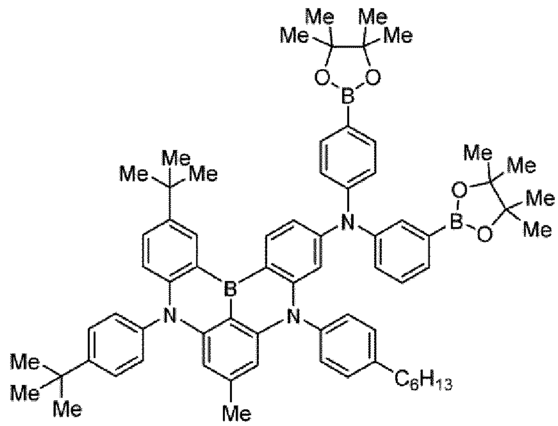

compound M8b

[Chemical Formula 78]

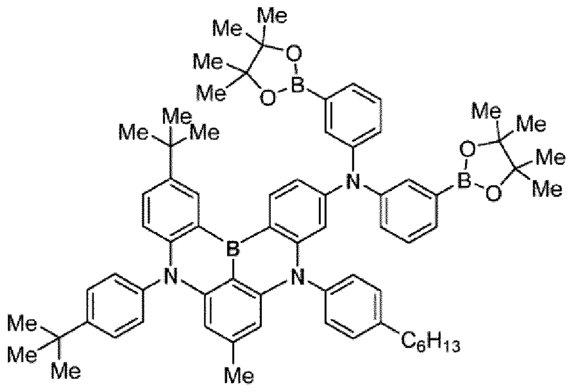

compound M8c

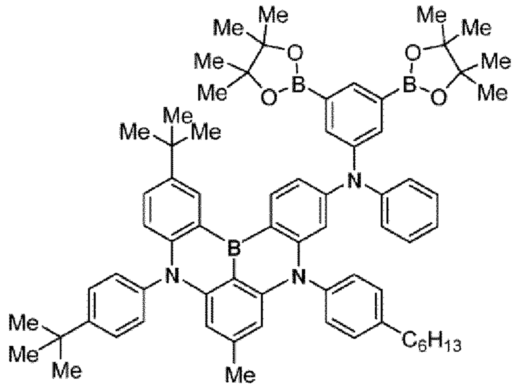

compound M8d

[Chemical Formula 79]

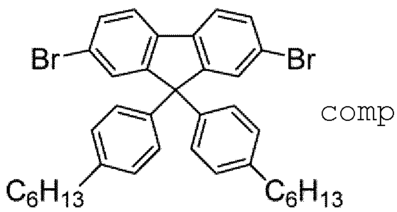

compound M9

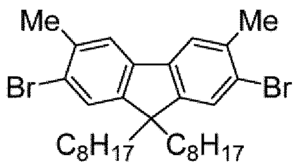

compound M12

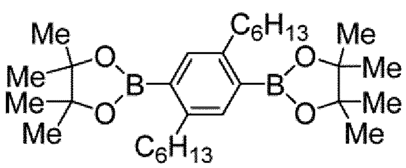

compound M10

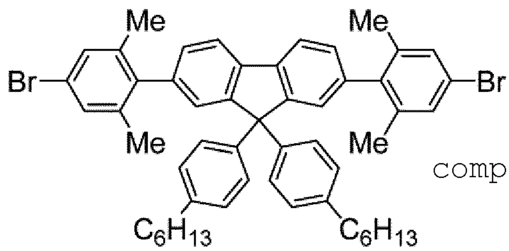

compound M13

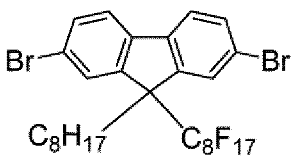

compound M11

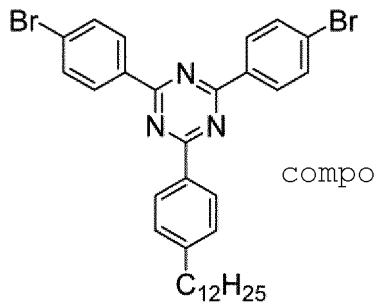

compound M14

[Chemical Formula 80]

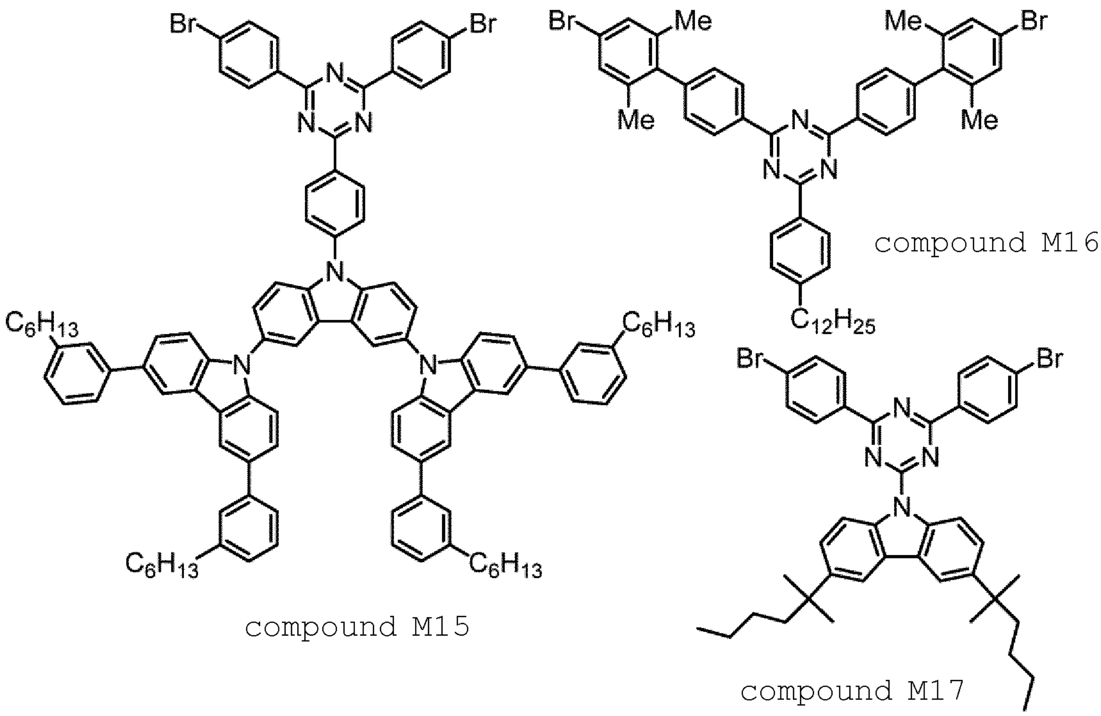

compound M15

compound M16

compound M17

[Chemical Formula 81]

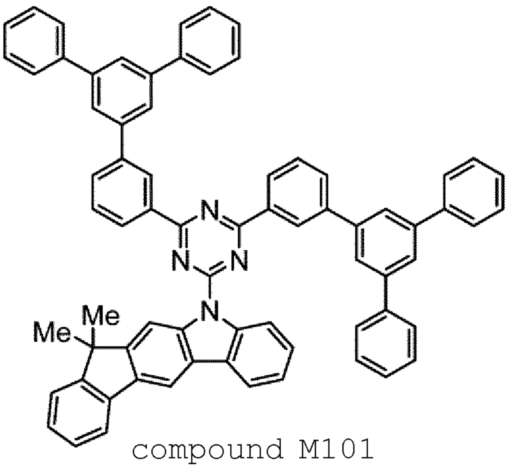

compound M101

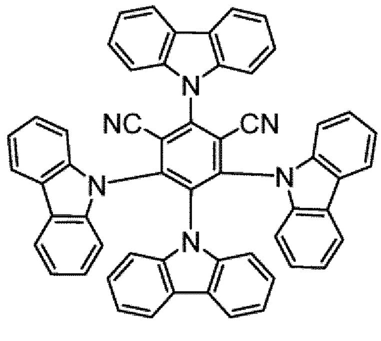

compound M102

[Chemical Formula 82]

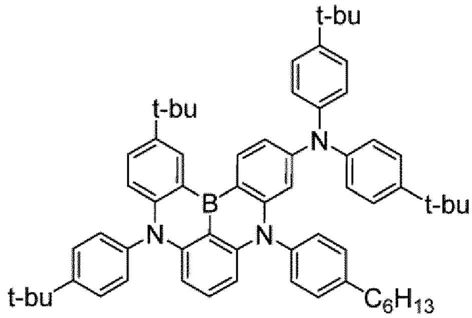

compound M103

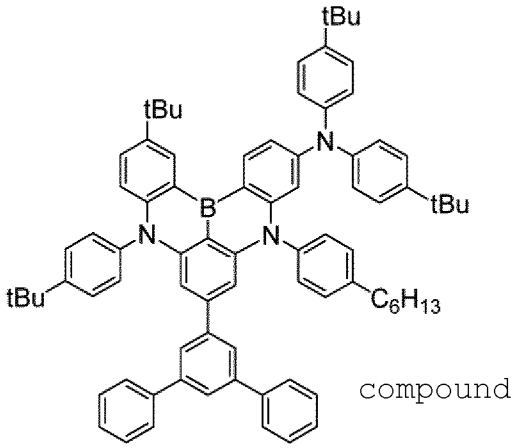

compound M104

The values of $\Delta E_{st}$ of the compound M101, the compound M102, the compound M103, and the compound M104 were 0.13 eV, 0.12 eV, 0.46 eV, and 0.46 eV, respectively.

<Synthesis Example 1> Synthesis of compound M105

[Chemical Formula 83]

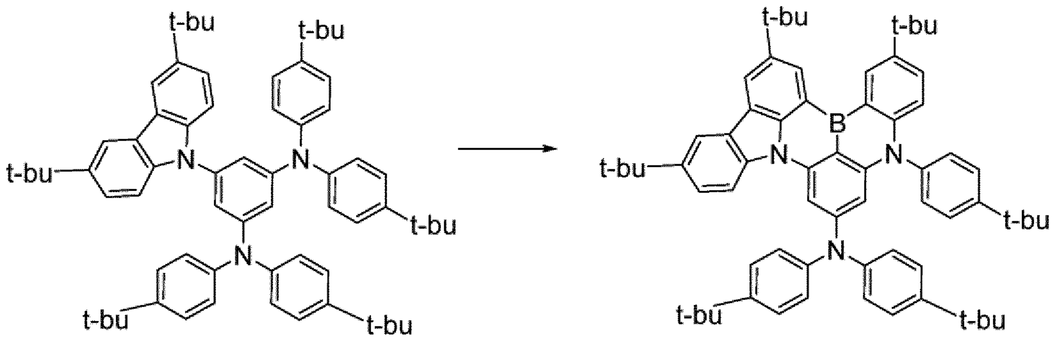

compound A105 compound M105

A nitrogen gas atmosphere was made in a reaction vessel, then, a compound A105 (22.5 g) synthesized by a method described in Angew. Chem. Int. Ed. 2018, 57, 11316-11320 and chlorobenzene were added and stirred, to this was added boron triiodide (16.4 g), and the mixture was stirred with heating at 90°C for 6 hours. Thereafter, the mixture was cooled down to room temperature (25°C), N,N-diisopropylethylamine (14.3 mL) was dropped, and the mixture was stirred continuously at room temperature for 15 minutes. To the resultant solution was added a 10% by mass sodium sulfite aqueous solution (70 mL). The above operation was repeated twice, the resultant organic layers were combined, and washed with a 10% by mass sodium sulfite aqueous solution and ion exchanged water. The resultant washed solution was liquid-separated, the resultant organic layer was dried over magnesium sulfate, then, filtrated through a filter paved with 45 g of Florisil. The resultant filtrate was concentrated, then, to this was added acetonitrile (340 mL), the mixture was stirred for 1 hour, and the resultant solid was filtrated. The resultant solid was dissolved in toluene (790 mL). To the resultant solution was added carboraffine (33 g) and the mixture weas stirred for 1 hour, then, an operation of filtrating through a filter paved with Celite was repeated three times. The resultant solution was concentrated under reduced pressure, and the resultant solid was recrystallized several times using a mixed solvent of toluene and acetonitrile, and a mixed solvent of toluene and ethanol, and dried at 50°C under reduced pressure, to obtain a compound M105 (30.9 g, yellow solid). The compound M105 had an HPLC area percentage value of 99.5% or more.

LC-MS (APCI, positive): "M+H"+ 922.

$^1$H-NMR ($CDCl_3$, 400MHz) δ (ppm): 9.05 (d,1H), 9.00 (d,1H), 8.32 (d,1H), 8.15 (d,1H), 7.52 (td,2H), 7.43 (d,1H)7.38 (d,1H), 7.32-7.22 (m,6H), 7.20 (td,2H)7.13 (td,4H), 6.65 (d,1H), 6.16 (d,1H), 1.62 (s,9H), 1.48 (s,9H), 1.43

(s,9H), 1.36 (s,18H), 1.34 (s,9H).

$\Delta E_{st}$ of the compound M105 was 0.43 eV.

<Synthesis Example 2> Synthesis of polymer compound PC1

A polymer compound PC1 was synthesized using the compound M1, the compound M2 and the compound M3 with reference to a method described in International Publication WO 2011/049241. The polymer compound PC1 had an Mn of $8.9 \times 10^4$, and an Mw of $4.2 \times 10^5$.

The polymer compound PC1 is a copolymer constituted of a constitutional unit derived from the compound M1, a constitutional unit derived from the compound M2, and a constitutional unit derived from the compound M3 at a molar ratio of 50:42.5:7.5, according to the theoretical value determined from the amounts of the charged raw materials.

<Synthesis Example 3> Synthesis of polymer compound PC2 to polymer compound PC8

A polymer compound PC2 to a polymer compound PC8 were synthesized by the same procedure as for the polymer compound PC1, except that "compound M1, compound M2 and compound M3" in the polymer compound PC1 were changed to monomers and mol fraction described in the following table. Table 2 shows Mn, Mw, mol fraction and synthesis method of the resultant polymer compound.

[Table 2]

| Polymer compound | Molar ratio | | | Synthesis method | Mn | Mw |
|---|---|---|---|---|---|---|
| PC1 | M1 (50) | M2 (42.5) | M3 (7.5) | Method described in WO 2011-049241 | $89\times10^3$ | $420\times10^3$ |
| PC2 | M4 (45) | M5 (5) | M6 (50) | Method described in WO 2015-145871 | $23\times10^3$ | $120\times10^3$ |
| PC3 | M7 (45) | M8 (5) | M9 (50) | Method described in WO 2019-004248 | $45\times10^3$ | $111\times10^3$ |
| PC4 | M10 (50) | M11 (40) | M15 (10) | Method described in WO 2019-04247 | $59\times10^3$ | $121\times10^3$ |
| PC5 | M10 (50) | M12 (40) | M15 (10) | Method described in WO 2019-04247 | $53\times10^3$ | $112\times10^3$ |
| PC6 | M10 (50) | M13 (26) | M16 (24) | Method described in WO 2015-008851 | $85\times10^3$ | $220\times10^3$ |
| PC7 | M10 (50) | M9 (40) | M14 (10) | Method described in JP-A No. 2012-036388 | $96\times10^3$ | $220\times10^3$ |
| PC8 | M10 (50) | M11 (40) | M17 (10) | Method described in WO 2019-004247 | $121\times10^3$ | $400\times10^3$ |

$\Delta E_{st}$ of H body of M8 in the polymer compound PC3 was 0.44 eV. $\Delta E_{st}$ of H body of M15 of the polymer compound PC4, and the polymer compound PC5 was 0.06 eV. $\Delta E_{st}$ of H body of M17 of the polymer compound PC8 was 0.16 eV. Note that the polymer compound PC6 and the polymer compound PC7 did not has a constitutional unit obtained by removing one or more hydrogen atoms from a compound having $\Delta E_{st}$ of 0.50 eV or less.

[Chemical Formula 84]

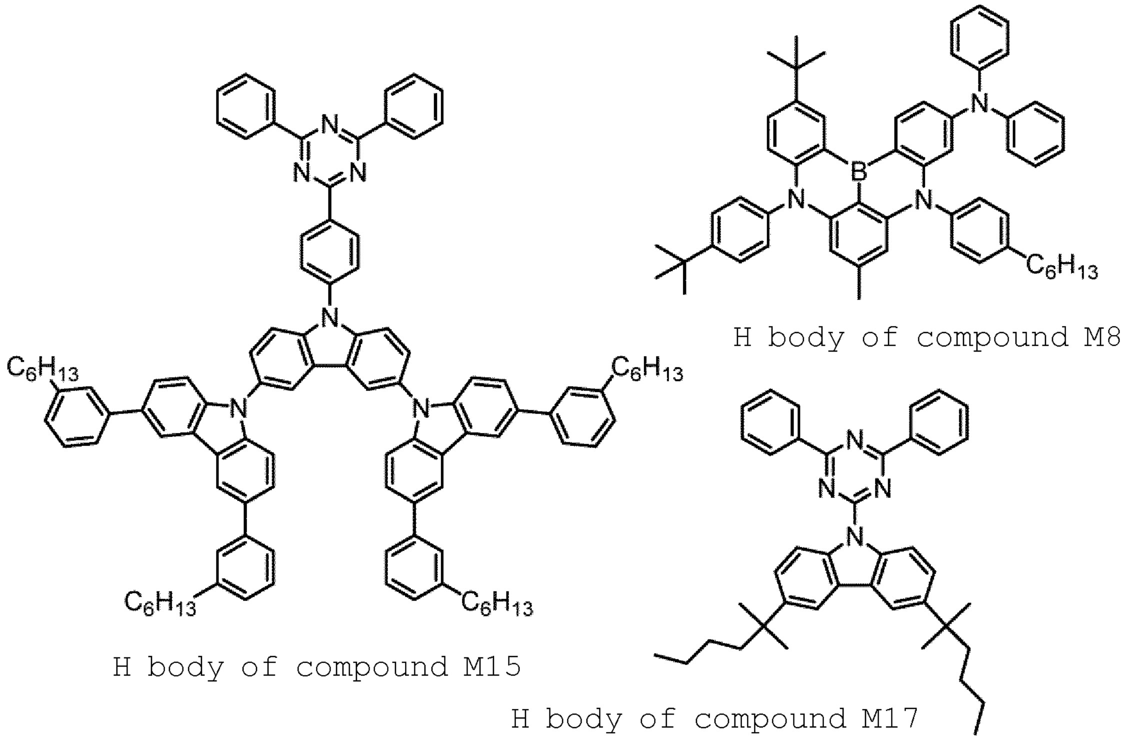

H body of compound M8

H body of compound M15

H body of compound M17

For the polymer compound PC3, the content number (number/g) per unit mass of the constitutional unit (SM1) obtained by removing one or more hydrogen atoms from the low molecular compound (SM1) in the polymer compound PC3 is calculated as shown below using Avogadro number ($N_A$).

The molecular weight of a repeating unit obtained from the compound M7: 388.64,

the molecular weight of a repeating unit obtained from the compound M8: 795.92,
the molecular weight of a repeating unit obtained from the compound M9: 484.73,
as a result:

$$0.05 \times N_A/(388.64 \times 0.45 + 795.92 \times 0.05 + 484.73 \times 0.5)$$

$$= 6.56 \times 10^{19} \text{ (number/g)}$$

For the polymer compound PC4, the content number (number/g) per unit mass of the constitutional unit (SM1) obtained by removing one or more hydrogen atoms from the low molecular compound (SM1) in the polymer compound PC4 is calculated in the same manner.

The molecular weight of a repeating unit obtained from the compound M10: 244.42,

the molecular weight of a repeating unit obtained from the compound M11: 388.64,
the molecular weight of a repeating unit obtained from the compound M15: 1443.98,
as a result:

$$0.1 \times N_A/(244.42 \times 0.5 + 388.64 \times 0.4 + 1443.98 \times 0.1)$$

$$= 1.42 \times 10^{20} \text{ (number/g)}$$

For the polymer compound PC5, the content number (number/g) per unit mass of the constitutional unit (constitutional unit SM1) obtained by removing one or more hydrogen atoms from the low molecular compound (SM1) in the polymer compound PC5 is calculated in the same manner.

The molecular weight of a repeating unit obtained from the compound M12: 416.69,
as a result:

$$0.1 \times N_A/(244.42 \times 0.5 + 416.69 \times 0.4 + 1443.98 \times 0.1) = 1.38 \times 10^{20} \text{ (number/g)}$$

For the polymer compound PC8, the content number (number/g) per unit mass of the constitutional unit (constitutional unit SM1) obtained by removing one or more hydrogen atoms from the low molecular compound (SM1) in the polymer compound PC8 is calculated in the same manner.

The molecular weight of a repeating unit obtained from the compound M17: 606.86, as a result:

$$0.1 \times N_A/(244.42 \times 0.5 + 388.64 \times 0.4 + 606.86 \times 0.1) = 1.77 \times 10^{20} \text{ (number/g)}$$

<Example D1> Fabrication of light emitting device D1

<ITO substrate and hole injection layer>

On a glass substrate, an ITO film was formed with a thickness of 45 nm by a sputtering method, to form an anode. A hole injection material ND-3202 (manufactured by Nissan Chemical Corporation) was spin-coated on the anode, to form a film with a thickness of 50 nm, and the film was heated on a hot plate at 240°C for 15 minutes under an air atmosphere. By this, a hole injection layer was formed.

<Hole transporting layer>

The polymer compound PC1 was dissolved in xylene at a concentration of 0.6% by mass. The resultant xylene solution was spin-coated on the hole injection layer, to form a film with a thickness of 20 nm, and the film was heated on a hot plate at 200°C for 30 minutes under a nitrogen gas atmosphere. By this, a hole transporting layer was formed.

<Light emitting layer>

The polymer compound PC3 and the compound M101 (polymer compound PC3:compound M101 = 85% by mass:15% by mass) were dissolved in xylene at a concentration of 1.4% by mass. The resultant xylene solution was spin-coated in the hole transporting layer, to form a film with a thickness of 70 nm, and the film was heated on a hot plate at 150°C for 10 minutes under a nitrogen gas atmosphere. By this, a light emitting layer was formed.

<Formation of cathode>

The substrate carrying the light emitting layer formed thereon was placed in a vapor deposition machine, and the internal pressure was lowered to $1.0 \times 10^{-4}$ Pa or less, then, as the cathode, sodium fluoride was vapor-deposited with a thickness of about 4 nm on the light emitting layer, then, aluminum was vapor-deposited with a thickness of about 80 nm on the sodium fluoride layer. After vapor deposition, the substrate carrying the cathode formed thereon was sealed with a glass substrate, to fabricate a light emitting device D1.

<Example D2 to Example D6, and Comparative Example CD1>

Fabrication of light emitting device D2 to light emitting device D6, and light emitting device CD1

Devices were fabricated in the same procedure as for the light emitting device D1, except that "polymer compound PC3, and compound M101 (polymer compound PC3:compound M101 = 85% by mass:15% by mass)" for the light emitting device D1 were changed to materials described in Table 3.

<Example D7> Fabrication of light emitting device D7

An ITO anode, a hole injection layer, a hole transporting layer and a cathode were fabricated in the same procedure as for the light emitting device D1.

<Light emitting layer>

The polymer compound PC4 and the compound M102 (polymer compound PC4:compound M102 = 85% by mass:15% by mass) were dissolve in chlorobenzene at a concentration of 1.2% by mass. The resultant xylene solution was spin-coated on a hole transporting layer, to form a film with a thickness of 70 nm, and the film was heated on a hot plate at 150°C for 10 minutes under a nitrogen gas atmosphere. By this, a light emitting layer was formed.

<Formation of cathode>

It was fabricated in the same procedure as for the light emitting device D1.

<Example D8 to Example D10, and Comparative Example CD2>

Fabrication of light emitting device D8 to Example D10, and light emitting device CD2

Devices were fabricated in the same procedure as for the light emitting device D7, except that "polymer compound PC4, and compound M102 (polymer compound PC4:compound M102 = 85% by mass:15% by mass)" for the light emitting device D7 were changed to materials described in Table 4.

<Example D11> Fabrication of light emitting device D11

<ITO substrate and hole injection layer>

On a glass substrate, an ITO film was formed with a thickness of 45 nm by a sputtering method, to form an anode. A hole injection material ND-3202 (manufactured by Nissan Chemical Corporation) was spin-coated on the anode, to form a film with a thickness of 35 nm, and the film was heated on a hot plate at 240°C for 15 minutes, under an air atmosphere. By this, a hole injection layer was formed.

<Hole transporting layer>

The polymer compound PC2 was dissolved in xylene at a concentration of 0.6% by mass. The resultant xylene solution was spin-coated on the hole injection layer, to form a film with a thickness of 20 nm, and the film was heated on a hot plate at 200°C for 30 minutes under a nitrogen gas atmosphere. By this, a hole transporting layer was formed.

<Light emitting layer>

The polymer compound PC8, and the compound M103 (polymer compound PC8:compound M103 = 98% by mass:2% by mass) were dissolved in xylene at a concentration of 1.2% by mass. The resultant xylene solution was spin-coated on the hole transporting layer, to form a film with a thickness of 60 nm, and the film was heated on a hot plate at 150°C for 10 minutes under a nitrogen gas atmosphere. By this, a light emitting layer was formed.

<Formation of cathode>

It was fabricated in the same procedure as for the light emitting device D1.

<Example D12 to Example D19, and Comparative Example CD3>

Fabrication of light emitting device D12 to light emitting device D19, and light emitting device CD3

Devices were fabricated in the same procedure as for the light emitting device D11, except that "polymer compound PC8, and compound M103 (polymer compound PC8:compound M103 = 98% by mass:2% by mass)" for the light emitting device D11 were changed to materials described in Table 5.

<Example D20> Fabrication of light emitting device D20

An ITO anode, a hole injection layer, a hole transporting layer and a cathode were fabricated in the same procedure as for the light emitting device D20.

<Light emitting layer>

The polymer compound PC3, and the compound M105 (polymer compound PC3:compound M105 = 98% by mass:2% by mass) were dissolved in xylene at a concentration of 1.2% by mass. The resultant xylene solution was spin-coated on the hole transporting layer, to form a film with a thickness of 60 nm, and the film was heated on a hot plate at 150°C for 10 minutes under a nitrogen gas atmosphere. By this, a light emitting layer was formed.

<Comparative Example CD4> Fabrication of light emitting device CD4

An ITO anode, a hole injection layer, a hole transporting layer and a cathode were fabricated in the same procedure as for the light emitting device D11.

<Light emitting layer>

The polymer compound PC3 was dissolved in xylene at a concentration of 1.2% by mass. The resultant xylene solution was spin-coated on the hole transporting layer, to form a film with a thickness of 60 nm, and the film was heated on a hot plate at 150°C for 10 minutes under a nitrogen gas atmosphere. By this, a light emitting layer was formed.

<Example D21> Fabrication of light emitting device D21

An ITO anode, a hole injection layer, a hole transporting layer and a cathode were fabricated in the same procedure as for the light emitting device D1.

<Light emitting layer>

The polymer compound PC3, and the polymer compound PC4 (polymer compound PC3:polymer compound PC4 = 50% by mass:50% by mass) were dissolved in xylene at a concentration of 1.2% by mass. The resultant xylene solution was spin-coated on the hole transporting layer, to form a film with a thickness of 70 nm, and the film was heated on a hot plate at 150°C for 10 minutes under a nitrogen gas atmosphere. By this, a light emitting layer was formed.

<Example D22> Fabrication of light emitting device D22

An ITO anode, a hole injection layer, a hole transporting layer and a cathode were fabricated in the same procedure as for the light emitting device D1.

<Light emitting layer>

The polymer compound PC3, and the polymer compound PC5 (polymer compound PC3:polymer compound PC5 = 50% by mass:50% by mass) were dissolved in xylene at a concentration of 1.2% by mass. The resultant xylene solution was spin-coated on the hole transporting layer, to form a film with a thickness of 70 nm, and the film was heated on a hot plate at 150°C for 10 minutes under a nitrogen gas atmosphere. By this, a light emitting layer was formed.

<Comparative Example CD5> Fabrication of light emitting device CD5

An ITO anode, a hole injection layer, a hole transporting layer and a cathode were fabricated in the same procedure as for the light emitting device D1.

<Light emitting layer>

The polymer compound PC3 was dissolved in xylene at a concentration of 1.2% by mass. The resultant xylene solution was spin-coated on the hole transporting layer, to form a film with a thickness of 70 nm, and the film was heated on a hot plate at 150°C for 10 minutes under a nitrogen gas atmosphere. By this, a light emitting layer was formed.

<Light emitting property of light emitting device D1 to light emitting device D6, and light emitting device CD1>

Voltage was applied to the light emitting device D1 to the light emitting device D6, and the light emitting device CD1, to observe EL emission. The light emission efficiency [unit: Lm/W, the same shall apply hereinafter] at 5 mA/$cm^2$ was measured.

The results of Examples D1 to D6 and Comparative Example CD1 are shown in Table 3. The relative values of the light emission efficiency of the light emitting devices D1 to D6, when the light emission efficiency of the light emitting device CD1 is taken as 1.0, are shown. ΔEst1 represents $\Delta E_{ST}$ of the low molecular compound (SM1), and ΔEst2 represents $\Delta E_{ST}$ of the low molecular compound (SM2).

Further, in the composition of the light emitting layer of Example D1, the sum and blending ratio of dSM1 and dSM2 are calculated as described below using the content number per unit mass of the constitutional unit (SM1) in the polymer compound PC3 and the molecular weight: 971.22 of the compound M101.

$$dSM1 + dSM2 = 0.85 \times 6.56 \times 10^{19} + 0.15 \times N_A/(971.22) = 1.48 \times 10^{20}\ [number/g]$$

$$dSM1/dSM2 = (0.85 \times 6.56 \times 10^{19})/(0.15 \times N_A/(971.22)) = 0.60[-]$$

Also in the compositions of the light emitting layer in Examples D2 to D6, the sum and blending ratio of dSM1 and dSM2 can be calculated in the same procedure. The results are shown in Table 3.

[Table 3]

| | Light emitting device | Light emitting layer | | | | | | | | Relative value [-] of light emission efficiency |
|---|---|---|---|---|---|---|---|---|---|---|
| | | Polymer compound | SM1 | SM2 | ratio | ΔEst1 [eV] | ΔEst2 [eV] | dSM1 + dSM2 [number/g] | dSM1/dSM2 [-] | |
| Example D1 | D1 | PC3 | H body of M8 | M101 | 85: 15 | 0. 44 | 0.13 | $1.5\times10^{20}$ | 0.60 | 1.6 |
| Example D2 | D2 | PC4 | H body of M15 | M101 | 78: 22 | 0. 06 | 0.13 | $2.5\times10^{20}$ | 0. 82 | 1.5 |
| Example D3 | D3 | PC4 | H body of M15 | M101 | 88: 12 | 0. 06 | 0.13 | $2.0\times10^{20}$ | 1.7 | 2.4 |
| Example D4 | D4 | PC4 | H body of M15 | M101 | 94:6 | 0. 06 | 0.13 | $1.7\times10^{20}$ | 3.6 | 2.3 |
| Example D5 | D5 | PC4 | H body of M15 | M101 | 97:3 | 0. 06 | 0.13 | $1.6\times10^{20}$ | 7.4 | 2.1 |
| Example D6 | D5 | PC5 | H body of M15 | M101 | 85: 15 | 0. 06 | 0.13 | $2.1\times10^{20}$ | 1.3 | 1.5 |
| Comparative Example CD1 | CD1 | PC6 | none | M101 | 85: 15 | - | 0.13 | - | - | 1.0 |

<Light emitting property of light emitting device D7 to light emitting device D10, and light emitting device CD2>

Voltage was applied to the light emitting device D7 to the light emitting device D10, and the light emitting device CD2, to observe EL emission. The light emission efficiency at 5 mA/$cm^2$ was measured.

The results of the light emitting device D7 to the light emitting device D10, and the light emitting device CD2 are shown in Table 4. The relative values of the light emission efficiency of the light emitting device D7 to the light emitting device D10, when the light emission efficiency of the light emitting device CD2 is taken as 1.0, are shown.

[Table 4]

| | Light emitting device | Light emitting layer | | | | | | | | Relative value [-] of light emission efficiency |
|---|---|---|---|---|---|---|---|---|---|---|
| | | Polymer compound | SM1 | SM2 | ratio | ΔEst1 [eV] | ΔEst2 [eV] | dSM1 + dSM2 [number/g] | dSM1/dSM2 [-] | |
| Example D7 | D7 | PC4 | H body of M15 | M102 | 85:15 | 0. 06 | 0.12 | $2.3 \times 10^{20}$ | 1.1 | 1.3 |
| Example D8 | D8 | PC4 | H body of M15 | M102 | 94:6 | 0. 06 | 0.12 | $1.8 \times 10^{20}$ | 2.9 | 2.0 |
| Example D9 | D9 | PC4 | H body of M15 | M102 | 97:3 | 0. 06 | 0.12 | $1.6 \times 10^{20}$ | 6. 0 | 1.9 |
| Example D10 | D10 | PC5 | H body of M15 | M102 | 85:15 | 0. 06 | 0.12 | $2.3 \times 10^{20}$ | 1.0 | 1.4 |
| Comparative Example CD2 | CD2 | PC7 | none | M102 | 85:15 | - | 0.12 | - | - | 1.0 |

<Light emitting property of light emitting device D11 to light emitting device D19, and light emitting device CD3>

Voltage was applied to the light emitting device D11 to the light emitting device D19, and the light emitting device CD3, to observe EL emission. The light emission efficiency at 5 $mA/cm^2$ was measured.

The results of the light emitting device D11 to the light emitting device D19, and the light emitting device CD3 are shown in Table 5. The relative values of the light emission efficiency of the light emitting device D11 to the light emitting device D19, when the light emission efficiency of the light emitting device CD3 is taken as 1.0, are shown.

[Table 5]

| | Light emitting device | Light emitting layer | | | | | | | | Relative value [-] of light emission efficiency |
|---|---|---|---|---|---|---|---|---|---|---|
| | | Polymer compound | SM1 | SM2 | ratio | ΔEst1 [eV] | ΔEst2 [eV] | dSM1 + dSM2 [number/g] | dSMl/dSM2 [-] | |
| Example D11 | D11 | PC8 | H body of M17 | M103 | 98:2 | 0.16 | 0.46 | $1.9\times10^{20}$ | 13.0 | 1.3 |
| Example D12 | D12 | PC4 | H body of M15 | M103 | 98:2 | 0. 06 | 0.46 | $1.5\times10^{20}$ | 10.4 | 1.7 |
| Example D13 | D13 | PC5 | H body of M15 | M103 | 98:2 | 0. 06 | 0.46 | $1.5\times10^{20}$ | 10.1 | 1.6 |
| Example D14 | D14 | PC5 | H body of M15 | M104 | 98:2 | 0. 06 | 0.46 | $1.5\times10^{20}$ | 12.7 | 1.5 |
| Example D15 | D15 | PC4 | H body of M15 | M105 | 98:2 | 0. 06 | 0.43 | $1.5\times10^{20}$ | 10.7 | 1.5 |
| Example D16 | D16 | PC4 | H body of M15 | M105 | 95:5 | 0. 06 | 0.43 | $1.7\times10^{20}$ | 4.2 | 1.5 |
| Example D17 | D17 | PC4 | H body of M15 | M105 | 89: 11 | 0. 06 | 0.43 | $2.0\times10^{20}$ | 1.8 | 1.6 |
| Example D18 | D18 | PC4 | H body of M15 | M105 | 86: 14 | 0. 06 | 0.43 | $2.1\times10^{20}$ | 1.3 | 1.2 |
| Example D19 | D19 | PC4 | H body of M15 | M105 | 83: 17 | 0. 06 | 0.43 | $2.3\times10^{20}$ | 1.1 | 1.3 |
| Comparative Example CD3 | CD3 | PC6 | none | M103 | 98:2 | - | 0.46 | - | - | 1.0 |

<Light emitting property of light emitting device D20, and light emitting device CD4>

Voltage was applied to the light emitting device D20, and the light emitting device CD4, to observe EL emission. The light emission efficiency at 5 $mA/cm^2$ was measured.

The results of the light emitting device D20 and the light emitting device CD4 are shown in Table 6. The relative value of the light emission efficiency of the light emitting device D20, when the light emission efficiency of the light emitting device CD4 is taken as 1.0, is shown.

[Table 6]

| | Light emitting device | Light emitting layer | | | | | | | | Relative value [-] of light emission efficiency |
|---|---|---|---|---|---|---|---|---|---|---|
| | | Polymer compound | SM1 | SM2 | ratio | ΔEst1 [eV] | ΔEst2 [eV] | dSM1 + dSM2 [number/g] | dSM1/dSM2 [-] | |
| Example D20 | D20 | PC3 | H body of M8 | M105 | 98:2 | 0.44 | 0.43 | $7.7\times10^{19}$ | 4.9 | 1.2 |
| Comparative Example CD4 | CD4 | PC3 | H body of M8 | none | 100 | 0.44 | - | | | 1.0 |

<Light emitting property of light emitting device D21, light emitting device D22, and light emitting device CD5>

Voltage was applied to the light emitting device D21, the light emitting device D22, and the light emitting device CD5, to observe EL emission. The light emission efficiency at 5 $mA/cm^2$ was measured.

The results of the light emitting device D21, the light emitting device D22, and the light emitting device CD5 are shown in Table 7. The relative values of the light emission efficiency of the light emitting device D21 and the light emitting device D22, when the light emission efficiency of the light emitting device CD5 is taken as 1.0, are shown.

Note that the compound corresponding to the low molecular compound (SM1) in the first polymer compound, among the two polymer compounds, was expressed as SM1-1, and the compound corresponding to the low molecular compound (SM1) in the second polymer compound was expressed as SM1-2. $\Delta E_{st}$ of SM1-1 and $\Delta E_{st}$ of SM1-2 are expressed as ΔEst1(a) and ΔEst1(b), respectively.

[Table 7]

| | Light emitting device | Light emitting layer | | | | | | | | Relative value [-] of light emission efficiency |
|---|---|---|---|---|---|---|---|---|---|---|
| | | Polymer compound | SM1-1 | SM1-2 | ratio | ΔEst1 (a) [eV] | ΔEst1 (b) [eV] | dSM1a + dSM1b [number/g] | dSM1a/dSM1b [-] | |
| Example D21 | D21 | PC3, PC4 | H body of M8 | H body of M15 | 50: 50 | 0.44 | 0. 06 | $1.0\times10^{20}$ | 0.46 | 2.0 |
| Example D22 | D22 | PC3, PC5 | H body of M8 | H body of M15 | 50: 50 | 0.44 | 0. 06 | $1.0\times10^{20}$ | 0.47 | 1.6 |
| Comparative Example CD5 | CD5 | PC3 | H body of M8 | - | - | 0.44 | - | - | - | 1.0 |

## Claims

1. A composition comprising

a polymer compound having a repeating unit represented by the formula (Y), and a constitutional unit (SM1) obtained by removing one or more hydrogen atoms from a low molecular compound (SM1) in which the absolute value of a difference between the energy level of the lowest triplet excited state and the energy level of the lowest singlet excited state is 0.50 eV or less, and
a low molecular compound (SM2) in which the absolute value of a difference between the energy level of the lowest triplet excited state and the energy level of the lowest singlet excited state is 0.50 eV or less,
wherein when the content number per unit mass of the constitutional unit (SM1) in the composition is represented as dSM1 and the content number per unit mass of the low molecular compound (SM2) in the composition is represented as dSM2, then, dSM1 + dSM2 is $2.0 \times 10^{19}$ (number/g) or more and dSM1/dSM2 is 0.020 or more and 50 or less:

[Chemical Formula 1]

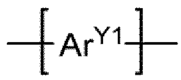

(Y)

wherein, $Ar^{Y1}$ represents an arylene group optionally having a substituent.

2. The composition according to claim 1, wherein the low molecular compound (SM1) is a compound represented by the formula (T-1) or a compound having a group selected from Group D:

[Chemical Formula 2]

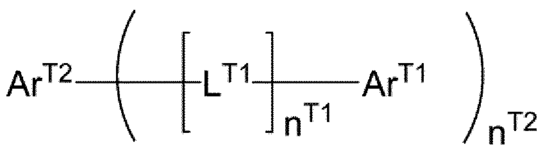

(T-1)

wherein,

$n^{T1}$ represents an integer of 0 or more, when a plurality of $n^{T1}$ are present, they may be the same or different,
$n^{T2}$ represents an integer of 0 or more,
$Ar^{T1}$ represents a substituted amino group or a monovalent hetero ring group, and these groups optionally have a substituent, when a plurality of the substituents are present, they may be the same or different, and may be combined together to form a ring together with atoms to which they are attached, when a plurality of $Ar^{T1}$ are present, they may be the same or different, note that the monovalent hetero ring group represented by $Ar^{T1}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$,
$L^{T1}$ represents an alkylene group, a cycloalkylene group, an arylene group, a divalent hetero ring group, an oxygen atom or a sulfur atom, and these groups optionally have a substituent, when a plurality of the substituents are present, they may be the same or different, and may be combined together to form a ring together with atoms to which they are attached, when a plurality of $L^{T1}$ are present, they may be the same or different,
$Ar^{T2}$ represents a group selected from Group A, Group B and Group C, note that when $Ar^{T2}$ is selected from Group A, $n^{T2}$ is 2;
Group A: -C(=O)-, -S(=O)- and $-S(=O)_2-$
Group B: groups obtained by removing $n^{T2}$ hydrogen atoms from an aromatic hydrocarbon having an electron-withdrawing group
Group C: groups obtained by removing $n^{T2}$ hydrogen atoms from a heterocyclic compound containing in the ring a group represented by =N-, groups obtained by removing $n^{T2}$ hydrogen atoms from a heterocyclic compound containing in the ring a group represented by -C(=O)-, groups obtained by removing $n^{T2}$ hydrogen atoms from

a heterocyclic compound containing in the ring a group represented by -S(=O)-, and groups obtained by removing $n^{T2}$ hydrogen atoms from a heterocyclic compound containing in the ring a group represented by $-S(=O)_2-$
Group D: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

**3.** The composition according to claim 1 or 2, wherein dSM1/dSM2 is 0.077 to 0.77 or 1.3 to 13.

**4.** The composition according to any one of claims 1 to 3, wherein the low molecular compound (SM1) is a compound represented by the formula (D-1):

[Chemical Formula 3]

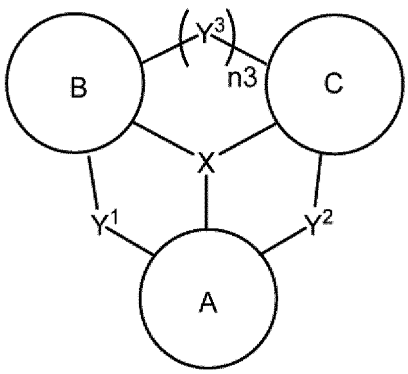

(D-1)

wherein,

Ring A, Ring B and Ring C each independently represent an aromatic hydrocarbon ring or an aromatic hetero ring, and these rings optionally have a substituent,
X represents a boron atom, a phosphorus atom, P=O, P=S, an aluminum atom, a gallium atom, an arsenic atom, Si-Rx or Ge-Rx, Rx represents an aryl group or an alkyl group, and these groups optionally have a substituent,
$Y^1$ represents N-Ry, a sulfur atom or a selenium atom, $Y^2$ and $Y^3$ each independently represent an oxygen atom, N-Ry, a sulfur atom or a selenium atom, Ry represents a hydrogen atom, an aryl group, a monovalent hetero ring group, or an alkyl group, and these groups optionally have a substituent, when a plurality of Ry are present, these may be the same or different, Ry may be linked to the Ring A, the Ring B or the Ring C directly or via linking group,
n3 is 0 or 1, and when n3 is 0, $-Y^3-$ is not present.

**5.** The composition according to any one of claims 1 to 4, wherein the polymer compound further contains a constitutional unit represented by the formula (X) (note that, it differs from the constitutional unit (SM1)):

[Chemical Formula 4]

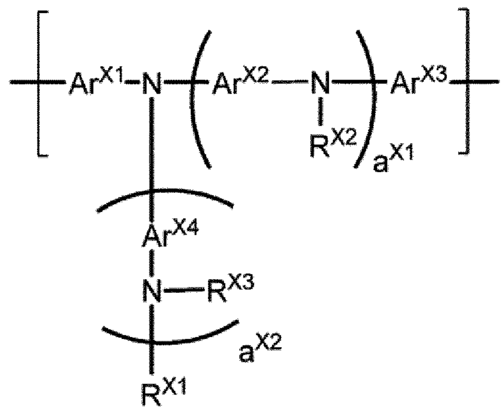

(X)

wherein,

$a^{X1}$ and $a^{X2}$ each independently represent an integer of 0 or more,
$Ar^{X1}$ and $Ar^{X3}$ each independently represent an arylene group or a divalent hetero ring group, and these groups optionally have a substituent, when a plurality of the substituents are present, they may be the same or different, and may be combined together to form a ring together with atoms to which they are attached,
$Ar^{X2}$ and $Ar^{X4}$ each independently represent an arylene group, a divalent hetero ring group, or a divalent group in which at least one arylene group and at least one divalent hetero ring group are bonded directly, and these groups optionally have a substituent, when a plurality of the substituents are present, they may be the same or different, and may be combined together to form a ring together with atoms to which they are attached, when a plurality of $Ar^{X2}$ and $Ar^{X4}$ are present, they may be the same or different at each occurrence,
$R^{X1}$, $R^{X2}$ and $R^{X3}$ each independently represent a hydrogen atom, an alkyl group, a cycloalkyl group, an aryl group or a monovalent hetero ring group, and these groups optionally have a substituent, when a plurality of the substituents are present, they may be the same or different, and may be combined together to form a ring together with atoms to which they are attached, when a plurality of $R^{X2}$ and $R^{X3}$ are present, they may be the same or different at each occurrence.

**6.** The composition according to any one of claims 1 to 5, wherein the low molecular compound (SM2) is a compound represented by the formula (T-11) or a compound having a group selected from Group G:

[Chemical Formula 5]

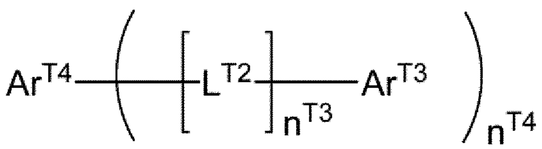

**(T-11)**

wherein,

$n^{T3}$ represents an integer of 0 or more, when a plurality of $n^{T3}$ are present, they may be the same or different,
$n^{T4}$ represents an integer of 1 or more,
$Ar^{T3}$ represents a substituted amino group or a monovalent hetero ring group, and these groups optionally have a substituent, when a plurality of the substituents are present, they may be the same or different, and may be combined together to form a ring together with atoms to which they are attached, when a plurality of $Ar^{T3}$ are present, they may be the same or different, note that the monovalent hetero ring group represented by $Ar^{T3}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$,
$L^{T2}$ represents an alkylene group, a cycloalkylene group, an arylene group, a divalent hetero ring group, an

oxygen atom or a sulfur atom, and these groups optionally have a substituent, when a plurality of the substituents are present, they may be the same or different, and may be combined together to form a ring together with atoms to which they are attached, when a plurality of $L^{T2}$ are present, they may be the same or different,
$Ar^{T4}$ represents a group selected from Group A, Group E and Group F, note that when $Ar^{T4}$ is a group selected from Group A, $n^{T4}$ is 2;
Group A: -C(=O)-, -S(=O)- and $-S(=O)_2-$
Group E: groups obtained by removing $n^{T4}$ hydrogen atoms from an aromatic hydrocarbon having an electron-withdrawing group
Group F: groups obtained by removing $n^{T4}$ hydrogen atoms from a heterocyclic compound containing in the ring a group represented by =N-, groups obtained by removing $n^{T4}$ hydrogen atoms from a heterocyclic compound containing in the ring a group represented by -C(=O)-, groups obtained by removing $n^{T4}$ hydrogen atoms from a heterocyclic compound containing in the ring a group represented by -S(=O)-, and groups obtained by removing $n^{T4}$ hydrogen atoms from a heterocyclic compound containing in the ring a group represented by $-S(=O)_2-$
Group G: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

**7.** The composition according to any one of claims 1 to 6, wherein the low molecular compound (SM2) is a compound represented by the formula (D-11):

[Chemical Formula 6]

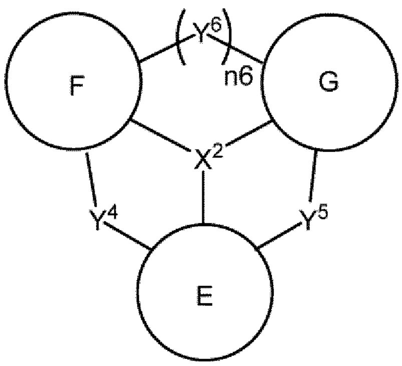

(D-11)

wherein,

Ring E, Ring F and Ring G each independently represent an aromatic hydrocarbon ring or an aromatic hetero ring, and these rings optionally have a substituent,
$X^2$ represents a boron atom, a phosphorus atom, P=O, P=S, an aluminum atom, a gallium atom, an arsenic atom, Si-Rx or Ge-Rx, Rx represents an aryl group or an alkyl group, and these groups optionally have a substituent,
$Y^4$ represents N-Ry, a sulfur atom or a selenium atom, $Y^3$ and $Y^6$ each independently represent an oxygen atom, N-Ry, a sulfur atom or a selenium atom, Ry represents a hydrogen atom, an aryl group, a monovalent hetero ring group, or an alkyl group, and these groups optionally have a substituent, when a plurality of Ry are present, these may be the same or different, Ry may be linked to the Ring E, the Ring F or the Ring G directly or via linking group,
n6 is 0 or 1, and when n6 is 0, $-Y^6-$ is not present.

**8.** A composition comprising

a first polymer compound having a repeating unit represented by the formula (Y), and a constitutional unit (SM1-1) obtained by removing one or more hydrogen atoms from a low molecular compound (SM1-1) in which

the absolute value of a difference between the energy level of the lowest triplet excited state and the energy level of the lowest singlet excited state is 0.50 eV or less, and

a second polymer compound having a repeating unit represented by the formula (Y), and a constitutional unit (SM1-2) obtained by removing one or more hydrogen atoms from a low molecular compound (SM1-2) in which the absolute value of a difference between the energy level of the lowest triplet excited state and the energy level of the lowest singlet excited state is 0.50 eV or less (note that, the low molecular compound (SM1-1) and the low molecular compound (SM1-2) are different),

wherein when the content number per unit mass of the constitutional unit (SM1-1) in the composition is represented as dSM1 and the content number per unit mass of the constitutional unit (SM1-2) in the composition is represented as dSM1b, then, dSM1a + dSM1b is $2.0 \times 10^{19}$ (number/g) or more and dSM1a/dSM1b is 0.020 or more and 50 or less:

[Chemical Formula 7]

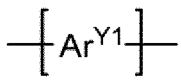

(Y)

wherein, $Ar^{Y1}$ represents an arylene group optionally having a substituent.

**9.** The composition according to claim 8, wherein the low molecular compound (SM1-1) and the low molecular compound (SM1-2) are each independently a compound represented by the formula (T-1) or a compound having a group selected from Group D:

[Chemical Formula 8]

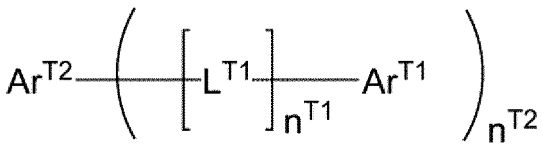

**(T-1)**

wherein,

$n^{T1}$ represents an integer of 0 or more, when a plurality of $n^{T1}$ are present, they may be the same or different,

$n^{T2}$ represents an integer of 0 or more,

$Ar^{T1}$ represents a substituted amino group or a monovalent hetero ring group, and these groups optionally have a substituent, when a plurality of the substituents are present, they may be the same or different, and may be combined together to form a ring together with atoms to which they are attached, when a plurality of $Ar^{T1}$ are present, they may be the same or different, note that the monovalent hetero ring group represented by $Ar^{T1}$ is a monovalent hetero ring group containing in the ring a nitrogen atom not forming a double bond and not containing in the ring a group represented by =N-, a group represented by -C(=O)-, a group represented by -S(=O)- and a group represented by $-S(=O)_2-$,

$L^{T1}$ represents an alkylene group, a cycloalkylene group, an arylene group, a divalent hetero ring group, an oxygen atom or a sulfur atom, and these groups optionally have a substituent, when a plurality of the substituents are present, they may be the same or different, and may be combined together to form a ring together with atoms to which they are attached, when a plurality of $L^{T1}$ are present, they may be the same or different,

$Ar^{T2}$ represents a group selected from Group A, Group B and Group C, note that when $Ar^{T2}$ is selected from Group A, $n^{T2}$ is 2;

Group A: -C(=O)-, -S(=O)- and $-S(=O)_2-$

Group B: groups obtained by removing $n^{T2}$ hydrogen atoms from an aromatic hydrocarbon having an electron-withdrawing group

Group C: groups obtained by removing $n^{T2}$ hydrogen atoms from a heterocyclic compound containing in the ring a group represented by =N-, groups obtained by removing $n^{T2}$ hydrogen atoms from a heterocyclic compound containing in the ring a group represented by -C(=O)-, groups obtained by removing $n^{T2}$ hydrogen atoms from a heterocyclic compound containing in the ring a group represented by -S(=O)-, and groups obtained by removing

$n^{T2}$ hydrogen atoms from a heterocyclic compound containing in the ring a group represented by $-S(=O)_2-$
Group D: groups obtained by removing one or more hydrogen atoms from a heterocyclic compound containing a boron atom, groups obtained by removing one or more hydrogen atoms from a heterocyclic compound containing a phosphorus atom, groups obtained by removing one or more hydrogen atoms from a heterocyclic compound containing an aluminum atom, groups obtained by removing one or more hydrogen atoms from a heterocyclic compound containing a gallium atom, groups obtained by removing one or more hydrogen atoms from a heterocyclic compound containing a silicon atom, groups obtained by removing one or more hydrogen atoms from a heterocyclic compound containing an arsenic atom, and groups obtained by removing one or more hydrogen atoms from a heterocyclic compound containing a germanium atom.

**10.** The composition according to claim 8 or 9, wherein the low molecular compound (SM1-1) and the low molecular compound (SM1-2) are each independently a compound represented by the formula (D-1):

[Chemical Formula 9]

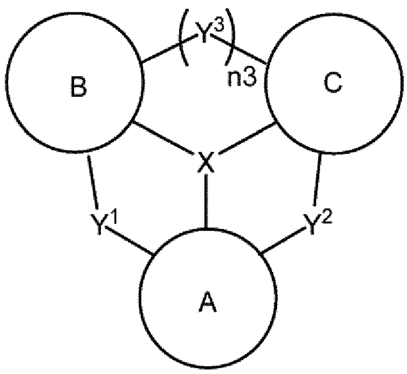

(D-1)

wherein,

Ring A, Ring B and Ring C each independently represent an aromatic hydrocarbon ring or an aromatic hetero ring, and these rings optionally have a substituent,
X represents a boron atom, a phosphorus atom, P=O, P=S, an aluminum atom, a gallium atom, an arsenic atom, Si-Rx or Ge-Rx, Rx represents an aryl group or an alkyl group, and these groups optionally have a substituent,
$Y^1$ represents N-Ry, a sulfur atom or a selenium atom, $Y^2$ and $Y^3$ each independently represent an oxygen atom, N-Ry, a sulfur atom or a selenium atom, Ry represents a hydrogen atom, an aryl group, a monovalent hetero ring group, or an alkyl group, and these groups optionally have a substituent, when a plurality of Ry are present, these may be the same or different, Ry may be linked to the Ring A, the Ring B or the Ring C directly or via linking group,
n3 is 0 or 1, and when n3 is 0, $-Y^3-$ is not present.

**11.** An ink comprising the composition as described in any one of claims 1 to 10, and a solvent.

**12.** A light emitting device comprising the composition as described in any one of claims 1 to 10.

## INTERNATIONAL SEARCH REPORT

International application No.
PCT/JP2021/025092

A. CLASSIFICATION OF SUBJECT MATTER
C09K 11/06(2006.01)i; H01L 51/50(2006.01)i
FI: H05B33/14 B; C09K11/06 660; C09K11/06 690
According to International Patent Classification (IPC) or to both national classification and IPC

B. FIELDS SEARCHED
Minimum documentation searched (classification system followed by classification symbols)
C09K11/06; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| Y | WO 2019/004247 A1 (SUMITOMO CHEMICAL CO., LTD.) 03 January 2019 (2019-01-03) paragraphs [0007], [0281], [0312], [0449], [0469], [0484], [0500], [0507]-[0531], [0546], [0548]-[0550] | 1-12 |
| Y | WO 2020/040298 A1 (KWANSEI GAKUIN EDUCATIONAL FOUNDATION, JNC CORPORATION) 27 February 2020 (2020-02-27) paragraphs [0048]-[0058], [0070]-[0072], [0079]-[0083], [0102]-[0147], [0336], [0380]-[0381], [0466]-[0467] | 1-12 |
| Y | JP 2018-061028 A (SUMITOMO CHEMICAL CO., LTD.) 12 April 2018 (2018-04-12) paragraphs [0010]-[0012], [0015], [0056]-[0057], [0295]-[0298], [0432]-[0448] | 1-12 |
| Y | JP 2018-061030 A (SUMITOMO CHEMICAL CO., LTD.) 12 April 2018 (2018-04-12) paragraphs [0009]-[0011], [0014], [0055]-[0056], [0294]-[0297], [0431]-[0447] | 1-12 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 September 2021 (09.09.2021) | 21 September 2021 (21.09.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2021/025092

C (Continuation). DOCUMENTS CONSIDERED TO BE RELEVANT

| Category* | Citation of document, with indication, where appropriate, of the relevant passages | Relevant to claim No. |
|---|---|---|
| A | JP 2018-061029 A (SUMITOMO CHEMICAL CO., LTD.) 12 April 2018 (2018-04-12) entire text | 1-12 |
| A | WO 2019/004248 A1 (SUMITOMO CHEMICAL CO., LTD.) 03 January 2019 (2019-01-03) entire text | 1-12 |
| A | JP 2019-050369 A (SUMITOMO CHEMICAL CO., LTD.) 28 March 2019 (2019-03-28) entire text | 1-12 |
| A | WO 2019/240080 A1 (KWANSEI GAKUIN EDUCATIONAL FOUNDATION, JNC CORPORATION) 19 December 2019 (2019-12-19) entire text, all drawings | 1-12 |

Form PCT/ISA/210 (continuation of second sheet) (January 2015)

**INTERNATIONAL SEARCH REPORT**
Information on patent family members

International application no.
PCT/JP2021/025092

| Patent Documents referred in the Report | Publication Date | Patent Family | Publication Date |
|---|---|---|---|
| WO 2019/004247 A1 | 03 Jan. 2019 | (Family: none) | |
| WO 2020/040298 A1 | 27 Feb. 2020 | (Family: none) | |
| JP 2018-061028 A | 12 Apr. 2018 | (Family: none) | |
| JP 2018-061030 A | 12 Apr. 2018 | (Family: none) | |
| JP 2018-061029 A | 12 Apr. 2018 | (Family: none) | |
| WO 2019/004248 A1 | 03 Jan. 2019 | EP 3647338 A1<br>entire text<br>CN 110799571 A<br>KR 10-2020-0023397 A | |
| JP 2019-050369 A | 28 Mar. 2019 | (Family: none) | |
| WO 2019/240080 A1 | 19 Dec. 2019 | TW 202000676 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2018062276 A
- WO 2018062278 A
- WO 2007063754 A
- WO 2008056746 A
- WO 2011032686 A
- WO 2012096263 A
- JP 2009227663 A
- JP 2010275255 A
- WO 2002045184 A
- JP 2002539292 W
- WO 2011049241 A
- WO 2015014871 A
- WO 2013146806 A
- JP 2007512249 T
- WO 2019004247 A
- WO 2012086671 A
- JP 2010189630 A
- WO 2013191086 A
- WO 2013191088 A
- JP 2010196040 A
- WO 2010136109 A
- WO 2015102118 A
- WO 2015145871 A
- WO 2019004248 A
- WO 201904247 A
- WO 2015008851 A
- JP 2012036388 A


### Non-patent literature cited in the description


- *Advanced Materials,* 2014, vol. 26, 7931-7958
- *Angew. Chem. Int. Ed.,* 2018, vol. 57, 11316-11320